(19) Europäisches Patentamt
European Patent Office
Office européen des brevets

(11) EP 4 456 133 A1

(12) # EUROPEAN PATENT APPLICATION
published in accordance with Art. 153(4) EPC

(43) Date of publication:
**30.10.2024 Bulletin 2024/44**

(21) Application number: **22910755.2**

(22) Date of filing: **25.11.2022**

(51) International Patent Classification (IPC):
***H01L 25/07*** *(2006.01)* ***C08G 73/10*** *(2006.01)*
***C08L 79/08*** *(2006.01)* ***H01L 25/065*** *(2023.01)*
***H01L 25/18*** *(2023.01)*

(52) Cooperative Patent Classification (CPC):
**C08G 73/10; C08L 79/08; H01L 25/065; H01L 25/07; H01L 25/18**

(86) International application number:
**PCT/JP2022/043600**

(87) International publication number:
**WO 2023/120037 (29.06.2023 Gazette 2023/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **23.12.2021 JP 2021209029**
**30.09.2022 JP 2022158712**
**11.11.2022 JP 2022181282**

(71) Applicant: **FUJIFILM Corporation**
**Tokyo 106-8620 (JP)**

(72) Inventors:
- **NAKAMURA, Atsushi**
  **Haibara-gun, Shizuoka 421-0396 (JP)**
- **YAMASHITA, Kosuke**
  **Haibara-gun, Shizuoka 421-0396 (JP)**
- **TOMOTA, Kazuki**
  **Haibara-gun, Shizuoka 421-0396 (JP)**

(74) Representative: **HGF**
**HGF Limited**
**1 City Walk**
**Leeds LS11 9DX (GB)**

(54) **JOINED BODY PRODUCTION METHOD, JOINED BODY, LAMINATE PRODUCTION METHOD, LAMINATE, DEVICE PRODUCTION METHOD, DEVICE, AND COMPOSITION FOR FORMING POLYIMIDE-CONTAINING PRECURSOR PART**

(57) There is provided a manufacturing method for a bonded body, in which a bonded body having a large maximum peeling resistance force between two substrates is obtained in a case where the two substrates are bonded, and a bonded body to be obtained, a manufacturing method for a laminate and a laminate to be obtained, a manufacturing method for a device and a device to be obtained, and a composition for forming a polyimide-containing precursor portion.

The manufacturing method for a bonded body includes a step of preparing a substrate A; a polyimide-containing precursor portion forming step of forming a polyimide-containing precursor portion on the surface of the substrate A, where the wiring line terminal is provided on the surface of the substrate A; a step of preparing a substrate B; and a bonding step of bonding the surface of the substrate A, where the polyimide-containing precursor portion is provided on the surface of the substrate A, to the surface of the substrate B, where the wiring line terminal is provided on the surface of the substrate B. In the manufacturing method, a difference between a cyclization rate of a polyimide in the polyimide-containing precursor portion before the bonding step and a cyclization rate of a polyimide in a polyimide-containing portion is 5% or more.

FIG. 3A

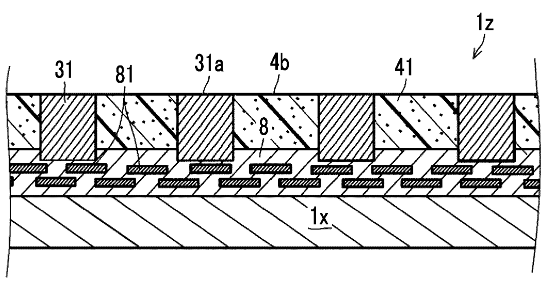

FIG. 3B

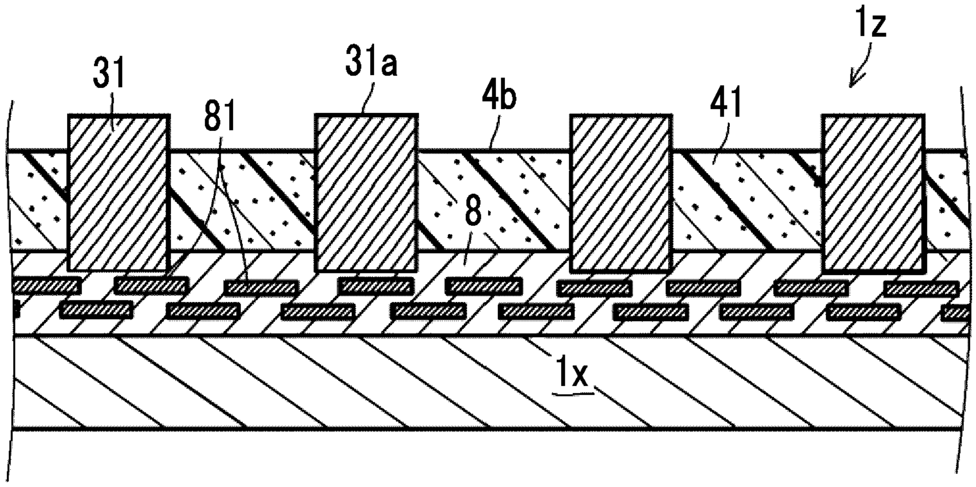


FIG. 3C

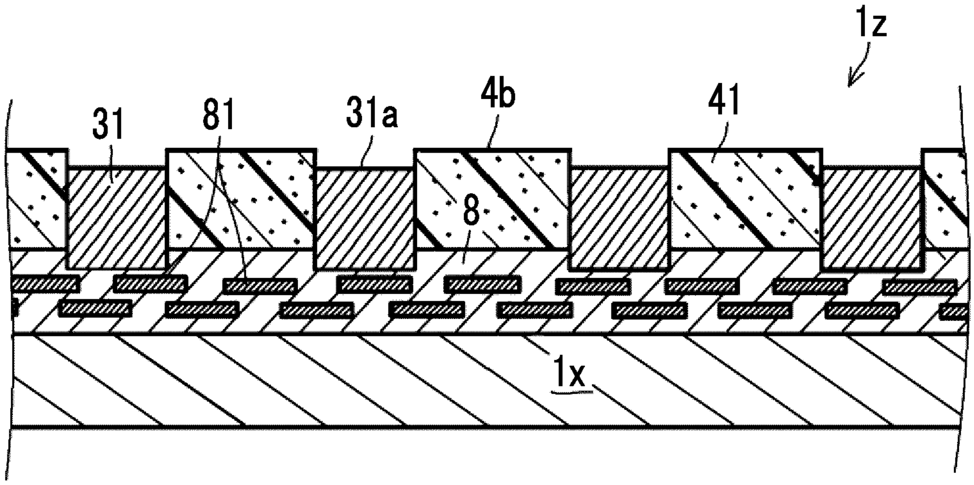

## Description

BACKGROUND OF THE INVENTION

1. Field of the Invention

The present invention relates to a manufacturing method for a bonded body, a bonded body, a manufacturing method for a laminate, a laminate, a manufacturing method for a device, and a device, and a composition for forming a polyimide-containing precursor portion.

2. Description of the Related Art

Electronic apparatuses such as a mobile phone or a tablet-type terminal are increasingly miniaturized, while the functions thereof are diversified. In order to respond to the needs, further miniaturization, high integration, and high-density mounting are required for electronic circuits incorporated in the electronic apparatuses. As a technique that achieves miniaturization while maintaining multi-functional high performance and reliability, a mounting technique such as system in package (SIP), multi chip module (MCM), and package on package (POP) have attracted attention. According to these techniques, the number of components can be reduced and the semiconductor manufacturing process can be simplified. Therefore, the techniques are also expected from the viewpoint of reducing the cost of the electronic apparatus.

By further applying the technique of the flip chip mounting, a technique related to threedimensionally mounted using the through silicon via (TSV) and a material for TSV have been studied (Using Permanent and Temporary Polyimide Adhesives in 3D-TSV Processing to Avoid Thin Wafer Handling (Journal of Microelectronics and Electronic Packaging (2010) 7, pp.214-219).

SUMMARY OF THE INVENTION

In SIP, chips are connected to each other by wire bonding, and thus it is difficult to obtain a processing speed equivalent to the processing speed of the system on chip (SOC) in the related art. In addition, the connection by wire bonding complicates a manufacturing process, and thus the improvement has been desired in product cost and product quality as well. In order to respond to such problems, a mounting technique for chip on chip (COC) has been developed. In the COC, a transmission distance can be shortened by connecting chips using the flip chip connection, and thus it is possible to obtain the same high-speed performance as the high-speed performance of the SOC. Fig. 1 is a cross-sectional view showing a structure of a general COC. The COC of this example is equipped with a daughter chip (first substrate) 1 and a mother chip (second substrate) 2. An electronic circuit (not shown in the drawing) and a flip chip electrode (not shown in the drawing) are formed in the mother chip 2, and the daughter chip 1 is connected to the mother chip 2 with a solder electrode (bump) 93 being interposed, while the daughter chip 1 is supported by the mother chip 2. The periphery of the solder electrode 93 is filled with an underfill 94 to ensure the insulating properties. The mother chip 2 is mounted, while maintaining insulating properties, by being adhered to a base substrate 98 with a bonding film 91. The electrical connection between the mother chip 2 and the base substrate 98 is carried out through a wire bonding pad 97b, a wire bonding 96, and a substrate electrode 97a. Such a COC structure is sealed with a sealing resin 95 to constitute a semiconductor device 90. This semiconductor device 90 is equipped with a solder ball 99 and is incorporated into an electronic apparatus by interposing the solder ball 99.

In an element having a COC structure such a structure as shown in Fig. 1, the daughter chip 1 and the mother chip 2 are connected and fixed to each other by a solder bump 93, and then the gap therebetween is filled with the underfill 94. Therefore, a resin having fluidity is adopted as a material that constitutes the underfill, and the underfill is formed by filling the gap between the solder bumps with a resin and then curing the resin.

Here, the daughter chip 1 and the mother chip 2 are adhered to each other by the adhesive force of the resin; however, it is required to improve the maximum peeling resistance force between these two substrates from the viewpoint of improving the adhesiveness.

Therefore, an object of the present disclosure is to provide a manufacturing method for a bonded body, in which a bonded body having a large maximum peeling resistance force between two substrates is obtained in a case where the two substrates are bonded, and a bonded body to be obtained, a manufacturing method for a laminate and a laminate to be obtained, a manufacturing method for a device and a device to be obtained, and a composition for forming a polyimide-containing precursor portion.

Examples of specific aspects of the present invention are described below.

<1> A manufacturing method for a bonded body, comprising:

a step of preparing a substrate A having a surface on which a wiring line terminal is provided;
a polyimide-containing precursor portion forming step of forming a polyimide-containing precursor portion on the surface of the substrate A, where the wiring line terminal is provided on the surface of the substrate A;
a step of preparing a substrate B having a surface on which a wiring line terminal is provided; and
a bonding step of bonding the surface of the substrate A, where the polyimide-containing precursor portion is provided on the surface of the substrate A, to the surface of the substrate B, where the wiring line terminal is provided on the surface of the substrate B,
in which a difference between a cyclization rate of a polyimide in the polyimide-containing precursor portion before the bonding step and a cyclization rate of a polyimide in a polyimide-containing portion formed at a bonded portion after the bonding step is 5% or more.

<2> The manufacturing method for a bonded body according to claim 1,
in which the cyclization rate of the polyimide in the polyimide-containing precursor portion before the bonding step is 40% to 90%.
<3> The manufacturing method for a bonded body according to <1> or <2>,
in which the cyclization rate of the polyimide in the polyimide-containing portion formed at the bonded portion after the bonding step is 91% to 100%.
<4> The manufacturing method for a bonded body according to any one of <1> to <3> in which a bonding temperature in the bonding step is 380°C or lower.
<5> The manufacturing method for a bonded body according to any one of <1> to <4>,
in which a bonding temperature in the bonding step is equal to or higher than a melting point of the wiring line terminal of the substrate A and equal to or higher than a melting point of the wiring line terminal of the substrate B.
<6> The manufacturing method for a bonded body according to any one of <1> to <5> in which the polyimide-containing precursor portion forming step includes applying a composition for forming a polyimide-containing precursor portion onto the surface of the substrate A, where the wiring line terminal is provided on the surface of the substrate A, and heating the applied composition for forming a polyimide-containing precursor portion at a temperature lower than a melting point of the wiring line terminal of the substrate A, where a heating temperature in the heating is lower than a melting point of the wiring terminal.
<7> The manufacturing method for a bonded body according to any one of <1> to <6> in which a form of the substrate A is a wafer.
<8> The manufacturing method for a bonded body according to any one of <1> to <7> in which a form of the substrate B is a chip.
<9> The manufacturing method for a bonded body according to any one of <1> to <7> in which a form of the substrate B is a wafer.
<10>The manufacturing method for a bonded body according to any one of <1> to <9>, further comprising:

a flattening step of flattening a surface of the polyimide-containing precursor portion on the substrate A,
in which the polyimide-containing precursor portion forming step, the flattening step, and the bonding step are included in this order.

<11> The manufacturing method for a bonded body according to any one of <1> or <10>,
in which in the bonding step, an electrode included on the surface of the substrate A, where the polyimide-containing precursor portion is provided on the surface of the substrate A, and an electrode on the surface of the substrate B, where the wiring line terminal is provided on the surface of the substrate B, are bonded to be in direct contact with each other.
<12> The manufacturing method for a bonded body according to any one of <1> to <11>, further comprising:

a second polyimide-containing precursor portion forming step of forming a second polyimide-containing precursor portion on the surface of the substrate B, where the wiring line terminal is provided on the surface of the substrate B,
in which the second polyimide-containing precursor portion forming step and the bonding step are included in this order.

<13> The manufacturing method for a bonded body according to <12>,
in which a difference between a cyclization rate of a polyimide in the second polyimide-containing precursor portion before the bonding step and the cyclization rate of the polyimide contained in the polyimide-containing portion formed at the bonded portion after the bonding step is 5% or more.
<14> The manufacturing method for a bonded body according to <12> or <13>,

in which the cyclization rate of the polyimide in the second polyimide-containing precursor portion before the bonding step is 40% to 90%.
<15> The manufacturing method for a bonded body according to any one of <1> to <11>, in which the substrate B includes an inorganic insulating film between the wiring line terminals of the substrate B.
<16> The manufacturing method for a bonded body according to any one of <1> to <15>,

in which the polyimide-containing precursor portion forming step is a step of applying a composition for forming a polyimide-containing precursor portion onto the surface of the substrate A, where the wiring line terminal is provided on the surface of the substrate A, and
the composition for forming a polyimide-containing precursor portion contains a polyimide precursor and a solvent.

<17> The manufacturing method for a bonded body according to <16>,
in which the composition for forming a polyimide-containing precursor portion contains a migration suppressing agent.
<18> The manufacturing method for a bonded body according to <16> or <17>,
in which the composition for forming a polyimide-containing precursor portion contains a polymerizable compound having a ring structure.
<19> The manufacturing method for a bonded body according to any one of <16> to <18>,
in which the composition for forming a polyimide-containing precursor portion contains a polymerizable compound in which a glass transition temperature of a homopolymer is 200°C or higher.
<19>, <20> The manufacturing method for a bonded body according to any one of <16> to
in which the composition for forming a polyimide-containing precursor portion contains a filler.
<21> A bonded body that is obtained by the manufacturing method according to any one of <1> to <20>.
<22> A manufacturing method for a laminate, comprising:

a step of preparing a substrate C having two or more surfaces on which a wiring line terminal is provided;
a step of preparing a plurality of substrates D each having a surface on which a wiring line terminal is provided;
a polyimide-containing precursor portion forming step of forming a polyimide-containing precursor portion on the surface of at least one of the substrate C or the substrate D, where the wiring line terminal is provided on the at least one of the substrate C or the substrate D; and
a bonding step of bonding the surface of the substrate D, where the wiring line terminal is provided, to each of at least two surfaces of the substrate C, where the wiring line terminal is provided,
in which all of a plurality of bonded portions in the bonding step include the polyimide-containing precursor portion, and
in at least one bonded portion, a difference between a cyclization rate of a polyimide in the polyimide-containing precursor portion before the bonding step and a cyclization rate of a polyimide in a polyimide-containing portion formed at the bonded portion after the bonding step is 5% or more.

<23> The manufacturing method for a laminate according to <22>,
in which the polyimide-containing precursor portion contains a filler.
<24> A laminate that is obtained by the manufacturing method for a laminate according to <22> or <23>.
<25> A manufacturing method for device, comprising:

the manufacturing method for a bonded body according to any one of <1> to <20>; or
the manufacturing method for a laminate according to <22> or <23>.

<26> A device comprising:

the bonded body according to <21>; or
the laminate according to <24>.

<27> A composition for forming a polyimide-containing precursor portion, which is used in a manufacturing method for a bonded body, the manufacturing method including:

a step of preparing a substrate A having a surface on which a wiring line terminal is provided;
a polyimide-containing precursor portion forming step of forming a polyimide-containing precursor portion on the surface of the substrate A; where a wiring line terminal is provided on the surface of the substrate A;
a step of preparing a substrate B having a surface on which a wiring line terminal is provided; and

a bonding step of bonding the surface of the substrate A, where the polyimide-containing precursor portion is provided on the surface of the substrate A, to the surface of the substrate B, which has the wiring line terminal, in which the polyimide-containing precursor portion is a member formed from the composition for forming a polyimide-containing precursor portion, and

a difference between a cyclization rate of a polyimide in the polyimide-containing precursor portion before the bonding step and a cyclization rate of a polyimide in a polyimide-containing portion formed at a bonded portion after the bonding step is 5% or more.

<28> The composition for forming a polyimide-containing precursor portion according to <27>,
in which the cyclization rate of the polyimide in the polyimide-containing precursor portion before the bonding step is 40% to 90%.
<29> The composition for forming a polyimide-containing precursor portion according to <27> or <28>,
in which the cyclization rate of the polyimide in the polyimide-containing portion formed at the bonded portion after the bonding step is 91% to 100%.
<30> The composition for forming a polyimide-containing precursor portion according to any one of <27> to <29>, further comprising a filler.

According to the present invention, there are provided a manufacturing method for a bonded body, in which a bonded body having a large maximum peeling resistance force between two substrates is obtained in a case where the two substrates are bonded, and a bonded body to be obtained, a manufacturing method for a laminate and a laminate to be obtained, a manufacturing method for a device and a device to be obtained, and a composition for forming a polyimide-containing precursor portion.

BRIEF DESCRIPTION OF THE DRAWINGS

Fig. 1 is a cross-sectional view schematically showing a structure of a COC semiconductor device.
Figs. 2A to 2C are step explanatory views schematically showing steps with cross-sectional views in a case where substrates are bonded in a manufacturing method for a bonded body according to one embodiment of the present invention, in which a composition for forming a polyimide-containing precursor portion according to the present invention is used.
Figs. 3A to 3C are step explanatory views schematically showing steps with cross-sectional views in a case where substrates are bonded in a manufacturing method for a bonded body according to one embodiment of the present invention, in which a composition for forming a polyimide-containing precursor portion according to the present invention is used (continued from Figs. 2A to 2C).
Figs. 4A and 4B are step explanatory views schematically showing steps with cross-sectional views in a case where substrates are bonded in a manufacturing method for a bonded body according to one embodiment of the present invention, in which a composition for forming a polyimide-containing precursor portion according to the present invention is used (continued from Figs. 3A to 3C).
Fig. 5 is a cross-sectional view schematically showing one example of a threedimensionally mounted semiconductor device using the TSV
Figs. 6A and 6B are schematic cross-sectional views showing details of a substrate used in Examples.
Figs. 7A to 7C are schematic cross-sectional views showing details of operations carried out in Examples 22 and 23.
Figs. 8A to 8C are schematic cross-sectional views showing details of operations carried out in Examples 22 and 23.

DESCRIPTION OF THE PREFERRED EMBODIMENTS

Hereinafter, the contents of the present invention will be described in detail.
The description of the constitutive elements of the present invention as described below may be made based on the representative embodiments of the present invention, but the present invention is not limited to such embodiments.
In a case where substitution or non-substitution is not explicitly indicated in the description of a group (atomic group) in the present specification, the group (atomic group) is intended to include not only a group (atomic group) having no substituent but also a group (atomic group) having a substituent. For example, the "alkyl group" includes not only an alkyl group having no substituent (an unsubstituted alkyl group) but also an alkyl group having a substituent (a substituted alkyl group).
In the present specification, "exposure" includes not only exposure using light but also lithography using particle beams such as electron beams and ion beams, unless otherwise specified. In addition, generally, examples of the light

to be used for exposure include an actinic ray or radiation, for example, a bright light spectrum of a mercury lamp, a far ultraviolet ray represented by an excimer laser, an extreme ultraviolet ray (EUV light), an X-ray, or an electron beam.

In the present specification, a numerical value range represented by "to" means a range including numerical values before and after "to" as a lower limit value and an upper limit value.

In the present specification, the term "(meth)acrylate" represents both or either of "acrylate" and "methacrylate", the term "(meth)acrylic" represents both or either of "acrylic" and "methacrylic", and the term "(meth)acryloyl" represents both or either of "acryloyl" and "methacryloyl".

In the present specification, the term "step" includes not only an independent step but also a step that cannot be clearly distinguished from other steps, as long as the intended action of the step is achieved.

In the present specification, the solid content refers to a mass percentage of other components excluding a solvent with respect to a total mass of a composition. In addition, the concentration of solid contents refers to a concentration at 25°C unless otherwise specified.

The temperature in the present invention is 25°C unless otherwise specified.

In the present specification, the weight-average molecular weight (Mw) and the number-average molecular weight (Mn) are each defined as a value in terms of polystyrene according to gel permeation chromatography (GPC measurement), unless otherwise specified. In the present specification, the weight-average molecular weight (Mw) and the number-average molecular weight (Mn) can be determined, for example, by using HLC-8220 (manufactured by Tosoh Corporation) and using, as a column, any of GUARD COLUMN HZ-L, TSKgel Super HZM-M, TSK gel Super HZ4000, TSK gel Super HZ3000, or TSK gel Super HZ2000 (manufactured by Tosoh Corporation). The eluent is tetrahydrofuran (THF) unless otherwise specified. In addition, unless otherwise stated, detection is carried out using a detector of ultraviolet rays (UV rays) having a wavelength of 254 nm.

(Manufacturing method for bonded body)

A manufacturing method for a bonded body according to an embodiment of the present invention includes a step of preparing a substrate A having a surface on which a wiring line terminal is provided; a polyimide-containing precursor portion forming step of forming a polyimide-containing precursor portion on the surface of the substrate A, where the wiring line terminal is provided on the surface of the substrate A; a step of preparing a substrate B having a surface on which a wiring line terminal is provided; and a bonding step of bonding the surface of the substrate A, where the polyimide-containing precursor portion is provided on the surface of the substrate A, to the surface of the substrate B, where the wiring line terminal is provided on the surface of the substrate B. In the manufacturing method, a difference between a cyclization rate of a polyimide in the polyimide-containing precursor portion before the bonding step and a cyclization rate of a polyimide in a polyimide-containing portion formed at a bonded portion after the bonding step is 5% or more.

In a case where the manufacturing method for a bonded body according to the embodiment of the present invention is used, it is possible to manufacture a bonded body having a large maximum peeling resistance force between two substrates in a case where two substrates such as a wafer and a wafer or a wafer and a chip are bonded with a polyimide-containing portion being interposed therebetween.

Specifically, since a difference between a cyclization rate of a polyimide in the polyimide-containing precursor portion before the bonding step and a cyclization rate of a polyimide in a polyimide-containing portion formed at the bonded portion after the bonding step is 5% or more, an anchor effect can be obtained in a case where the polyimide-containing precursor portion is changed to the polyimide-containing portion (the cyclization rate increases) during bonding, which makes it possible to increase the maximum peeling resistance force during bonding.

Hereinafter, the manufacturing method for a bonded body according to the embodiment of the present invention will be described in detail.

<Step of preparing substrate A>

The manufacturing method for a bonded body according to the embodiment of the present invention includes a step of preparing a substrate A having a surface on which a wiring line terminal is provided.

In the step of preparing the substrate A, the substrate A may be manufactured by a publicly known method (for example, by plating a substrate such as a silicon substrate) or may be obtained by means such as a purchase.

[Substrate A]

The substrate A has a surface having a wiring line terminal.

Hereinafter, the wiring line terminal on the substrate A is also described as a wiring line terminal A.

The form of the substrate A may be a wafer or may be a chip; however, a form of a wafer is also one of the

preferred aspects of the present invention.

In the present invention, the wafer refers to a substrate including a semiconductor and has a concept including a panel or the like, which is formed from elements such as a plurality of semiconductors.

In the present invention, the chip refers to an individual piece including a semiconductor formed by dicing or the like, and it may be a single-sided chip or may be a double-sided chip.

The shape of the substrate A is not particularly limited, and examples thereof include a polygonal flat plate shape, a disk shape, and a polyhedral shape.

The thickness of the substrate A is preferably 0.1 to 5 mm and more preferably 0.2 to 1 mm.

The wiring line terminal A on the substrate A is preferably a pillar electrode.

In addition, the wiring line terminal A preferably contains a metal, more preferably contains at least one metal selected from the group consisting of tin (Sn), gold (Au), silver (Ag), copper (Cu), aluminum (Al), tungsten (W), palladium (Pd), platinum (Pt), cobalt (Co), nickel (Ni), zinc (Zn), ruthenium (Ru), iridium (Ir), rhodium (Rh), lead (Pb), bismuth (Bi), and indium (In), and still more preferably contains at least one metal selected from the group consisting of copper, tin, and nickel. In the present specification, containing at least one of a metal X or an alloy containing the metal X is collectively described as "containing a metal X". It is noted that the alloy may contain elements other than those exemplified above. For example, a copper alloy may contain a silicon atom to form a Corson alloy. In addition, oxygen that is inevitably dissolved, an organic residue of a raw material compound that is mixed during precipitation, or the like may be present.

The wiring line terminal A may be a wiring line terminal including a plurality of different members.

For example, one wiring line terminal A may be formed by providing, on a substrate, a portion (hereinafter, also referred to as an "electrode") that is used as an electrode consisting of a metal such as copper, silver, gold, or an alloy containing any or a plurality of these, forming, on an electrode such as copper, a portion (hereinafter, also referred to as "conduction path") that is used as a solder consisting of a metal such as nickel, tin, lead or an alloy containing any or a plurality of these, and allowing the electrode and the conduction path to be present in series.

Among these, the wiring line terminal A is preferably the wiring line terminal A that is obtained by including at least a member containing copper and a member containing tin. Examples of the substrate A that has a surface including such a wiring line terminal A include the example of the substrate B used in Examples of the present application. In the substrate B, a conduction path consisting of tin is formed on an electrode consisting of copper.

In addition, a material to be used for the electrode is not particularly limited; however, examples thereof include tin, gold, silver, copper, aluminum, tungsten, palladium, platinum, cobalt, nickel, zinc, ruthenium, iridium, rhodium, and alloys thereof. Among them, the electrode is preferably a metal including copper, a metal including aluminum, a metal including tungsten, a metal including nickel, or a metal including gold, more preferably a metal including copper, and still more preferably copper.

As a metal to be used for the electrode, it is preferable to use a metal that does not melt in the bonding step. The melting point of the metal to be used for the electrode is preferably 500°C or higher, more preferably 700°C or higher, and still more preferably 800°C or higher. The upper limit thereof is not particularly limited; however, it is preferably, for example, 3,000°C or lower.

A material to be used for the conduction path is not particularly limited; however, examples thereof include tin, lead, silver, copper, zinc, bismuth, or indium, or an alloy thereof. Above the above, a solder of tin or tin alloy (metal including tin) is preferable in the present invention. In recent years, a technology of lead-free solder that does not use lead has progressed, and thus it is also preferable to select such a material.

The metal to be used for the conduction path is preferably a metal that is melted in the bonding step. The melting point of the metal to be used for the conduction path is preferably 400°C or lower, more preferably 300°C or lower, and still more preferably 250°C or lower. The lower limit of the melting point is not particularly limited as long as the metal is solid at room temperature; however, it is, for example, preferably 150°C or higher.

In addition, it is preferable that a plurality of the wiring line terminals A are formed on the substrate A.

The material to be used for the substrate A is not particularly limited, and it may be a semiconductor production substrate such as silicon, silicon nitride, polysilicon, silicon oxide, amorphous silicon, quartz, glass, an optical film, a ceramic material, a vapor deposited film, magnetic film, a reflection film, a metal substrate such as Ni, Cu, Cr, or Fe, paper, a spin on glass (SOG), a thin film transistor (TFT) array substrate, an electrode plate of a plasma display panel (PDP), or the like, which is not particularly limited. A layer such as an adhesion layer made of hexamethyl disilazane (HMDS) or the like, or an oxide layer may be provided on a surface of a substrate. In the present invention, in particular, the semiconductor production substrate is preferable, and the silicon substrate (silicon wafer) is more preferable. The substrate A may have an electronic circuit region including an electronic circuit. In addition, the electronic circuit may have an element such as a semiconductor. In addition, it is preferable that the electronic circuit is electrically bonded to the wiring line terminal A.

Regarding a size in a case where the substrate A is a wafer, the diameter (the maximum diameter in a case where the substrate A is not circular) can be set to 100 mm or more. In addition, a size of a large-sized substrate is, for example, preferably 200 mm or more and more preferably 250 mm or more. The upper limit thereof is not particularly

limited; however, is preferably 2,000 mm or less.

Regarding a size in a case where the substrate A is a chip, the diameter (the maximum diameter in a case where the substrate A is not circular) is preferably 7 mm or more, more preferably 10 mm or more, and still more preferably 20 mm or more. The upper limit thereof is, for example, preferably 50 mm or less, more preferably 40 mm or less, and still more preferably 30 mm or less.

<Polyimide-containing precursor portion forming step>

The manufacturing method for a bonded body according to the embodiment of the present invention includes a polyimide-containing precursor portion forming step of forming a polyimide-containing precursor portion on the surface of the substrate A, where the wiring line terminal (wiring line terminal A) is provided on the surface of the substrate A.

The polyimide-containing precursor portion is preferably formed to be in contact with the wiring line terminal A, and it is more preferably formed to fill a recess part between the wiring line terminal A and the wiring line terminal A.

In addition, it suffices that the polyimide-containing precursor portion is formed on at least a part of the wiring line terminal A; however, for example, an aspect in which the polyimide-containing precursor portion is formed on the entire wiring line terminal A is also one of the preferred aspect of the present invention.

The polyimide-containing precursor portion forming step preferably includes applying a composition for forming a polyimide-containing precursor portion onto the surface of the substrate A, where the wiring line terminal is provided on the surface of the substrate A, and carrying out heating. Details of the application and the heating will be described later.

[Polyimide-containing precursor portion]

The polyimide-containing precursor portion is preferably a member containing a polyimide precursor and may further contain a component other than the polyimide precursor.

Examples of the component other than the polyimide precursor include a component other than the polyimide precursor, which is contained in the composition for forming a polyimide-containing precursor portion described later, and a component obtained by subjecting this component to modification (decomposition, polymerization, structural change, or the like) by due to heating.

The polyimide-containing precursor portion preferably further contains a polymerizable compound having a ring structure.

In addition, it is preferable that the polyimide-containing precursor portion further contains a polymerizable compound in which a glass transition temperature of a homopolymer is 200°C or higher.

Details of these polymerizable compounds will be described later.

The thickness of the polyimide-containing precursor portion is not particularly limited. However, from the viewpoint of exhibiting the effect of the physical properties of the polyimide-containing precursor portion, the thickness immediately before the bonding step (the thickness immediately before the flattening step in a case where the flattening step described later is carried out) is preferably 100 nm or more, more preferably 300 nm or more, still more preferably 500 nm or more, even still more preferably 1 μm or more, and even further still more preferably 2 μm or more. The upper limit thereof is not particularly limited; however, it is preferably 1 mm or less, more preferably 500 μm or less, and still more preferably 200 μm or less. The thickness of the film can be measured using a publicly known film thickness measuring device.

[Application step]

The polyimide-containing precursor portion forming step is preferably a step including applying a composition for forming a polyimide-containing precursor portion (hereinafter, also simply referred to as a "resin composition") onto the surface of the substrate A having the wiring line terminal A, where the wiring line terminal A is provided on the surface of the substrate A (an application step).

Here, it is also preferable that the polyimide-containing precursor portion forming step is a step of applying a composition for forming a polyimide-containing precursor portion onto the surface of the substrate A, where the wiring line terminal is provided on the surface of the substrate A, and the composition for forming a polyimide-containing precursor portion contains a polyimide precursor and a solvent.

The composition for forming a polyimide-containing precursor portion preferably further contains a migration suppressing agent.

It is preferable that the composition for forming a polyimide-containing precursor portion further contains a polymerizable compound having a ring structure.

It is preferable that the composition for forming a polyimide-containing precursor portion further contains a polymerizable compound in which a glass transition temperature of a homopolymer is 200°C or higher.

The details of the composition for forming a polyimide-containing precursor portion such as a migration suppressing agent and a polymerizable compound will be described later.

Examples of the means for applying the resin composition onto the substrate A include a dip coating method, an air knife coating method, a curtain coating method, a wiring line bar coating method, a gravure coating method, an extrusion coating method, a spray coating method, a spin coating method, a slit coating method, and an inkjet method. From the viewpoint of the uniformity of the film thickness, the spin coating method, the slit coating method, the spray coating method, or the ink jet method is more preferable, and from the viewpoint of the uniformity of the film thickness and the viewpoint of productivity, a spin coating method or a slit coating method is preferable. A film having a desired thickness can be obtained by adjusting the concentration of solid contents of the resin composition and application conditions according to the method. In addition, the coating method can be appropriately selected depending on the shape of the substrate. In a case where a circular substrate such as a wafer is used, the spin coating method, the spray coating method, the ink jet method, and the like are preferable, and in a case where a rectangular substrate is used, the slit coating method, the spray coating method, the inkjet method, and the like are preferable. For example, the spin coating method can be applied at a rotation speed of 500 to 3,500 rpm for about 10 seconds to 3 minutes.

In addition, it is also possible to apply a method of transferring a coating film formed in advance on a temporary support by the above-described application method, onto a substrate.

Regarding the transfer method, the production methods disclosed in paragraphs 0023 and 0036 to 0051 of JP2006-023696A and paragraphs 0096 to 0108 of JP2006-047592A can also be suitably used in the present invention.

In addition, a step of removing an unnecessary film at the end part of the substrate may be carried out. Examples of such a step include edge bead rinse (EBR) and back rinse.

Further, a pre-wetting step of applying various solvents onto the substrate before applying the resin composition onto the substrate to improve the wettability of the substrate and then applying the resin composition may be adopted.

In addition, in a case where the resin composition contains a solvent, a step of applying the resin composition to the substrate A and then drying a member (hereinafter, also simply referred to as a "film") consisting of the resin composition (a drying step) may be included.

The drying temperature in the drying step is preferably 50°C to 150°C, more preferably 70°C to 130°C, and still more preferably 90°C to 110°C. In addition, the drying may be carried out by reducing the pressure. Examples of the drying time include 30 seconds to 20 minutes, and the drying time is preferably 1 minute to 10 minutes and more preferably 2 minutes to 7 minutes.

The thickness immediately after the application (the thickness after drying in a case where the drying step is carried out) is not particularly limited, and it may be appropriately adjusted so that the thickness of the obtained polyimide-containing precursor portion is the thickness described later.

The polyimide-containing precursor portion forming step may include a step of patterning the member consisting of the resin composition. In a case where a resin composition containing a photosensitive compound such as a photopolymerization initiator described below is used as the resin composition, the patterning can be carried out by exposure and development.

After the polyimide-containing precursor portion is formed, the surface thereof may be flattened. Details of the flattening will be described later. It is noted that in a case where patterning has been carried out, the thickness of a portion removed by development or the like is not used in the calculation of the film thickness difference (T1 - T2) described later.

[Exposure step]

The film may be subjected to an exposure step of selectively exposing the film.

That is, the manufacturing method for a bonded body according to the embodiment of the present invention may include an exposure step of selectively exposing the polyimide-containing precursor portion formed by the polyimide-containing precursor portion forming step.

The selective exposure means that a part of the polyimide-containing precursor portion is exposed. In addition, by the selective exposure, an exposed region (an exposed portion) and an unexposed region (a non-exposed portion) are formed in the polyimide-containing precursor portion.

The exposure amount is not particularly specified as long as the resin composition according to the embodiment of the present invention can be cured; however, it is, for example, preferably 50 to 10,000 $mJ/cm^2$ and more preferably 200 to 8,000 $mJ/cm^2$ in terms of conversion of exposure energy at a wavelength of 365 nm.

The exposure wavelength can be appropriately determined in a range of 190 to 1,000 nm and preferably in a range of 240 to 550 nm.

Examples of the exposure wavelength, which are mentioned in the relationship with the light source, include (1) a semiconductor laser (wavelength: 830 nm, 532 nm, 488 nm, 405 nm, 375 nm, 355 nm, or the like); (2) a metal halide lamp; (3) a high-pressure mercury lamp, a g-line (wavelength: 436 nm), an h-line (wavelength: 405 nm), an i-line

(wavelength: 365 nm), or broadband light (three wavelengths of the g, h, and i-line); (4) an excimer laser, a KrF excimer laser (wavelength: 248 nm), an ArF excimer laser (wavelength: 193 nm), or an $F_2$ excimer laser (wavelength: 157 nm); (5) an extreme ultraviolet ray: EUV (wavelength: 13.6 nm); (6) an electron beam; and (7) a second harmonic wave of 532 nm and a third harmonic wave of 355 nm of a YAG laser. In the manufacturing method for a bonded body according to the embodiment of the present invention, the exposure with a high-pressure mercury lamp is particularly preferable, and the exposure with an i-line is particularly preferable. In this case, particularly high exposure sensitivity can be obtained.

In addition, the exposure method is not particularly limited as long as at least a part of the polyimide-containing precursor portion consisting of the resin composition is exposed; however, examples thereof include exposure using a photo mask and exposure by a laser direct imaging method.

<Post-exposure heating step>

The polyimide-containing precursor portion may be subjected to a step of carrying out heating after the exposure (a post-exposure heating step).

That is, the manufacturing method for a bonded body according to the embodiment of the present invention may include a post-exposure heating step of heating the polyimide-containing precursor portion exposed by the exposure step.

The post-exposure heating step can be carried out after the exposure step and before the development step.

The heating temperature in the post-exposure heating step is preferably 50°C to 140°C and more preferably 60°C to 120°C.

The heating time in the post-exposure heating step is preferably 30 seconds to 300 minutes and more preferably 1 minute to 10 minutes.

In the post-exposure heating step, the temperature elevation rate from the temperature at the start of heating to the maximum heating temperature is preferably 1 to 12 °C/min, more preferably 2 to 10 °C/min, and still more preferably 3 to 10 °C/min.

In addition, the temperature elevation rate may be appropriately changed during heating. The heating means in the post-exposure heating step is not particularly limited, and a publicly known hot plate, oven, infrared heater, or the like can be used.

In addition, it is also preferable to carry out the heating in an atmosphere having a low oxygen concentration by allowing an inert gas such as nitrogen, helium, argon, or the like to flow.

<Development Step>

The exposed polyimide-containing precursor portion may be subjected to a development step of carrying out development using a developer to form a pattern.

That is, the manufacturing method for a bonded body according to the embodiment of the present invention may include a development step of developing the film exposed in the exposure step using a developer to form a pattern. By carrying out the development, one of the exposed portion and the non-exposed portion of the film is removed, and a pattern is formed.

Here, the development in which the non-exposed portion of the polyimide-containing precursor portion is removed by the development step is referred to as negative tone development, and the development in which the exposed portion of the polyimide-containing precursor portion is removed by the development step is referred to as positive tone development.

[Developer]

Examples of the developer that is used in the development step include a developer containing an alkaline aqueous solution or an organic solvent.

In a case where the developer is an alkaline aqueous solution, examples of the basic compound that can be contained in the alkaline aqueous solution include inorganic alkalis, primary amines, secondary amines, tertiary amines, and a quaternary ammonium salt. The basic compound is preferably tetramethylammonium hydroxide (TMAH), sodium hydroxide, potassium hydroxide, sodium carbonate, sodium silicate, sodium metasilicate, ammonia, ethylamine, n-propylamine, diethylamine, di-n-butylamine, triethylamine, methyldiethylamine, dimethylethanolamine, triethanolamine, tetraethylammonium hydroxide, tetrapropylammonium hydroxide, tetrabutylammonium hydroxide, tetrapentylammonium hydroxide, tetrahexylammonium hydroxide, tetraoctylammonium hydroxide, ethyltrimethylammonium hydroxide, butyltrimethylammonium hydroxide, methyltriamylammonium hydroxide, and dibutyldipentylammonium hydroxide, dimethylbis(2-hydroxyethyl)ammonium hydroxide, trimethylphenylammonium hydroxide, trimethylbenzylammonium hydroxide, triethylbenzylammonium hydroxide, pyrrole, or piperidine, and it is more preferably TMAH. For example, in a

case where TMAH is used, the content of the basic compound in the developer is preferably 0.01% to 10% by mass, more preferably 0.1% to 5% by mass, and still more preferably 0.3% to 3% by mass with respect to the total mass of the developer.

In a case where the rinsing liquid contains an organic solvent, suitable examples of the organic solvent include esters such as ethyl acetate, n-butyl acetate, amyl formate, isoamyl acetate, isobutyl acetate, butyl propionate, isopropyl butyrate, ethyl butyrate, butyl butyrate, methyl lactate, ethyl lactate, γ-butyrolactone, ε-caprolactone, δ-valerolactone, an alkyl alkyloxyacetate (example: a methyl alkyloxyacetate, an ethyl alkyloxyacetate, and a butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (example: a methyl 3-alkyloxypropionate and an ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (example: a methyl 2-alkyloxypropionate, an ethyl 2-alkyloxypropionate, and a propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), a methyl 2-alkyloxy-2-methylpropionate and an ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, and ethyl 2-oxobutanoate; ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether (PGME), propylene glycol monomethyl ether acetate (PGMEA), propylene glycol monoethyl ether acetate, and propylene glycol monopropyl ether acetate; ketones such as methyl ethyl ketone, cyclohexanone, cyclopentanone, 2-heptanone, 3-heptanone, and N-methyl-2-pyrrolidone; cyclic hydrocarbons, for example, aromatic hydrocarbons such as toluene, xylene, and anisole, and cyclic terpenes such as limonene; sulfoxides such as dimethyl sulfoxide; and alcohols such as methanol, ethanol, propanol, isopropanol, butanol, pentanol, octanol, diethylene glycol, propylene glycol, methylisobutyl carbinol, and triethylene glycol; and amides such as N-methylpyrrolidone, N-ethylpyrrolidone, and dimethylformamide.

In a case where the developer contains an organic solvent, one kind of organic solvent can be used, or two or more kinds thereof can be mixedly used. In the present invention, in particular, a developer containing at least one selected from the group consisting of cyclopentanone, γ-butyrolactone, dimethyl sulfoxide, N-methyl-2-pyrrolidone, and cyclohexanone is preferable, a developer containing at least one selected from the group consisting of cyclopentanone, γ-butyrolactone, and dimethyl sulfoxide is more preferable, and a developer containing cyclopentanone is most preferable.

In a case where the developer contains an organic solvent, the content of the organic solvent with respect to the total mass of the developer is preferably 50% by mass or more, more preferably 70% by mass or more, still more preferably 80% by mass or more, and particularly preferably 90% by mass or more. In addition, the above content may be 100% by mass.

The developer may further contain another component.

Examples of the other component include a publicly known surfactant and a publicly known antifoaming agent.

[Method of supplying developer]

The method of supplying a developer is not particularly limited as long as a desired pattern can be formed, and it includes a method of immersing a substrate on which a film has been formed in a developer, puddle development of supplying a developer to a film formed on a substrate using a nozzle, and a method of continuously supplying a developer. The kind of nozzle is not particularly limited, and examples thereof include a straight nozzle, a shower nozzle, and a spray nozzle.

From the viewpoint of the permeability of the developer, the removability of the nonimage area, and the manufacturing efficiency, a method of supplying a developer with a straight nozzle or a method of continuously supplying a developer with a spray nozzle is preferable, and from the viewpoint of the permeability of the developer into the image area, a method of supplying a developer with a spray nozzle is more preferable.

In addition, after the continuous supply by a straight nozzle, the substrate is spun to remove the developer from the substrate, and then the developer is continuously supplied by the straight nozzle again after the spin drying, a step of spinning the substrate to remove the developer from the substrate may be adopted, and this step may be repeated a plurality of times.

In addition, in the method of supplying a developer in the development step, a step of continuously supplying a developer to a substrate, a step of keeping a developer in a substantially stationary state on a substrate, a step of vibrating a developer on a substrate by ultrasonic waves or the like, and a step obtained by combining these steps can be adopted.

The development time is preferably 10 seconds to 10 minutes and more preferably 20 seconds to 5 minutes. The temperature of the developer at the time of the development is not particularly specified; however, rinsing can be

preferably carried out at 10°C to 45°C and more preferably 18°C to 30°C.

In the development step, washing (rinsing) of the pattern with a rinsing liquid may be further carried out after the treatment with the developer. In addition, a method such as supplying a rinsing liquid before the developer which is in contact with the pattern is completely dried may be adopted.

[Rinsing liquid]

In a case where the developer is an alkaline aqueous solution, it is possible to use, for example, water as the rinsing liquid. In a case where the developer is a developer containing an organic solvent, it is possible to use as the rinsing liquid, for example, a solvent (for example, water, an organic solvent different from the organic solvent contained in the developer) different from the solvent contained in the developer.

In a case where the rinsing liquid contains an organic solvent, suitable examples of the organic solvent include esters such as ethyl acetate, n-butyl acetate, amyl formate, isoamyl acetate, isobutyl acetate, butyl propionate, isopropyl butyrate, ethyl butyrate, butyl butyrate, methyl lactate, ethyl lactate, γ-butyrolactone, ε-caprolactone, δ-valerolactone, an alkyl alkyloxyacetate (example: a methyl alkyloxyacetate, an ethyl alkyloxyacetate, and a butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (example: a methyl 3-alkyloxypropionate and an ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (example: a methyl 2-alkyloxypropionate, an ethyl 2-alkyloxypropionate, and a propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), a methyl 2-alkyloxy-2-methylpropionate and an ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, and ethyl 2-oxobutanoate; ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether (PGME), propylene glycol monomethyl ether acetate (PGMEA), propylene glycol monoethyl ether acetate, and propylene glycol monopropyl ether acetate; ketones such as methyl ethyl ketone, cyclohexanone, cyclopentanone, 2-heptanone, 3-heptanone, and N-methyl-2-pyrrolidone; cyclic hydrocarbons, for example, aromatic hydrocarbons such as toluene, xylene, and anisole, and cyclic terpenes such as limonene; sulfoxides such as dimethyl sulfoxide; and alcohols such as methanol, ethanol, propanol, isopropanol, butanol, pentanol, octanol, diethylene glycol, propylene glycol, methylisobutyl carbinol, and triethylene glycol; and amides such as N-methylpyrrolidone, N-ethylpyrrolidone, and dimethylformamide.

In a case where the rinsing liquid contains an organic solvent, one kind of organic solvent can be used, or two or more kinds thereof can be mixedly used. In the present invention, cyclopentanone, γ-butyrolactone, dimethyl sulfoxide, N-methylpyrrolidone, cyclohexanone, PGMEA, or PGME is particularly preferable, cyclopentanone, γ-butyrolactone, dimethyl sulfoxide, PGMEA, or PGME is more preferable, and cyclohexanone or PGMEA is still more preferable.

In a case where the rinsing liquid contains an organic solvent, the content of the organic solvent in the rinsing liquid is preferably 50% by mass or more, the content of the organic solvent is more preferably 70% by mass or more, and the content of the organic solvent is still more preferably 90% by mass or more. In addition, 100% by mass of the rinsing liquid may be an organic solvent.

The rinsing liquid may further contain another component.

Examples of the other component include a publicly known surfactant and a publicly known antifoaming agent.

[Method of supplying rinsing liquid]

The method of supplying a rinsing liquid is not particularly limited as long as a desired pattern can be formed and includes a method of immersing a substrate in a rinsing liquid, a method of supplying a rinsing liquid to a substrate by liquid filling, a method of supplying a rinsing liquid to a substrate with a shower, and a method of continuously supplying a rinsing liquid to a substrate by means such as a straight nozzle.

From the viewpoint of the permeability of the rinsing liquid, the removability of nonimage area, and the manufacturing efficiency, there is a method of supplying a rinsing liquid with a shower nozzle, a straight nozzle, a spray nozzle, or the like, and a method of continuously supplying a rinsing liquid with a spray nozzle is preferable. From the viewpoint of the permeability of the rinsing liquid into the image area, a method of supplying a rinsing liquid with a spray nozzle is more preferable. The kind of nozzle is not particularly limited, and examples thereof include a straight nozzle, a shower nozzle, and a spray nozzle.

That is, the rinsing step is preferably a step of supplying, with a straight nozzle, or continuously supplying a rinsing liquid to the film after the exposure, and it is more preferably a step of supplying a rinsing liquid with a spray nozzle.

In addition, in the method of supplying a rinsing liquid in the rinsing step, a step of continuously supplying a rinsing liquid to a substrate, a step of keeping a rinsing liquid in a substantially stationary state on a substrate, a step of vibrating a rinsing liquid on the substrate by ultrasonic waves or the like, and a step obtained by combining these steps can be adopted.

The rinsing time is preferably 10 seconds to 10 minutes and more preferably 20 seconds to 5 minutes. The temperature of the rinsing liquid during rinsing is not particularly specified; however, rinsing can be preferably carried out at 10°C to 45°C and more preferably 18°C to 30°C.

<Heating step>

The polyimide-containing precursor portion obtained by the polyimide-containing precursor portion forming step is preferably subjected to a heating step of heating the polyimide-containing precursor portion.

That is, the manufacturing method for a bonded body according to the embodiment of the present invention may include a heating step of heating the polyimide-containing precursor portion.

In the heating step, a part of the resin such as the polyimide precursor is cyclized to become a resin such as polyimide.

In addition, the crosslinking of unreacted crosslinkable groups in the specific resin or a crosslinking agent other than the specific resin also proceeds.

The heating temperature (the maximum heating temperature) in the heating step is preferably 250°C or lower, more preferably 220°C or lower, and still more preferably 200°C or lower, and it can be also set to 180°C or lower.

The lower limit of the heating temperature is preferably 160°C or higher and more preferably 170°C or higher.

In a case of adjusting the heating conditions such as the heating temperature and the heating time in the heating step, it is possible to adjust the cyclization rate of the polyimide in the polyimide-containing precursor portion. Specifically, although the cyclization rate of the polyimide increases in a case where heating is carried out at a higher temperature and for a longer time, a difference between a cyclization rate of a polyimide in the polyimide-containing precursor portion before the bonding step and a cyclization rate of a polyimide in a polyimide-containing portion formed at a bonded portion after the bonding step decreases.

The heating step is preferably a step of accelerating the cyclization reaction of the polyimide precursor in the pattern under the action of the base or the like generated from the base generator by heating.

The heating in the heating step is preferably carried out at a temperature elevation rate of 1 to 12°C/min from the temperature at the start of heating to the maximum heating temperature. The temperature elevation rate is more preferably 2 to 10°C/min and still more preferably 3 to 10°C/min. In a case where the above temperature elevation rate is set to 1 °C/min or higher, the excessive volatilization of the acid or solvent can be prevented while securing productivity, and in a case where the above temperature elevation rate is to 12 °C/min or lower, the residual stress of the cured substance can be relaxed.

In addition, in a case of an oven that enables rapid heating, the heating is preferably carried out at a temperature elevation rate of 1 to 8°C/sec from the temperature at the start of heating to the maximum heating temperature, more preferably 2 to 7 °C/sec, and still more preferably 3 to 6 °C/sec.

The temperature at the start of heating is preferably 20°C to 150°C, more preferably 20°C to 130°C, and still more preferably 25°C to 120°C. The temperature at the start of heating refers to a temperature at which the step of heating to the maximum heating temperature is started. For example, in a case where the resin composition according to the embodiment of the present invention is applied on a substrate and then dried, the temperature at the start of heating is the temperature of the film (layer) after drying, and for example, it is preferable to raise the temperature from a temperature lower by 30°C to 200°C than the boiling point of the solvent contained in the resin composition according to the embodiment of the present invention.

The heating time (the heating time at the maximum heating temperature) is preferably 1 to 60 minutes, more preferably 2 to 30 minutes, and still more preferably 5 to 20 minutes.

The heating may be carried out stepwise. For example, a step in which the temperature is raised from 25°C to 120°C at 3 °C/min, held at 120°C for 60 minutes, raised from 120°C to 200°C at 2 °C/min, and held at 200°C for 10 minutes, may be carried out. In addition, it is also preferable to carry out the treatment while irradiating with ultraviolet rays as described in US9159547B. By such a pretreatment step, it is possible to improve the properties of the film. The pretreatment step may be carried out for a short time of about 10 seconds to 2 hours and more preferably 15 seconds to 30 minutes. The pretreatment step may be carried out in two or more stages, for example, a first stage pretreatment step may be carried out in a range of 100°C to 150°C, and then a second stage pretreatment step may be carried out in a range of 150°C to 200°C.

Further, cooling may be carried out after heating, and the cooling rate, in this case, is preferably 1 to 5 °C/min.

From the viewpoint of preventing the decomposition of the specific resin, it is preferable that the heating step is carried out in an atmosphere of a low oxygen concentration, for example, by allowing an inert gas such as nitrogen,

helium, argon, or the like to flow, or carrying out heating under reduced pressure. The oxygen concentration is preferably 50 ppm (volume ratio) or lower, and more preferably 20 ppm (volume ratio) or lower.

The heating means in the heating step is not particularly limited; however, examples thereof include a hot plate, an infrared furnace, an electric heating oven, a hot air oven, and an infrared oven.

<Post-exposure step>

The polyimide-containing precursor portion obtained by the polyimide-containing precursor portion forming step may be subjected to a post-exposure step of exposing the polyimide-containing precursor portion instead of the heating step or in addition to the heating step.

That is, the manufacturing method for a bonded body according to the embodiment of the present invention may include a post-exposure step of exposing the polyimide-containing precursor portion. The manufacturing method for a bonded body according to the embodiment of the present invention may include the heating step and the post-exposure step or may include only one of the heating step and the post-exposure step.

In the post-exposure step, it is possible to accelerate, for example, a reaction in which the cyclization of a polyimide precursor or the like proceeds by photosensitization of a photobase generator, a reaction in which the elimination of an acid-decomposable group proceeds by photosensitization of a photoacid generator.

In the post-exposure step, it is sufficient that at least a part of the polyimide-containing precursor portion is exposed; however, it is preferable that the entire polyimide-containing precursor portion is exposed.

The exposure amount in the post-exposure step is preferably 50 to 20,000 $mJ/cm^2$ and more preferably 100 to 15,000 $mJ/cm^2$ in terms of conversion of exposure energy at the wavelength at which the photosensitive compound has a sensitivity.

The post-exposure step can be carried out using, for example, the light source in the above-described exposure step, and it is preferable to use broadband light.

<Formation with two or more layers>

In the polyimide-containing precursor portion forming step, forming the polyimide-containing precursor portion with two or more layers is also one of the preferred aspects of the present invention.

That is, the polyimide-containing precursor portion may have a structure in which a plurality of layers consisting of a resin composition are laminated. However, a part of a first layer may be dissolved in a solvent in the formation of a second layer, which makes the interface between these layers indistinct.

In a case where the polyimide-containing precursor portion is configured to have two or more layers, the flatness of the surface of the polyimide-containing precursor portion is improved, and there is an advantage in that, for example, the flattening step described later is easily carried out.

In the above aspect, the polyimide-containing precursor portion is preferably formed from 2 to 4 layers, more preferably formed from 2 or 3 layers, and still more preferably formed from 2 layers.

In a case where the polyimide-containing precursor portion is formed from two or more layers, such an aspect in which, for example, after carrying out the application step (further, the drying step as necessary) is continuously carried out, the above-described exposure step, post-exposure heating step, and development step are carried out as necessary, and the above-described heating step is carried out may be adopted.

In addition, after carrying out the above-described application step, and as necessary, exposure step, post-exposure heating step, and development step, the above-described heating step may be carried out to form a first layer, and then after subjecting the first layer to the above-described application step, and as necessary, exposure step, post-exposure heating step, and development step, the above-described heating step may be carried out to form the second and subsequent layers.

Further, in a case where the first layer is subjected to steps from the application step to the heating step, the second and subsequent layers may be subjected to steps from the application step to the heating step in a state where the conditions of the exposure step and the heating step, which are carried out as necessary, are adjusted to be conditions for semi-curing.

In addition, in a case where the polyimide-containing precursor portion is formed from two or more layers, the components contained in the resin compositions to be used for forming the respective layers and the content proportions of the respective components may be the same or different from each other.

<Step of preparing substrate B>

The manufacturing method for a bonded body according to the embodiment of the present invention includes a step of preparing a substrate B having a surface on which a wiring line terminal is provided.

The form of the substrate B may be a wafer or may be a chip; however, these may be selected depending on the design of a desired bonded body.

[Substrate B]

The substrate B has a wiring line terminal.

Hereinafter, the wiring line terminal on the substrate B is also described as a wiring line terminal B.

The thickness of the substrate B is preferably 0.1 to 5 mm and more preferably 0.2 to 1 mm.

In a bonded body to be obtained by the bonding step described later, it is preferable that at least a part of the wiring line terminal B is electrically bonded to the wiring line terminal A on the above-described substrate A.

The material to be used for the substrate B is not particularly limited, and preferred examples thereof include the same materials as those of the above-described substrate A.

In addition, a preferred aspect of the wiring line terminal B is the same as the preferred aspect of the wiring line terminal A.

The substrate B may have an electronic circuit region including an electronic circuit. In addition, the electronic circuit may have an element such as a semiconductor. In addition, it is preferable that the electronic circuit is electrically bonded to the wiring line terminal.

Regarding a size in a case where the substrate B is a wafer, the diameter (the maximum diameter in a case where the substrate B is not circular) can be set to 100 mm or more. In addition, a size of a large-sized substrate is, for example, preferably 200 mm or more and more preferably 250 mm or more. The upper limit thereof is not particularly limited; however, is preferably 2,000 mm or less.

Regarding a size in a case where the substrate B is a chip, the diameter (the maximum diameter in a case where the substrate B is not circular) is preferably 7 mm or more, more preferably 8 mm or more, and still more preferably 10 mm or more. The upper limit thereof is, for example, preferably 50 mm or less, more preferably 30 mm or less, and still more preferably 20 mm or less.

In addition, it is also preferable that the substrate B includes an inorganic insulating film between the wiring line terminals.

The inorganic insulating film is not particularly limited; however, examples thereof include a silicon oxide film, a silicon nitride film, a silicon oxynitride film (the content ratio of oxygen to nitrogen is not particularly limited), an aluminum oxide film, an aluminum nitride film, a hafnium oxide film, a yttrium oxide film, a zirconium oxide film, a gallium oxide film, a tantalum oxide film, a magnesium oxide film, a lanthanum oxide film, a cerium oxide film, a neodymium oxide film, and a silicon carbon nitride (SiCN) film.

In a case where the substrate B includes an inorganic insulating film, specific examples thereof include the substrate C in Examples described later.

It is preferable that the inorganic insulating film insulates a plurality of electrodes included in the wiring line terminal B.

In addition, in a case where the substrate B includes an inorganic insulating film, the second polyimide-containing precursor portion forming step described later may be carried out; however, an aspect in which the second polyimide-containing precursor portion forming step is not carried out can also be adopted.

<Second polyimide-containing precursor portion forming step>

The manufacturing method for a bonded body according to the embodiment of the present invention preferably further includes, before the bonding step, a second polyimide-containing precursor portion forming step of forming a second polyimide-containing precursor portion on the surface of the substrate B, where the wiring line terminal is provided on the surface of the substrate B.

The second polyimide-containing precursor portion forming step can be carried out, for example, according to the same method as the above-described polyimide-containing precursor portion forming step for the substrate A.

Here, in the second polyimide-containing precursor portion forming step, the composition for forming a polyimide-containing precursor portion according to the embodiment of the present invention may be used, or another publicly known composition for forming a polyimide-containing precursor portion may be used. However, it is preferable to use the composition for forming a polyimide-containing precursor portion according to the embodiment of the present invention.

However, in a case where the composition for forming a polyimide-containing precursor portion according to the embodiment of the present invention is used in the second polyimide-containing precursor portion forming step, the composition of the composition for forming a polyimide-containing precursor portion according to the embodiment of the present invention, which is used in the second polyimide-containing precursor portion forming step, and the composition of the composition for forming a polyimide-containing precursor portion, which is used in the polyimide-containing precursor portion forming step for the substrate A may be the same or different from each other.

A preferred aspect of the second polyimide-containing precursor portion is the same as the preferred aspect of the polyimide-containing precursor portion that is formed on the above-described substrate A.

The adhesiveness in the bonded body is considered to be improved in a case where the second polyimide-containing precursor portion and the polyimide-containing precursor portion formed on the above-described substrate A are bonded in the bonding step described later so that at least parts thereof are in contact with each other.

[Flattening step]

The manufacturing method for a bonded body according to the embodiment of the present invention preferably includes a flattening step of flattening a surface of the polyimide-containing precursor portion on the substrate A, between the polyimide-containing precursor portion forming step and the bonding step.

In the bonding step described later, it is preferable that the flattened polyimide-containing precursor portion in the substrate A and the surface of the substrate B (or the surface of the second polyimide-containing precursor portion which may be flattened) are bonded to be in contact with each other.

It is preferable that the wiring line terminal A on the substrate A is exposed from the polyimide-containing precursor portion by the flattening.

In addition, in the substrate A and the polyimide-containing precursor portion after the flattening, the wiring line terminal A and the polyimide-containing precursor portion may have the same height, the terminal A may be recessed with respect to the polyimide-containing precursor portion, or the polyimide-containing precursor portion may be recessed with respect to the wiring line terminal A.

Here, a difference in the height between the wiring line terminal A and the polyimide-containing precursor portion is preferably ± 1 μm or less and more preferably ± 0.5 μm or less.

The flattening may be carried out by physical polishing such as cutting, mechanical polishing, grinding, plasma treatment, or laser ablation or may be carried out by chemical polishing such as chemical mechanical polishing (CMP).

The polishing rate of the polyimide-containing precursor portion during the flattening preferably 200 nm/min or more, more preferably 400 nm/min or more, still more preferably 900 nm/min or more, and even still more preferably 1,800 nm/min or more. The upper limit of the polishing rate is not particularly limited; however, it is preferably less than 3,000 nm/min from the viewpoint of controlling the in-plane uniformity of an object to be polished.

The polishing rate of the wiring line terminal A on the substrate A during the flattening is preferably equal to or lower than the polishing rate of the polyimide-containing precursor portion, and it is more preferably half or less of the polishing rate of the polyimide-containing precursor portion.

A slurry to be used in the CMP is not particularly limited; however, a silica slurry, a ceria slurry, an alumina slurry, or the like can be used. The size of the particle of the slurry is not particularly limited; however, from the viewpoint of suppressing scratches, the average particle diameter is preferably 1,000 nm or less, more preferably 500 nm or less, and still more preferably 200 nm or less. The lower limit of the particle size of the slurry is not particularly limited; however, it is preferably 10 nm or more from the viewpoint of the polishing rate.

In addition, these methods may be combined, where CMP is carried out after cutting.

Specific examples thereof include an aspect in which the surface of the polyimide-containing precursor portion is cut with a diamond byte to expose a new surface of the polyimide-containing precursor portion and the wiring line terminal A. The wiring line terminal A and the polyimide-containing precursor portion on the substrate A are subjected to a flattening treatment so that the wiring line terminal A is exposed, whereby the head of the wiring line terminal A can protrude due to the collective flattening of the wiring line terminal A and the polyimide-containing precursor portion.

The flattening can be carried out by, for example, a surface planer. Examples of the surface planer include those in which a diamond byte is mounted on a spindle, which includes DFS8910, DFS8960, DAS8920, and DAS8930 (all of which are product names) manufactured by DISCO Corporation.

- TTV -

In the flattening step, the polyimide-containing precursor portion is preferably flattened together with the wiring line terminal A. Regarding the degree of the flattening, a total thickness variation (TTV) of the polyimide-containing precursor portion and the wiring line terminal A is preferably 10 μm or less, more preferably 5 μm or less, and still more preferably 3 μm or less.

In the present invention, the TTV refers to an arithmetic average value of film thickness differences (T1 - T2) of a group of compartments which is obtained by dividing a region located inside an edge part of the polyimide-containing precursor portion by 1 mm or more into compartments having a size of a 2 mm square (in a case where the polyimide-containing precursor portion cannot be divided into compartments having a size of a 2 mm square, for example, in a case where the area of the polyimide-containing precursor portion is very small, the entire region located inside the edge

part of the polyimide-containing precursor portion by 1 mm or more is regarded as one compartment), measuring, for each compartment, a maximum thickness (T1) between one surface and the other surface and a minimum thickness (T2) between one surface and the other surface, calculating a film thickness difference (T1 - T2) for each compartment, placing an order to each compartment in the descending order of the film thickness difference (T1 - T2), and excluding a group of compartments, the number of which corresponds to 10% of the total number of compartments in the descending order of the film thickness difference from the uppermost compartment (having the largest film thickness difference) (rounding to the nearest decimal place in a case where the decimal places are present), and a group of compartments, the number of which corresponds to 10% of the total number of compartments in the ascending order of the film thickness difference from the lowermost compartment (having the smallest film thickness difference) (rounding to the nearest decimal place in a case where the decimal places are present).

In the present specification, in a case where the TTV of the polyimide-containing precursor portion defined here is particularly meant, it may be referred to as a "compartment evaluation TTV". In a case where the TTV of the polyimide-containing precursor portion is set to be equal to or smaller than the above-described upper limit value, the film thickness is roughly uniform, and thus the adhesiveness to the substrate B is improved.

- Ra -

In the polyimide-containing precursor portion according to the present invention, a surface roughness Ra of a surface on a side opposite to the side in contact with the surface of the substrate A is preferably 10 nm or more and 1.5 μm or less. The upper limit thereof is preferably 1 μm or less, more preferably 500 nm or less, still more preferably 300 nm or less, even more preferably 200 nm or less, even still more preferably 150 nm or less, and even further still more preferably 120 nm or less.

In a case where the surface roughness of the polyimide-containing precursor portion is set to be equal to or larger than the above-described lower limit value, the anchor effect works, and thus the adhesiveness to the substrate B can be improved.

In addition, in a case where the surface roughness is set to be equal to or smaller than the above-described upper limit value, it is possible to effectively suppress the occurrence of defects such as voids due to the bonding with the incorporation of bubbles and the like in the bonding to the substrate B.

In a case where the second polyimide-containing precursor portion is formed on the substrate B, it is preferable to include a second flattening step of flattening a surface of the second polyimide-containing precursor portion, between the second polyimide-containing precursor portion forming step and the bonding step.

The second flattening step can be carried out according to the same method as the flattening step for the above-described substrate A.

<Bonding step>

The manufacturing method for a bonded body according to the embodiment of the present invention includes a bonding step of bonding the surface of the substrate A, where the polyimide-containing precursor portion is provided on the surface of the substrate A, to the surface of the substrate B, where the wiring line terminal is provided on the surface of the substrate B.

In a case where the substrate B has the second polyimide-containing precursor portion, the bonding step is a step of bonding a surface of the substrate A, where the polyimide-containing precursor portion is provided on the surface of the substrate A, to a surface of the substrate B, which has the second polyimide-containing precursor portion.

By the bonding, the wiring line terminal A on the substrate A and the wiring line terminal B on the substrate B are electrically bonded.

In the bonding step, an aspect in which an electrode included on the surface of the substrate A, where the polyimide-containing precursor portion is provided on the surface of the substrate A, and an electrode on the surface of the substrate B, where the wiring line terminal is provided on the surface of the substrate B, are bonded to be in direct contact with each other is also one of the preferred aspects of the present invention.

That is, it is also preferable that both the wiring line terminal A and the wiring line terminal B do not have a conduction path.

The bonding is preferably carried out by a means including heating and more preferably carried out by a means including heating and pressurization.

The temperature (bonding temperature) at the time of bonding is preferably 100°C or higher, more preferably 150°C or higher, and still more preferably 180°C or higher. The upper limit thereof is preferably 450°C or lower, more preferably 400°C or lower, still more preferably 380°C or lower, particularly preferably 350°C or lower, even still more preferably 300°C or lower, even still more preferably 280°C or lower, even still even more preferably 260°C or lower, and even further still more preferably 250°C or lower. This temperature is preferably a temperature near the melting

point of the conduction path in consideration of the fact that the conduction path is melted to enable the electrodes to be bonded to each other as described above.

The heating time in the bonding step is not particularly limited; however, it is preferably 5 seconds or more, more preferably 1 minute or more, and still more preferably 2 minutes or more. The upper limit thereof is practically 30 minutes or less.

The environment at the time of heating is not particularly limited; however, it is preferable to carry out the heating while mechanically pressurizing the polyimide-containing precursor portion in a reduced pressure atmosphere. The atmospheric pressure is preferably $1 \times 10^{-5}$ mbar or more, more preferably $1 \times 10^{-4}$ mbar or more, and still more preferably $5 \times 10^{-4}$ mbar or more. The upper limit thereof is preferably 0.1 mbar or less, more preferably $1 \times 10^{-2}$ mbar or less, and still more preferably $5 \times 10^{-3}$ mbar or less.

The bonding is preferably carried out by sandwiching two substrates (the substrate A and the substrate B), and in this case, it is preferable to apply pressure to the substrates. The pressure to be applied to the substrate is preferably 1 kN or more, more preferably 5 kN or more, and still more preferably 10 kN or more. The upper limit thereof is practically 100 kN or less. A device to be used in the bonding step is not particularly limited; however, a device that is used for reflow of an electronic component can be suitably to be used.

In addition, in the bonding step, it is also preferable that the temperature of the substrate A including the polyimide-containing precursor portion is preheated to 70°C or higher.

In addition, in a case where the substrate B includes the second polyimide-containing precursor portion, it is also preferable that the temperature of the substrate B is preheated to 70°C or higher.

The temperature is preferably 70°C or higher and more preferably 90°C or higher. In addition, the upper limit of the temperature is not particularly limited; however, it is preferably 130°C or lower.

According to the aspect, the tact time of the bonding process can be reduced.

In addition, the fluidity of the polyimide-containing precursor portion at the time of bonding may be improved, which improves the maximum peeling resistance force.

By the bonding step, the polyimide-containing precursor portion becomes a polyimide-containing portion.

Here, in a case where the substrate B has the second polyimide-containing precursor portion, the polyimide-containing portion is formed from the polyimide-containing precursor portion and the second polyimide-containing precursor portion.

The thermal diffusivity of the polyimide-containing portion is preferably $2.0 \times 10^{-7}$ $m^2s^{-1}$ or more and more preferably $3.0 \times 10^{-7}$ $m^2s^{-1}$ or more, and still more preferably $5.0 \times 10^{-7}$ $m^2s^{-1}$ or more.

The thermal diffusivity of the polyimide-containing portion can be adjusted by the design of the kind of a material of the filler, the particle diameter of the filler (a combination of particle diameters in a case where two or more kinds of fillers are contained), the thermal diffusivity of the filler, the content of the filler, the structure of polyimide, the thermal diffusivity of polyimide, the content of polyimide, or the like, for example, in a case where the polyimide-containing portion contains the filler.

«Filler»

The composition according to the embodiment of the present invention may contain a filler. In a case where a filler is contained, the filler preferably has thermal conductivity. The filler may have electrical insulating properties, may be a semiconductor, or may have electrical conductivity. The degree of electrical insulating properties and electrical conductivity is appropriately selected depending on the design and purpose. For example, in a case where filler has electrical insulating properties, the lower limit of the volume resistivity of the filler is preferably $1.0 \times 10^{11}$ Ω·cm or more, more preferably $5.0 \times 10^{11}$ Ω·cm or more, and particularly preferably $1.0 \times 10^{12}$ Ω·cm or more. In addition, the upper limit of the volume resistivity is not particularly limited; however, it is, for example, preferably $1.0 \times 10^{18}$ Ω·cm.

On the other hand, in a case of a semiconductor or an electrically conductive filler, the lower limit of the volume resistivity of the filler is not particularly limited; however, it is, for example, preferably $1.0 \times 10^{-7}$ Ω·cm or more. In addition, the upper limit of the volume resistivity is preferably less than $1.0 \times 10^{11}$ Ω·cm.

The thermal diffusivity of the filler is, for example, $1.0 \times 10^{-6}$ $m^2s^{-1}$ or more, preferably $2.0 \times 10^{-6}$ $m^2s^{-1}$ or more, and particularly preferably $5.0 \times 10^{-6}$ $m^2s^{-1}$ or more. In addition, the upper limit of the thermal diffusivity of the filler is not particularly limited; however, it is, for example, preferably $1.0 \times 10^{-4}$ $m^2s^{-1}$ or less.

The density of the filler is, for example, 4.0 g/cm$^3$ or less, and preferably 3.0 g/cm$^3$ or less. In addition, the lower limit of the density of the filler is not particularly limited; however, it is, for example, preferably 1.0 g/cm$^3$ or more. It is noted that in a case where the filler is one having voids or cavities such as porous or hollow particles, the density of the filler in the present specification means the density of the solid content of the components constituting the filler.

Preferably, the filler includes a material having electrical insulating properties. The filler material having electrical insulating properties is, for example, a ceramic having electrical insulating properties consisting of a nitrogen compound, an oxygen compound, a silicon compound, a boron compound, a carbon compound, and a composite compound thereof.

Examples of the nitrogen compound include boron nitride, aluminum nitride, and silicon nitride. Examples of the oxygen compound include metal oxides such as aluminum oxide (alumina), magnesium oxide (magnesia), zinc oxide, silicon oxide (silica), beryllium oxide, titanium oxide (titania), copper oxide, and cuprous oxide. Examples of the silicon compound and the carbon compound include silicon carbides. Examples of the boron compound include metal borides such as titanium boride. The other carbon compound is, for example, a carbon substrate material in which σ bond is dominant, such as diamond. Examples of the composite compound include mineral-based ceramics such as magnesite (magnesium carbonate), perovskite (calcium titanate), talc, mica, kaolin, bentonite, and pyrophyllite. In addition, the filler material having electrical insulating properties may be a metal hydroxide such as magnesium hydroxide or aluminum hydroxide.

Above all, from the viewpoint of thermal conductivity or the like, the filler material preferably contains at least one of a ceramic consisting of a nitrogen compound, a ceramic consisting of a metal oxide, or a metal hydroxide. The filler material preferably contains, for example, at least one of boron nitride, aluminum nitride, silicon nitride, aluminum oxide, magnesium oxide, zinc oxide, beryllium oxide, or aluminum hydroxide. Above all, the filler material is particularly preferably at least one of boron nitride, aluminum nitride, silicon nitride, aluminum oxide, magnesium oxide, zinc oxide, or beryllium oxide. It is noted that the boron nitride may have any structure such as c-BN (cubic crystal structure), w-BN (wurtzite structure), h-BN (hexagonal crystal structure), r-BN (rhombohedral crystal structure), or t-BN (turbulent layer structure). The boron nitride has a spherical shape or a scaly shape, and both spherical boron nitride and scaly boron nitride can be used.

Examples of the filler material having electrical conductivity include carbon substrate materials in which π bonds are dominant, such as black lead, carbon black, graphite, carbon fiber (pitch-based carbon fiber or PAN-based carbon fiber), carbon nanotube (CNT), and carbon nanofiber (CNF). In addition, such a filler material may be a metal such as silver, copper, iron, nickel, aluminum, or titanium, or an alloy such as stainless steel (SUS). Furthermore, an electrically conductive metal oxide such as zinc oxide doped with a different element, or an electrically conductive ceramic such as ferrite can also be used as such a filler material.

The filler may have a configuration in which a semiconductor or an electrically conductive, thermally conductive particle is coated or surface-treated with an electrically insulating material such as silica. According to such an aspect, it is easy to individually control the thermal conductivity and the electrical insulating properties, and thus it is easy to adjust the thermal conductivity and the electrical insulating properties. For example, a water glass method or a sol-gel method can be mentioned as a method for forming a silica film on the surface.

These fillers can be used alone or in combination of two or more thereof. In addition, with regard to the shape of the filler, it is possible to use fillers of a variety of shapes, examples of which include a fibrous shape, a plate shape, a scale shape, a rod shape, a spherical shape, a tube shape, a curved plate shape, and a needle shape.

The filler may be subjected to a surface treatment such as a silane coupling treatment, a titanate coupling treatment, an epoxy treatment, a urethane treatment, or an oxidation treatment. Examples of a surface treatment agent to be used for the surface treatment include polyol, aluminum oxide, aluminum hydroxide, silica (silicon oxide), hydrous silica, an alkanolamine, stearic acid, organosiloxane, zirconium oxide, hydrogen dimethicone, a silane coupling agent, and a titanate coupling agent. Of these, a silane coupling agent is preferable.

With regard to the size of the filler, the average primary particle diameter of the filler is preferably 0.01 to 30 μm. The lower limit of the average primary particle diameter of the filler is more preferably 0.05 μm or more, still more preferably 0.1 μm or more, and particularly preferably 0.5 μm or more. The upper limit of the average primary particle diameter of the filler is more preferably 20 μm or less, still more preferably 15 μm or less, and particularly preferably 10 μm or less. The "average primary particle diameter" of the filler can be obtained by observing the filler in a dispersion liquid with a transmission electron microscope (TEM) and observing a portion where the filler particles are not aggregated (primary particles). Specifically, a transmission electron micrograph of primary particles of the filler was taken using a transmission electron microscope, and then the micrograph is subjected to image processing using an image processing apparatus to measure the particle size distribution of the filler. Then, a number-based arithmetic average diameter calculated from the particle size distribution is adopted as the "average primary particle diameter" of the filler. For example, an electron microscope (H-7000, manufactured by Hitachi, Ltd.) is used as the transmission electron microscope, and LUZEX AP (manufactured by Nireco Corporation) is used as the image processing apparatus.

The filler may include a granular mixture in which at least two kinds of particle groups having different average primary particle diameters are mixed. The "average primary particle diameter" of a certain particle group is also obtained in the same manner as in a case of the "average primary particle diameter" of the filler. With such a configuration, small particles are embedded between large particles and as compared with a case where only single-diameter fillers are included, the spacing between the fillers is reduced and the number of contact points is increased, which results in improved thermal conductivity. For example, in a case where two kinds of particle groups having different average primary particle diameters are mixed, two peaks are observed in the particle size distribution of the filler containing these particle groups. Therefore, by confirming the number of peaks in the particle size distribution of the filler, it is possible to confirm how many kinds of particle groups having different average primary particle diameters are included in the granular mixture that is the filler.

In a case where there are a plurality of peaks in the particle size distribution of the filler, a peak particle diameter ratio (ratio of particle diameters corresponding to peak apexes) is preferably 1.5 to 50 between at least two peaks. The lower limit of the peak particle diameter ratio is preferably 2 or more and more preferably 4 or more. The upper limit of the peak particle diameter ratio is preferably 40 or less and more preferably 20 or less. In a case where the peak particle diameter ratio is in the above range, it becomes easy for the small-diameter fillers to occupy the space between the large-diameter fillers while suppressing the large-diameter fillers from becoming coarse particles. In addition, a peak intensity ratio of a large particle size peak to a small particle size peak is preferably 0.2 to 5.0 between at least two peaks. The lower limit of the peak intensity ratio is preferably 0.3 or more and more preferably 0.5 or more. The upper limit thereof is preferably 4.0 or less and more preferably 3.0 or less.

The filler has an aspect ratio of preferably 2 or more, more preferably 4 or more, and particularly preferably 5 or more. In addition, the upper limit of the aspect ratio is preferably 1000 or less, more preferably 500 or less, and particularly preferably 100 or less. The "aspect ratio" of the filler is a ratio of a minimum length to a maximum length (maximum length/minimum length) of a three-dimensional length.

In addition, an aspect in which two or more kinds of fillers having different materials are used as the filler is also one of the preferred aspects of the present invention.

Preferred examples thereof include a combination of boron nitride and aluminum oxide and a combination of aluminum nitride and aluminum oxide.

In addition, a combination of two or more kinds of fillers having the same material and different aspect ratios, or a combination of two or more kinds of fillers having different materials and different aspect ratios.is also preferable.

The content of the filler in the composition is preferably 1% by volume or more, more preferably 5% by volume or more, particularly preferably 10% by volume or more, and most preferably 20% by volume or more, with respect to the volume of the total solid content of the composition. In addition, from the viewpoint of workability by lithography, the content of the filler in the composition is more preferably 85% by volume or less, still more preferably 81% by volume or less, particularly preferably 75% by volume or less, and most preferably 60% by volume or less, with respect to the volume of the total solid content of the composition. In addition, the content of the filler in the composition is preferably 10% by mass or more and more preferably 30% by mass or more, with respect to the mass of the total solid content of the composition. From the viewpoint of workability by lithography, the upper limit of the content of the filler in the composition is preferably 90% by mass or less and particularly preferably 70% by mass or less. As described above, by considering the workability in addition to the thermal conductivity and the electrical insulating properties, the thermal conductive layer having high thermal conductivity and high electrical insulating properties can be formed at a desired position and in a desired pattern.

The proportion of the particle group having an average primary particle diameter of 0.5 to 15 μm in the filler is preferably 50% by mass or more and more preferably 80% by mass or more. The upper limit of this proportion may be 100% by mass or 99% by mass or less. From the viewpoint of workability by lithography, this percentage is preferably 99% by mass or less and more preferably 95% by mass or less.

As described above, the fillers may be used alone or in combination of two or more thereof, and in a case where two or more types of fillers are contained, the total amount thereof is preferably within the above range.

The polyimide-containing portion is preferably a member having insulating properties. The insulating properties (electric resistance) of the polyimide-containing portion are not particularly limited; however, the volume resistivity is preferably $1 \times 10^{15}$ Ω·cm or more and more preferably $1 \times 10^{16}$ Ω·cm or more. The upper limit thereof is not particularly limited; however, it is practically $1 \times 10^{19}$ Ω·cm or less. The dielectric breakdown voltage preferably 1 kV/mm or more and more preferably 10 kV/mm or more. The upper limit thereof is not particularly limited; however, it is practically 1,000 kV/mm or less. In the present specification, the measurement and the like of the volume resistivity and the dielectric breakdown voltage, and the like are in accordance with JIS C2151:2006 and JIS C2318:2007.

In addition, the glass transition temperature of the polyimide-containing portion is preferably 250°C or lower, more preferably 230°C or lower, and still more preferably 220°C or lower. The lower limit of the glass transition temperature is not particularly limited; however, it is preferably 120°C or higher.

A difference between a cyclization rate of a polyimide in the polyimide-containing precursor portion before the bonding step and a cyclization rate of a polyimide in a polyimide-containing portion formed at a bonded portion after the bonding step is 5% or more, and it is preferably 6% or more. In addition, an aspect in which the difference in the cyclization rate is 10% or more is also one of the preferred aspects of the present invention.

In the present invention, the cyclization rate of the polyimide is measured, for example, according to the following method.

The infrared absorption spectrum of polyimide is measured, and a peak intensity P1 in the vicinity of 1,370 $cm^{-1}$, which is the absorption peak derived from the imide structure, is obtained. Next, the polyimide is heat-treated at 350°C for 1 hour, and then the infrared absorption spectrum is measured again to obtain a peak intensity P2 in the vicinity of 1,370 $cm^{-1}$. Using the obtained peak intensities P1 and P2, the cyclization rate of the polyimide can be determined based on the following expression.

$$\text{Cyclization rate (\%)} = (\text{peak intensity P1}/\text{peak intensity P2}) \times 100$$

The cyclization rate of the polyimide in the polyimide-containing precursor portion before the bonding step is preferably 40% to 90%, more preferably 50% to 90%, and still more preferably 60% to 90%.

The cyclization rate of the polyimide in the polyimide-containing portion formed at the bonded portion after the bonding step is preferably 91% to 100%, more preferably 94% to 100%, and still more preferably 97% to 100%.

In a case where the substrate B includes the second polyimide-containing precursor portion, a difference between the cyclization rate of the polyimide in the second polyimide-containing precursor portion before the bonding step and the cyclization rate of the polyimide contained in the polyimide-containing portion formed at the bonded portion after the bonding step is preferably 5% or more and more preferably 6% or more. In addition, an aspect in which the difference in the cyclization rate is 10% or more is also one of the preferred aspects of the present invention.

In a case where the substrate B includes the second polyimide-containing precursor portion, the cyclization rate of the polyimide in the second polyimide-containing precursor portion before the bonding step is preferably 40% to 90%, more preferably 50% to 90%, and still more preferably 60% to 90%.

<Annealing step>

The annealing step is a heating step which may be incorporated after the bonding step (for example, bonding with a flip chip bonder).

The annealing step makes it possible to increase the peeling resistance force of the bonded portion.

The heating means is not particularly limited; however, for example, a heating equipment such as a hot plate or an oven can be used.

The heating temperature in the annealing step is preferably a temperature equal to or lower than the bonding temperature in the bonding step.

The heating temperature in the annealing step is preferably 180°C to 440°C, more preferably 200°C to 350°C, and still more preferably 210°C to 260°C.

In addition, the heating temperature in the annealing step may be determined in consideration of the bonding temperature in the bonding step and the heating temperature in the heating step.

A difference between the bonding temperature in the bonding step and the heating temperature in the annealing step (the bonding temperature in the bonding step - the heating temperature in the annealing step) is preferably 10°C or more. The upper limit thereof is not particularly limited; however, it is, for example, preferably 250°C or lower and more preferably 200°C or lower.

In a case where the above-described heating step is carried out, the heating temperature in the annealing step is preferably a temperature equal to or higher than the heating temperature (maximum heating temperature) in the above-described heating step.

A difference between the heating temperature in the annealing step and the heating temperature in the heating step (the heating temperature in the annealing step - the heating temperature in the heating step) is preferably 10°C or more, and more preferably 30°C or more. The upper limit thereof is not particularly limited; however, it is, for example, preferably 250°C or lower and more preferably 150°C or lower.

In addition, the heating time in the annealing step is preferably equal to or longer than the bonding time in the bonding step.

The heating time in the annealing step (the heating time at the above-described heating temperature) is preferably 1 hour or more. In addition, the upper limit of the heating time is not particularly limited; however, it is preferably 10 hours or less and more preferably 5 hours or less.

A difference between the heating time in the annealing step and the heating time in the bonding step (the heating time in the annealing step - the heating time in the bonding step) is preferably 30 minutes or more. In addition, the upper limit thereof is not particularly limited; however, it is preferably 10 hours or less and more preferably 5 hours or less.

The atmosphere during heating can be appropriately selected from those that can be provided by a heating equipment, such as atmospheres under Air, under $N_2$, and under vacuum.

The atmospheric pressure is not particularly limited; however, the heating is preferably carried out at 1 atm or lower and more preferably carried out at 1 atm ± 0.1 atm. The 1 atm refers to 101,325 Pa. The heating can be carried out, for example, under atmospheric pressure particularly without carrying out pressurization or reducing the pressure.

The imidization rate after the annealing step is, for example, preferably 98% or more. The upper limit thereof is not particularly limited, and it is, for example, preferably 100%.

[Other steps]

It is noted that in the manufacturing method for a bonded body according to the embodiment of the present invention, other steps may be allowed to be interposed between the steps specified above. In addition, although the example in which a surface of the substrate A and a surface of the substrate B are made to face each other and are bonded to each other has been mainly described as the bonding step. However, a form in which a plurality of the substrates B are disposed to be juxtaposed with the substrate A and bonded to the substrate A may be allowed. Alternatively, a form, in which the substrate A and the substrate B, having mutually appropriate thicknesses, are provided together and the side surfaces thereof are bonded to each other, is also included.

<Example of manufacturing method for bonded body>

Hereinafter, one example of the manufacturing method for a bonded body will be described with reference to the drawings.

Figs. 2A to 2C are step explanatory views schematically showing steps (partially) with cross-sectional views in a case where substrates are adhered by the manufacturing method for a bonded body according to the embodiment of the present invention. First, a substrate A (underlying substrate) 1 where an electronic circuit region 8 is disposed on a silicon wafer 1x and an electrode 31 (wiring line terminal A) is attached to the electronic circuit region 8 is prepared (Fig. 2A). An electronic circuit 81 composed of a conductor or a semiconductor is already formed inside the electronic circuit region 8 of the substrate A1. A method of forming an electronic circuit is not particularly limited, and the electronic circuit can be formed according to a conventional method. In addition, the structure or members of the electronic circuit are not particularly limited, and examples thereof include transistors or a wiring structure in which the transistors are conductively conducted to electrodes.

A resin composition is applied onto a surface (a surface having the electronic circuit region) P0 of the substrate A1, on which electrodes are disposed, whereby a member (a resin composition layer) 4 consisting of the resin composition is formed (Fig. 2B). In this state, the resin composition layer may be heated and dried (drying step). In addition, after drying, the resin composition layer 4 may be patterned by photolithography, ion sputtering, or the like.

Then, in the present embodiment, the resin composition layer 4 is heated to promote cyclization, thereby obtaining a polyimide-containing precursor portion 41 in which the polyimide precursor has been subjected to partial cyclization (curing) (Fig. 2C). As a result, a polyimide-containing precursor portion arranged substrate 1y, in which the polyimide-containing precursor portion 41 is disposed on the substrate A1, is formed. As in this example, the polyimide-containing precursor portion 41 may shrink due to the curing, as compared with the resin composition layer 4. Although the magnitude of shrinkage is slightly exaggerated in the drawings, the shrinkage rate is not particularly limited, where a smaller shrinkage rate may be allowed, or shrinkage may not occur due to curing.

In addition, although the substrate A shown in the drawing has only the electrode 31 as the wiring line terminal A, a conduction path may be formed on the electrode 31. The conduction path may be formed on the substrate A from the beginning, or the polyimide-containing precursor portion may be patterned before being cured to prepare a conduction path on the patterned portion by plating or the like.

In the polyimide-containing precursor portion arranged substrate 1y according to the present embodiment, the heights h1 and h2 of the electrodes 31 vary. In addition, a surface 4a of the polyimide-containing precursor portion is also wavy and is not in a flat state. In the present embodiment, by carrying out the flattening, such a variation in the height of the electrode 31 is eliminated, the distal end surface of the electrode 31 is exposed, and the surface of the polyimide-containing precursor portion is also flattened.

It is considered that the adhesiveness of the substrate is improved by carrying out the flattening in this way.

In addition, it is considered that the bondability between the wiring line terminals is improved even in a case where the conduction path is not formed.

Fig. 3A to Fig. 3C each shows a polyimide-containing precursor portion arranged substrate (laminate) 1z after the flattening. A distal end 31a of the electrode 31 is exposed on a surface 4b of the polyimide-containing precursor portion, where the entire surface 4b of the polyimide-containing precursor portion is flattened.

Fig. 3A shows an example of an aspect in which the height of the electrode 31 and the height of the surface 4b of the polyimide-containing precursor are the same height, Fig. 3B shows an example of an aspect in which the height of the surface 4b of the polyimide-containing precursor is lower than the height of the electrode 31, and Fig. 3C shows an example of an aspect in which the height of the surface 4b of the polyimide-containing precursor is higher than the height of the electrode 31.

The substrate B is separately prepared for the laminate (the flattened polyimide-containing precursor portion arranged substrate) 1z (Fig. 4A). A substrate B2 includes a silicon wafer 2x having a through-hole electrode 2y, a circuit wiring region 8 having a circuit wiring 81 disposed on the silicon wafer 2x, and an electrode 32 (wiring line terminal B) formed in the circuit wiring region 8.

In the present embodiment, a second polyimide-containing precursor portion 42 is also formed on a surface of the substrate B, which has the wiring line terminal B, where the surface as a surface 2a is flattened in the same manner as the surface of the polyimide-containing precursor portion 41 on the substrate A. The formation and the flattening of the second polyimide-containing precursor portion 42 can be carried out according to the same method as the method of forming and flattening the polyimide-containing precursor portion 41.

Since both the surfaces of the polyimide-containing precursor portion 41 and the electrode 31 on the substrate A and the surfaces of the second polyimide-containing precursor portion 42 and the electrode 32 on the substrate B are flattened in this manner, the electrical connectivity is improved even in a case where there is no conduction path as in the embodiment described here.

In this case, alignment (registration) is carried out so that the portion of the electrode 31 of the laminate and the electrode 32 provided on the substrate B2 are in contact with each other.

Here, in a case where at least one of the polyimide-containing precursor portion 41 or the second polyimide-containing precursor portion 42 contains a migration suppressing agent, it is possible to suppress the migration of the metal from the electrode 31 (the electrode 32) to the polyimide-containing precursor portion 41 (the second polyimide-containing precursor portion 42) even in a case where misregistration occurs in the alignment, which makes it possible to improve the withstand voltage performance.

In the wiring line terminal B as well, a conduction path may be formed on the electrode 32. The conduction path may be formed on the substrate B from the beginning, or the second polyimide-containing precursor portion may be patterned before being cured to prepare a conduction path on the patterned portion by plating or the like.

Next, in the present embodiment, the aligned substrate B2 and laminate 1z are allowed to touch each other and bonded at a bonding surface P1 with the polyimide-containing precursor portion 41 and the second polyimide-containing precursor portion 42 being interposed therebetween (Fig. 4B).

As a result, a bonded body 100 in which the two substrates are bonded is formed. In the bonded body 100, the electrode 31 and the electrode 32 are electrically bonded (the bonding step).

At the same time, the polyimide-containing precursor portion 41 is softened by heating, and the surface 4b of the polyimide-containing precursor portion of the laminate 1z and the surface (the surface of the flattened second polyimide-containing precursor portion 42) 2a of the substrate B are adhered to each other to form the bonded body 100. In the bonded body 100, a polyimide-containing portion 51 is formed from the polyimide-containing precursor portion 41 and the second polyimide-containing precursor portion 42. The polyimide contained in the polyimide-containing portion is subjected to further cyclization due to the heating during the bonding. Therefore, a difference between a cyclization rate of a polyimide in the polyimide-containing precursor portion 41 before the bonding step and a cyclization rate of a polyimide in the polyimide-containing portion 51 formed at the bonded portion after the bonding step is 5% or more.

This makes it possible to carry out electrical connection between the substrate A and the substrate B and also to realize a state in which the substrate A and the substrate B are firmly fixed by the above-described anchor effect.

In a preferred embodiment according to the present invention, the surface 4b of the polyimide-containing precursor portion of the laminate 1z and the surface 2a of the second polyimide-containing precursor portion have high flatness, and thus it is possible to obtain a dense and accurate touch state between the laminate 1z and the substrate B2 on a touch surface. The realization of a denser and more accurate touch state makes it possible to effectively suppress voids that tend to be generated in the touch surface.

(Bonded body)

The bonded body according to the embodiment of the present invention is a bonded body obtained by the manufacturing method for a bonded body according to the embodiment of the present invention.

The bonded body according to the embodiment of the present invention can be suitably used for a use application such as a device or the like according to an embodiment of the present invention described later.

(Manufacturing method for laminate)

A manufacturing method for a laminate according to the embodiment of the present invention includes a step of preparing a substrate C having two or more surfaces on which a wiring line terminal is provided, a step of preparing a plurality of substrates D each having a surface on which a wiring line terminal is provided, a polyimide-containing precursor portion forming step of forming a polyimide-containing precursor portion on the surface of at least one of the substrate C or the substrate D, where the wiring line terminal is provided on the at least one of the substrate C or the substrate D, and a bonding step of bonding the surface of the substrate D, where the wiring line terminal is provided, to each of at least two surfaces of the substrate C, where the wiring line terminal is provided, in which the polyimide-containing precursor portion is present in all bonded portions in the bonding step, and in at least one bonded portion, a difference between a cyclization rate of a polyimide in the polyimide-containing precursor portion before the bonding

step, where the polyimide-containing precursor portion is bonded in the bonded portion, and a cyclization rate of a polyimide in a polyimide-containing portion formed at the bonded portion after the bonding step is 5% or more.

<Step of preparing substrate C>

The manufacturing method for a bonded body according to the embodiment of the present invention includes a step of preparing a substrate C having two or more surfaces on which a wiring line terminal is provided.

In the step of preparing the substrate C, the substrate C may be manufactured according to a publicly known method or may be obtained by means such as a purchase.

As the material that is used for the substrate C in the manufacturing method for a laminate according to the embodiment of the present invention and as the wiring line terminal that is included in the substrate C, the same material as the material and the same wiring line terminal as the wiring line terminal A, which are used for the substrate A described above, can be used, and the same applies to the preferred aspects thereof.

In addition, the substrate C may be a wafer or may be a chip, where a preferred aspect thereof is also the same as that of the substrate A.

<Step of preparing substrate D>

In the step of preparing the substrate D, the substrate D may be manufactured according to a publicly known method or may be obtained by means such as a purchase.

As the substrate D in the manufacturing method for a laminate according to the embodiment of the present invention, the same substrate as the substrate B described above can be used, and the same applies to the preferred aspect thereof.

In addition, the substrate D may be a wafer or may be a chip, where a preferred aspect thereof is also the same as that of the substrate B.

<Polyimide-containing precursor portion forming step>

In the polyimide-containing precursor portion forming step, the polyimide-containing precursor portion is formed on a surface of at least one of the substrate C or the substrate D.

Here, in a case where two substrates D (temporarily referred to as a substrate D1 and a substrate D2) are bonded to the substrate C, the polyimide-containing precursor portion may be formed on two surfaces of the substrate C, to which the substrate D1 and the substrate D2 are bonded, the polyimide-containing precursor portion may be formed on a surface of the substrate C, to which the substrate D1 is bonded and a surface of the substrate D2, on which the wiring line terminal provided, the polyimide-containing precursor portion may be formed on surfaces of the substrate D1 and the substrate D2, where the wiring line terminal is provided, or the polyimide-containing precursor portion may be formed on all of surfaces of the substrate C, the substrate D1, and the substrate D2, where the wiring line terminal is provided.

A preferred aspect of a method of forming the polyimide-containing precursor portion is the same as the preferred aspect of the forming method in the polyimide-containing precursor portion forming step in the above-described manufacturing method for a bonded body according to the embodiment of the present invention.

<Bonding step>

A bonding step of bonding the surface of the substrate D, where the wiring line terminal is provided, to each of at least two surfaces of the substrate C, where the wiring line terminal is provided, is included, where the polyimide-containing precursor portion is present in all bonded portions in the bonding step, and in at least one bonded portion, a difference between a cyclization rate of a polyimide in the polyimide-containing precursor portion before the bonding step, where the polyimide-containing precursor portion is bonded in the bonded portion, and a cyclization rate of a polyimide in a polyimide-containing portion formed at the bonded portion after the bonding step is 5% or more.

Here, in a case where two substrates D (temporarily referred to as a substrate D1 and a substrate D2) are bonded to the substrate C, the bonding step may be divided into two steps such that the substrate D1 is bonded to the substrate C and then the substrate D2 is bonded to the substrate C, or the bonding step may be carried out at one time.

In addition, another substrate may be further bonded to a surface of the substrate D, to which the substrate C has not been bonded. Regarding this bonding as well, the bonding step may be dividedly carried out or may be carried out at one time.

The difference in the cyclization rate is 5% or more, and it is preferably 6% or more. In addition, an aspect in which the difference in the cyclization rate is 10% or more is also one of the preferred aspects of the present invention.

In addition, from the viewpoint of adhesiveness, the difference in the cyclization rate in all the bonded portions is preferably 5% or more and more preferably 6% or more. In addition, an aspect in which the difference in the cyclization rate is 10% or more is also one of the preferred aspects of the present invention.
The cyclization rate of the polyimide in the polyimide-containing precursor portion before the bonding step is preferably 40% to 90%, more preferably 50% to 90%, and still more preferably 60% to 90%.
The cyclization rate of the polyimide in the polyimide-containing portion formed at the bonded portion after the bonding step is preferably 91% to 100%, more preferably 94% to 100%, and still more preferably 97% to 100%.

<Annealing step>

The manufacturing method for a laminate according to the embodiment of the present invention may further include an annealing step after the bonding step.
The details of the annealing step are the same as the details of the annealing step in the manufacturing method for a bonded body according to the embodiment of the present invention.

[Other steps]

It is noted that in the manufacturing method for a bonded body according to the embodiment of the present invention, other steps may be allowed to be interposed between the steps specified above.

(Laminate)

The laminate according to the embodiment of the present invention is a laminate obtained by the manufacturing method for a laminate according to the embodiment of the present invention.
The laminate according to the embodiment of the present invention can be suitably used for a use application such as a device or the like according to an embodiment of the present invention described later.

(Device and manufacturing method thereof)

A device according to an embodiment of the present invention includes the bonded body according to the embodiment of the present invention or the laminate according to the embodiment of the present invention.
A manufacturing method for a device according to the embodiment of the present invention includes the manufacturing method for a bonded body according to the embodiment of the present invention or the manufacturing method for a laminate according to the embodiment of the present invention.
The device according to the embodiment of the present invention includes a semiconductor device, an electronic device, or the like, and it is preferably a semiconductor device or an electronic device.
Examples of the device include each of the devices described in "All of Most Advanced Semiconductor Package Technologies", edited by Society of Semiconductor New Technology Research, Kogyo Chosakai Publishing Co., Ltd., 8-19, 110-114, and 160-165, and "All of Surface Treatment Technologies with Illustrations", edited by Surface Optical Research Laboratory, Kanto University, Kogyo Chosakai Publishing Co., Ltd., pp. 32-41 and 56-59.
Specific examples thereof include an aspect in which the above-described polyimide-containing portion is used as an adhesive film to replace an underfill between chips, and an aspect in which the above-described polyimide-containing portion is used as a die bonding film for fixing a chip.
In addition, the manufacturing method for a bonded body and the manufacturing method for a laminate according to the embodiments of the present invention can be applied to a wide variety of applications such as mounting of a light emitting diode (LED) element, mounting of an optical element of a flat panel display, and mounting of a power semiconductor package.
In addition, the manufacturing method for a bonded body and the manufacturing method for a laminate according to the embodiments of the present invention can be also suitably used, for example, for three-dimensional mounting of a semiconductor element equipped with a through-electrode (TSV: through silicon via).
Fig. 5 is a cross-sectional view schematically showing a three-dimensional mounted device. In the present embodiment, a laminate 101 in which a plurality of semiconductor elements (semiconductor chips) 101a to 101d are laminated is disposed on a wiring board 120. Each of a plurality of the semiconductor elements 101a to 101d consists of a semiconductor wafer such as a silicon substrate. The laminate 101 has a structure in which the semiconductor element 101a having no through-electrode and the semiconductor elements 101b to 101d having through-electrodes 102b to 102d are connected using the flip chip connection. Connection pads on the side of the semiconductor element having the through-electrodes are connected by metal bumps 103a, 103b, and 103c, such as solder bumps or the like. A resin layer 110 is formed in gaps between the semiconductor elements 101a to 101d. As a manufacturing method for

this laminate, the manufacturing method for a bonded body according to the embodiment of the present invention can be used. That is, for example, at least one (preferably all) of the resin layers 110 can be made into the polyimide-containing portion in the above-described manufacturing method for a bonded body according to the embodiment of the present invention or the above-described manufacturing method for a laminate according to the embodiment of the present invention. A surface electrode 120a is provided on one surface of the wiring board 120. An insulating layer 115 on which a re-distribution layer 105 is formed is disposed between the wiring board 120 and the laminate (the substrate/substrate laminate) 101. One end of the re-distribution layer 105 is connected to an electrode pad formed on a surface of the semiconductor element 101d on the re-distribution layer 105 side, with a metal bump 103d such as a solder bump being interposed therebetween. In addition, the other end of the re-distribution layer 105 is connected to the surface electrode 120a of the wiring board with a metal bump 103e such as a solder bump being interposed therebetween. A resin layer 110a is formed between the insulating layer 115 and the laminate 101. For the bonding of the insulating layer 115 and the laminate 101 as well, it is possible to use the manufacturing method for a bonded body according to the embodiment of the present invention or the manufacturing method for a laminate according to the embodiment of the present invention. That is, for example, the resin layer 110a can be made into the above-described polyimide-containing portion. In addition, a resin layer 110b is formed between the insulating layer 115 and the wiring board 120. For the bonding of the insulating layer 115 and the wiring board 120 as well, it is possible to use the manufacturing method for a bonded body according to the embodiment of the present invention or the manufacturing method for a laminate according to the embodiment of the present invention. That is, for example, the resin layer 110b can be made into the above-described polyimide-containing portion.

(Composition for forming polyimide-containing precursor portion)

The composition for forming a polyimide-containing precursor portion according to the embodiment of the present invention is a composition for forming a polyimide-containing precursor portion, which is used in a manufacturing method for a bonded body, the manufacturing method including, a step of preparing a substrate A having a surface on which a wiring line terminal is provided, a polyimide-containing precursor portion forming step of forming a polyimide-containing precursor portion on the surface of the substrate A, where a wiring line terminal is provided on the surface of the substrate A, a step of preparing a substrate B having a surface on which a wiring line terminal is provided, and a bonding step of bonding the surface of the substrate A, where the polyimide-containing precursor portion is provided on the surface of the substrate A, to the surface of the substrate B, where the wiring line terminal is provided, in which the polyimide-containing precursor portion is a member formed from the composition for forming a polyimide-containing precursor portion, and a difference between a cyclization rate of a polyimide in the polyimide-containing precursor portion before the bonding step and a cyclization rate of a polyimide in a polyimide-containing portion formed at a bonded portion after the bonding step is 5% or more.

Here, the manufacturing method for a bonded body has the same meaning as the above-described manufacturing method for a bonded body according to the embodiment of the present invention, and the same applies to the preferred aspect thereof.

In addition, the composition for forming a polyimide-containing precursor portion according to the embodiment of the present invention has the same meaning as the composition for forming a polyimide-containing precursor portion, which is used for forming a polyimide-containing precursor portion in the above-described manufacturing method for a bonded body according to the embodiment of the present invention or the above-described manufacturing method for a laminate according to the embodiment of the present invention, and the same applies to the preferred aspect thereof.

In the use application of the composition, a difference between a cyclization rate of a polyimide in the polyimide-containing precursor portion before the bonding step and a cyclization rate of a polyimide in a polyimide-containing portion formed at a bonded portion after the bonding step is 5% or more, and it is preferably 6% or more. In addition, an aspect in which the difference in the cyclization rate is 10% or more is also one of the preferred aspects of the present invention.

The cyclization rate of the polyimide in the polyimide-containing precursor portion before the bonding step is preferably 40% to 90%, more preferably 50% to 90%, and still more preferably 60% to 90%.

In the use application of the composition, the cyclization rate of the polyimide in the polyimide-containing portion formed at the bonded portion after the bonding step is preferably 91% to 100%, more preferably 94% to 100%, and still more preferably 97% to 100%.

Hereinafter, the details of each component contained in the composition (the resin composition) for forming a polyimide-containing precursor portion according to the embodiment of the present invention will be described.

The composition for forming a polyimide-containing precursor portion according to the embodiment of the present invention preferably contains a polyimide precursor and a solvent.

In addition, the composition for forming a polyimide-containing precursor portion according to the embodiment of the present invention preferably further contains a photosensitive compound. Examples of the photosensitive compound include a photopolymerization initiator and a photoacid generator, where a photopolymerization initiator is preferable.

<Specific resin>

The resin composition according to the embodiment of the present invention preferably contains at least one resin (a specific resin) selected from the group consisting of a polyimide and a polyimide precursor, and it more preferably contains a polyimide precursor.

In addition, the specific resin preferably has a polymerizable group and more preferably contains a radically polymerizable group.

In a case where the specific resin has a radically polymerizable group, the resin composition according to the embodiment of the present invention preferably contains a radical polymerization initiator described later, and it more preferably contains a radical polymerization initiator described later and a radical crosslinking agent described later. Further, a sensitizing agent described later can be contained as necessary. From such a resin composition according to the embodiment of the present invention, for example, a negative tone photosensitive film is formed.

In addition, the specific resin may have a polarity converting group such as an acid-decomposable group.

In a case where the specific resin has an acid-decomposable group, it is preferable that the resin composition according to the embodiment of the present invention contains a photoacid generator described later. From such a resin composition according to the embodiment of the present invention, for example, a positive tone photosensitive film or a negative tone photosensitive film, which is a chemical amplification type photosensitive film, is formed.

[Polyimide precursor]

The kind or the like of the polyimide precursor that is used in the present invention is not particularly specified; however, it is preferable that the polyimide precursor contains a repeating unit represented by Formula (2).

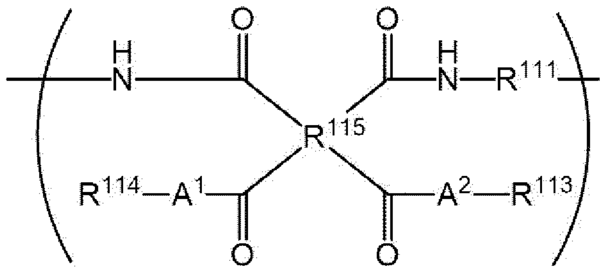

(2)

In Formula (2), $A^1$ and $A^2$ each independently represent an oxygen atom or -NH-, $R^{111}$ represents a divalent organic group, $R^{115}$ represents a tetravalent organic group, and $R^{113}$ and $R^{114}$ each independently represent a hydrogen atom or a monovalent organic group.

$A^1$ and $A^2$ in Formula (2) each independently represent an oxygen atom or -NH-, and an oxygen atom is preferable.

$R^{111}$ in Formula (2) represents a divalent organic group. Examples of the divalent organic group include a group having a linear or branched aliphatic group, a cyclic aliphatic group, or an aromatic group. A linear or branched aliphatic group having 2 to 20 carbon atoms, a cyclic aliphatic group having 3 to 20 carbon atoms, an aromatic group having 3 to 20 carbon atoms, or a group consisting of a combination of these groups is preferable, and a group containing an aromatic group having 6 to 20 carbon atoms is more preferable. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of the preferred embodiment according to the present invention include groups respectively represented by -Ar- and -Ar-L-Ar-, and where a group represented by -Ar-L-Ar- is particularly preferable. However, Ar's are each independently an aromatic group, and L is a single bond or an aliphatic hydrocarbon group having 1 to 10 carbon atoms, which may be substituted with a fluorine atom, -O-, -CO-, -S-, $-SO_2-$, or -NHCO-, or a group consisting of a combination of two or more of the above. The preferred ranges thereof are as described above.

$R^{111}$ is preferably derived from a diamine. Examples of the diamine that is used for producing the polyimide precursor include a linear aliphatic or branched aliphatic diamine, a cyclic aliphatic diamine, or an aromatic diamine. One kind of diamine may be used alone, or two or more kinds thereof may be used.

Specifically, the diamine is preferably a diamine containing a linear or branched aliphatic group having 2 to 20 carbon atoms, a cyclic aliphatic group having 3 to 20 carbon atoms, an aromatic group having 3 to 20 carbon atoms, or

a group consisting of a combination thereof, and more preferably a diamine containing an aromatic group having 6 to 20 carbon atoms. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of the group containing an aromatic group include the following groups.

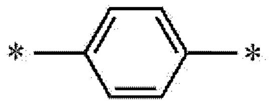
AR-1

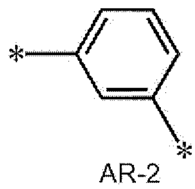
AR-2

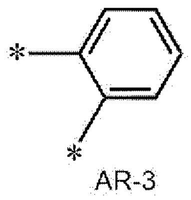
AR-3

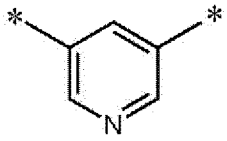
AR-4

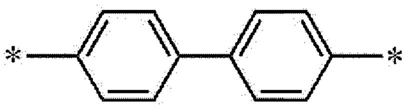
AR-5

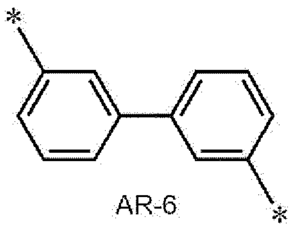
AR-6

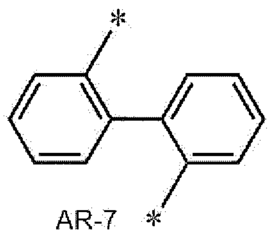
AR-7

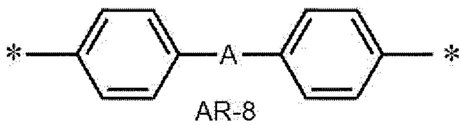
AR-8

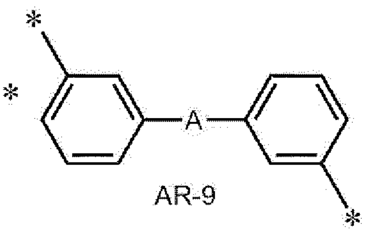
AR-9

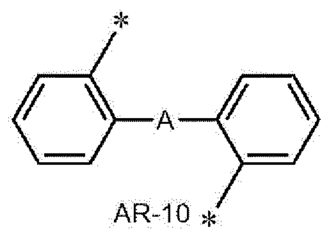
AR-10

In the formulae, A represents a single bond or a divalent linking group. It is preferably a single bond, or an aliphatic hydrocarbon group having 1 to 10 carbon atoms, which may be substituted with a fluorine atom, -O-, -C(=O)-, -S-, $-SO_2-$, -NHCO-, or a group selected from combinations thereof, more preferably a single bond or a group selected from an alkylene group having 1 to 3 carbon atoms, which may be substituted with a fluorine atom, -O-, -C(=O)-, -S-, or $-SO_2-$, and still more preferably $-CH_2-$, -O-, -S-, $-SO_2-$, $-C(CF_3)_2-$, or $-C(CH_3)_2-$.

In the formulae, * represents a bonding site to another structure.

Specific examples of the diamine include at least one diamine selected from 1,2-diaminoethane, 1,2-diaminopropane, 1,3-diaminopropane, 1,4-diaminobutane, or 1,6-diaminohexane; 1,2- or 1,3-diaminocyclopentane, 1,2-, 1,3-, or 1,4-diaminocyclohexane, 1,2-, 1,3-, or 1,4-bis(aminomethyl)cyclohexane, bis-(4-aminocyclohexyl)methane, bis-(3-aminocyclohexyl)methane, 4,4'-diamino-3,3'-dimethylcyclohexylmethane, or isophorone diamine; m- or p-phenylene diamine, diaminotoluene, 4,4'- or 3,3'-diaminobiphenyl, 4,4'-diaminodiphenyl ether, 3,3-diaminodiphenyl ether, 4,4'- or 3,3'-diaminodiphenylmethane, 4,4'-or 3,3'-diaminodiphenyl sulfone, 4,4'- or 3,3'-diaminodiphenyl sulfide, 4,4'- or 3,3'-diaminobenzophenone, 3,3'-dimethyl-4,4'-diaminobiphenyl, 2,2'-dimethyl-4,4'-diaminobiphenyl, 3,3'-dimethoxy-4,4'-diaminobiphenyl, 2,2-bis(4-aminophenyl)propane, 2,2-bis(4-aminophenyl)hexafluoropropane, 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, bis(3-amino-4-hydroxyphenyl)sulfone, bis(4-amino-3-hydroxyphenyl)sulfone, 4,4'-diaminoparaterphenyl, 4,4-bis(4-aminophenoxy)biphenyl, bis[4-(4-aminophenoxy)phenyl]sulfone, bis[4-(3-aminophenoxy)phenyl]sulfone, bis[4-(2-aminophenoxy)phenyl]sulfone, 1,4-bis(4-aminophenoxy)benzene, 9,10-bis(4-aminophenyl)anthracene, 3,3'-dimethyl-4,4'-diaminodiphenyl sulfone, 1,3-bis(4-aminophenoxy)benzene, 1,3-bis(3-aminophenoxy)benzene, 1,3-bis(4-aminophenyl)benzene, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy)phenyl]propane, 2,2-bis[4-(4-aminophenoxy)phenyl]hexafluoropropane, 9,9-bis(4-aminophenyl)-10-hydroanthracene, 3,3',4,4'-tetraaminobiphenyl, 3,3',4,4'-tetraaminodiphenyl ether, 1,4-diaminoanthraquinone, 1,5-diaminoanthraquinone, 3,3-dihydroxy-4,4'-diaminobiphenyl, 9,9'-bis(4-aminophenyl)fluorene, 4,4'-dimethyl-3,3'-diaminodiphenyl sulfone, 3,3',5,5'-tetramethyl-4,4'-diaminodiphenylmethane, 2,4- or, 2,5-diaminocumene, 2,5-dimethyl-p-phenylene diamine, acetoguanamine, 2,3,5,6-tetramethyl-p-phenylene diamine, 2,4,6-trimethyl-m-phenylene diamine, bis(3-aminopropyl)tetramethyl disiloxane, bis(p-aminophenyl)octamethylpentasiloxane, 2,7-diaminofluorene, 2,5-diaminopyridine, 1,2-bis(4-aminophenyl)ethane, diaminobenzanilide, esters of diaminobenzoic acid, 1,5-diaminonaphthalene, diaminobenzotrifluoride, 1,3-bis(4-aminophenyl)hexafluoropropane, 1,4-bis(4-aminophenyl)octafluorobutane, 1,5-bis(4-aminophenyl)decafluoropentane, 1,7-bis(4-aminophenyl)tetradecafluoroheptane, 2,2-bis[4-(3-aminophenoxy)phenyl]hexafluoropropane, 2,2-bis[4-(2-aminophenoxy)phenyl]hexafluoropropane, 2,2-bis[4-(4-aminophenoxy)-3,5-dimethylphenyl]hexafluoropropane, 2,2-bis[4-(4-aminophenoxy)-3,5-bis(trifluoromethyl)phenyl]hexafluoropropane, p-bis(4-amino-2-trifluoromethylphenoxy)benzene, 4,4'-bis(4-amino-2-trifluoromethylphenoxy)biphenyl, 4,4'-bis(4-amino-3-trifluoromethylphenoxy)biphenyl, 4,4'-bis(4-amino-2-trifluoromethylphenoxy)diphenyl sulfone, 4,4'-bis(3-amino-5-trifluoromethylphenoxy)diphenyl sulfone, 2,2-bis[4-(4-amino-3-trifluoromethylphenoxy)phenyl]hexafluoropropane, 3,3',5,5'-tetramethyl-4,4'-diaminobiphenyl, 4,4'-diamino-2,2'-bis(trifluoromethyl)biphenyl, 2,2',5,5',6,6'-hexafluorotolidine, or 4,4'-diaminoquaterphenyl.

In addition, the diamines (DA-1) to (DA-18) described in paragraphs 0030 to 0031 of WO2017/038598A are also preferable.

In addition, the diamine having two or more alkylene glycol units in the main chain, described in paragraphs 0032 to 0034 of WO2017/038598A, is also preferably used.

$R^{111}$ is preferably represented by -Ar-L-Ar- from the viewpoint of the flexibility of the organic film to be obtained. However, Ar's are each independently an aromatic group, and L is an aliphatic hydrocarbon group having 1 to 10 carbon atoms, which may be substituted with a fluorine atom, -O-, -CO-, -S-, $-SO_2-$, or -NHCO-, or a group consisting of a combination of two or more of the above. Ar is preferably a phenylene group, and L is preferably an aliphatic hydrocarbon group having 1 or 2 carbon atoms, which may be substituted with a fluorine atom, -O-, -CO-, -S-, or $-SO_2-$. The aliphatic hydrocarbon group here is preferably an alkylene group.

In addition, from the viewpoint of the i-line transmittance, $R^{111}$ is preferably a divalent organic group represented by Formula (51) or Formula (61) below. In particular, from the viewpoint of the i-line transmittance and ease of availability, a divalent organic group represented by Formula (61) is more preferable.

Formula (51)

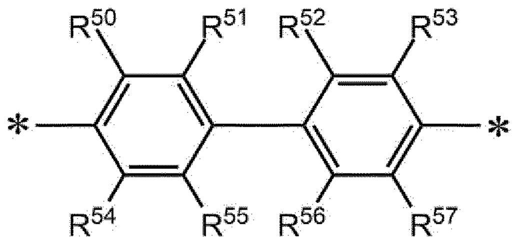

(51)

In Formula (51), $R^{50}$ to $R^{57}$ each independently represent a hydrogen atom, a fluorine atom, or a monovalent organic group, and at least one of $R^{50}$, ..., or $R^{57}$ represents a fluorine atom, a methyl group, or a trifluoromethyl group, and *'s each independently represent a bonding site to the nitrogen atom in Formula (2).

Examples of the monovalent organic group as $R^{50}$ to $R^{57}$ include an unsubstituted alkyl group having 1 to 10 (preferably 1 to 6 carbon atoms) carbon atoms and a fluorinated alkyl group having 1 to 10 (preferably 1 to 6 carbon atoms) carbon atoms.

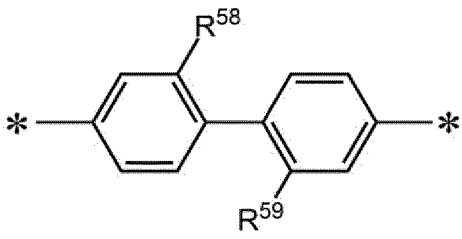

(61)

In Formula (61), $R^{58}$ and $R^{59}$ each independently represent a fluorine atom, a methyl group, or a trifluoromethyl group, and *'s each independently represent a bonding site to the nitrogen atom in Formula (2).

Examples of the diamine that provides a structure of Formula (51) or Formula (61), 2,2'-dimethylbenzidine, 2,2'-bis(trifluoromethyl)-4,4'-diaminobiphenyl, and 2,2'-bis(fluoro)-4,4'-diaminobiphenyl, 4,4'-diaminooctafluorobiphenyl. These may be used alone or in a combination of two or more thereof.

$R^{115}$ in Formula (2) represents a tetravalent organic group. The tetravalent organic group is preferably a tetravalent organic group containing an aromatic ring and more preferably a group represented by Formula (5) or Formula (6).

In Formula (5) or Formula (6), *'s each independently represent a bonding site to another structure.

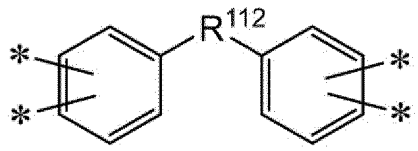 (5) 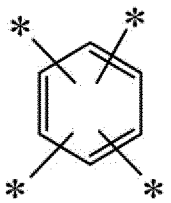 (6)

In Formula (5), $R^{112}$ is a single bond or a divalent linking group. It is preferably a single bond or a group selected from an aliphatic hydrocarbon group having 1 to 10 carbon atoms, which may be substituted with a fluorine atom, -O-, -CO-, -S-, $-SO_2-$, -NHCO-, or a combination thereof, more preferably a single bond or a group selected from an alkylene group having 1 to 3 carbon atoms, which may be substituted with a fluorine atom, -O-, -CO-, -S-, or - $SO_2$-, and still more preferably a divalent group selected from the group consisting of $-CH_2-$, - $C(CF_3)_2$-, $-C(CH_3)_2-$, -O-, -CO-, -S-, and $-SO_2-$.

Specific examples of $R^{115}$ include a tetracarboxylic acid residue that remains after the removal of the anhydride group from the tetracarboxylic acid dianhydride. The polyimide precursor may contain only one kind of tetracarboxylic acid dianhydride residue or may contain two or more kinds thereof, as a structure corresponding to $R^{115}$.

The tetracarboxylic acid dianhydride is preferably represented by Formula (O).

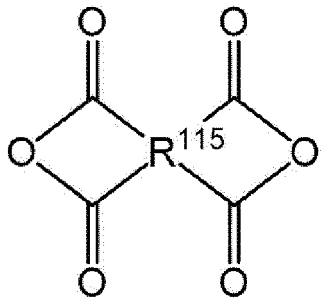 (O)

In Formula (O), $R^{115}$ represents a tetravalent organic group. $R^{115}$ has the same meaning as $R^{115}$ in Formula (2), and the same applies to the preferred range thereof.

Specific examples of the tetracarboxylic acid dianhydride include pyromellitic acid dianhydride (PMDA), 3,3',4,4'-biphenyltetracarboxylic acid dianhydride, 3,3',4,4'-diphenylsulfide tetracarboxylic acid dianhydride, 3,3',4,4'-diphenylsulfone tetracarboxylic acid dianhydride, 3,3',4,4'-benzophenone tetracarboxylic acid dianhydride, 3,3',4,4'-diphenylmethane tetracarboxylic acid dianhydride, 2,2',3,3'-diphenylmethane tetracarboxylic acid dianhydride, 2,3,3',4'-biphenyltetracarboxylic acid dianhydride, 2,3,3',4'-benzophenone tetracarboxylic acid dianhydride, 4,4'-oxydiphthalic acid dianhydride, 2,3,6,7-naphthalene tetracarboxylic acid dianhydride, 1,4,5,7-naphthalene tetracarboxylic acid dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl) hexafluoropropane dianhydride, 1,3-diphenylhexafluoropropane-3,3,4,4-tetracarboxylic acid dianhydride, 1,4,5,6-naphthalene tetracarboxylic acid dianhydride, 2,2',3,3'-diphenyl tetracarboxylic acid dianhydride, 3,4,9,10-perylene tetracarboxylic acid dianhydride, 1,2,4,5-naphthalene tetracarboxylic acid dianhydride, 1,4,5,8-naphthalene tetracarboxylic acid dianhydride, 1,8,9,10-phenanthrene tetracarboxylic acid dianhydride, 1,1-bis(2,3-dicarboxyphenyl)ethane dianhydride, 1,1-bis(3,4-dicarboxyphenyl)ethane dianhydride, 1,2,3,4-benzene tetracarboxylic acid dianhydride, and alkyl derivatives having 1 to 6 carbon atoms thereof as well as alkoxy derivatives having 1 to 6 carbon atoms thereof.

In addition, preferred examples thereof include the tetracarboxylic acid dianhydrides (DAA-1) to (DAA-5) described in paragraph 0038 of WO2017/038598A.

In Formula (2), it is also possible that at least one of $R^{111}$ or $R^{115}$ has an OH group. More specifically, examples of $R^{111}$ include a residue of a bisaminophenol derivative.

$R^{113}$ and $R^{114}$ in Formula (2) each independently represent a hydrogen atom or a monovalent organic group. The monovalent organic group preferably includes a linear or branched alkyl group, a cyclic alkyl group, an aromatic group, or a polyalkyleneoxy group. In addition, at least one of $R^{113}$ or $R^{114}$ preferably contains a polymerizable group, and more preferably both of them contain a polymerizable group. It is also preferable that at least one of $R^{113}$ or $R^{114}$ contains two or more polymerizable groups. The polymerizable group is preferably a group capable of undergoing a crosslinking reaction under the action of heat, a radical, or the like, where the group is a radically polymerizable group. Specific examples of the polymerizable group include a group having an ethylenically unsaturated bond, an alkoxymethyl group, a hydroxymethyl group, an acyloxymethyl group, an epoxy group, an oxetanyl group, a benzoxazolyl group, a

blocked isocyanate group, and an amino group. The radically polymerizable group contained in the polyimide precursor is preferably a group having an ethylenically unsaturated bond.

Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, a (meth)acrylamide group, a (meth)acryloyloxy group, and a group represented by Formula (III), where a group represented by Formula (III) is preferable.

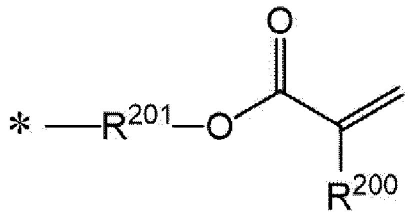

(III)

In Formula (III), $R^{200}$ represents a hydrogen atom, a methyl group, an ethyl group, or a methylol group, where a hydrogen atom or a methyl group is preferable.

In Formula (III), * represents a bonding site to another structure.

In Formula (III), $R^{201}$ represents an alkylene group having 2 to 12 carbon atoms, - $CH_2CH(OH)CH_2$-, a cycloalkylene group, or a polyalkyleneoxy group.

Suitable examples of $R^{201}$ include an alkylene group such as an ethylene group, a propylene group, a trimethylene group, a tetramethylene group, a pentamethylene group, a hexamethylene group, an octamethylene group, or a dodecamethylene group, a 1,2-butanediyl group, a 1,3-butanediyl group, -$CH_2CH(OH)CH_2$-, and a polyalkyleneoxy group, where an alkylene group such as an ethylene group or a propylene group, -$CH_2CH(OH)CH_2$-, a cyclohexyl group, or a polyalkyleneoxy group is more preferable, and an alkylene group such as an ethylene group or a propylene group, or a polyalkyleneoxy group is still more preferable.

In the present invention, the polyalkyleneoxy group refers to a group to which two or more alkyleneoxy groups are directly bonded. The alkylene group in the plurality of alkyleneoxy groups contained in the polyalkyleneoxy group may be the same or different from each other.

In a case where the polyalkyleneoxy group contains a plurality of kinds of alkyleneoxy groups having different alkylene groups, the sequence of the alkyleneoxy groups in the polyalkyleneoxy group may be a random sequence, may be a sequence having a block, or may be a sequence having an alternating pattern or the like.

The number of carbon atoms of the alkylene group (including the number of carbon atoms of the substituent in a case where the alkylene group has a substituent) is preferably 2 or more, more preferably 2 to 10, still more preferably 2 to 6, even still more preferably 2 to 5, even further still more preferably 2 to 4, particularly preferably 2 or 3, and most preferably 2.

In addition, the alkylene group may have a substituent. Examples of the preferred substituent include an alkyl group, an aryl group, and a halogen atom.

In addition, the number of alkyleneoxy groups contained in the polyalkyleneoxy group (the number of repetitions of the polyalkyleneoxy group) is preferably 2 to 20, more preferably 2 to 10, and still more preferably 2 to 6.

The polyalkyleneoxy group is preferably a polyethyleneoxy group, a polypropyleneoxy group, a polytrimethyleneoxy group, a polytetramethyleneoxy group, or a group obtained by bonding a plurality of ethyleneoxy groups with a plurality of propyleneoxy groups, more preferably a polypropyleneoxy group or a polyethyleneoxy group, and still more preferably an polyethyleneoxy group, from the viewpoint of solubility in a solvent and solvent resistance. In the group obtained by bonding a plurality of ethyleneoxy groups with a plurality of propyleneoxy groups, the ethyleneoxy groups and the propyleneoxy groups may be randomly arranged, may be arranged by forming a block, or may be arranged in an alternately patterned manner or the like. The preferred aspect of the number of repetitions of the ethyleneoxy group and the like in these groups is as described above.

In Formula (2), in a case where $R^{113}$ is a hydrogen atom, or in a case where $R^{114}$ is a hydrogen atom, the polyimide precursor may form a conjugate salt together with a tertiary amine compound having an ethylenically unsaturated bond. Examples of the tertiary amine compound having such an ethylenically unsaturated bond include N,N-dimethylaminopropyl methacrylate.

In Formula (2), at least one of $R^{113}$ or $R^{114}$ may be a polarity converting group such as an acid-decomposable group. The acid-decomposable group is not particularly limited as long as it decomposes by the action of the acid to generate an alkali-soluble group such as a phenolic hydroxy group or a carboxy group; however, it is preferably an acetal group, a ketal group, a silyl group, or a silyl ether group, a tertiary alkyl ester group, or the like, and from the viewpoint of exposure sensitivity, it is more preferably an acetal group or a ketal group.

Specific examples of the acid-decomposable group include a tert-butoxycarbonyl group, an isopropoxycarbonyl

group, a tetrahydropyranyl group, a tetrahydrofuranyl group, an ethoxyethyl group, a methoxyethyl group, an ethoxymethyl group, a trimethylsilyl group, a tertbutoxycarbonylmethyl group, and a trimethylsilyl ether group. From the viewpoint of exposure sensitivity, an ethoxyethyl group or a tetrahydrofuranyl group is preferable.

In addition, the polyimide precursor preferably has a fluorine atom in the structure thereof. The content of fluorine atoms in the polyimide precursor is preferably 10% by mass or more, and it is preferably 20% by mass or less.

In addition, for the purpose of improving adhesiveness to a substrate, the polyimide precursor may be copolymerized with an aliphatic group having a siloxane structure. Specifically, an aspect in which bis(3-aminopropyl)tetramethyldisiloxane, bis(p-aminophenyl)octamethyl pentasiloxane, or the like is used as the diamine can be mentioned.

The repeating unit represented by Formula (2) is preferably a repeating unit represented by Formula (2-A). That is, at least one polyimide precursor that is used in the present invention is preferably a precursor having a repeating unit represented by Formula (2-A). In a case where the polyimide precursor contains a repeating unit represented by Formula (2-A), it is possible to further widen the width of the exposure latitude.

Expression (2-A)

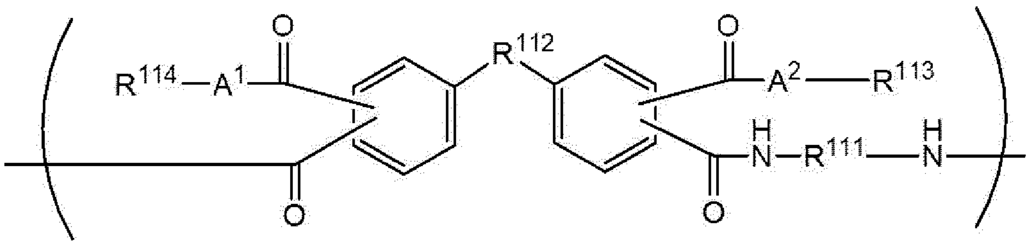

In Formula (2-A), $A^1$ and $A^2$ represent an oxygen atom, $R^{111}$ and $R^{112}$ each independently represent a divalent organic group, $R^{113}$ and $R^{114}$ each independently represent a hydrogen atom or a monovalent organic group, and at least one of $R^{113}$ or $R^{114}$ is a group containing a polymerizable group, where both of them are preferably a group containing a polymerizable group.

$A^1$, $A^2$, $R^{111}$, $R^{113}$, and $R^{114}$ are each independently have the same meaning as $A^1$, $A^2$, $R^{111}$, $R^{113}$, and $R^{114}$ in Formula (2), respectively, and the same applies to the preferred ranges thereof.

$R^{112}$ has the same meaning as $R^{112}$ in Formula (5), and the same applies to the preferred range thereof.

The polyimide precursor may contain one kind of repeating unit represented by Formula (2) or may contain two or more kinds thereof. In addition, the polyimide precursor may contain structural isomers of the repeating unit represented by Formula (2). In addition, it is needless to say that the polyimide precursor may also contain another kind of repeating unit in addition to the above repeating unit represented by Formula (2).

One embodiment of the polyimide precursor in the present invention includes an aspect in which the content of the repeating unit represented by Formula (2) is 50% by mole or more of all the repeating units. The above-described total content is more preferably 70% by mole or more, still more preferably 90% by mole or more, and particularly preferably more than 90% by mole. The upper limit of the total content is not particularly limited, and all the repeating units in the polyimide precursor excluding the terminal may be the repeating unit represented by Formula (2).

The weight-average molecular weight (Mw) of the polyimide precursor is preferably 5,000 to 100,000, more preferably 10,000 to 50,000, and still more preferably 15,000 to 40,000. In addition, the number-average molecular weight (Mn) thereof is preferably 2,000 to 40,000, more preferably 3,000 to 30,000, and still more preferably 4,000 to 20,000.

The dispersivity of the molecular weight of the polyimide precursor is preferably 1.5 or more, more preferably 1.8 or more, and still more preferably 2.0 or more. The upper limit value of the dispersivity of the molecular weight of the polyimide precursor is not particularly limited; however, it is, for example, preferably 7.0 or less, more preferably 6.5 or less, and still more preferably 6.0 or less.

In the present specification, the dispersivity of the molecular weight is a value obtained by calculating "weight-average molecular weight/number-average molecular weight".

In addition, in a case where the resin composition contains a plurality of kinds of polyimide precursors as the specific resin, it is preferable that the weight-average molecular weight, the number-average molecular weight, and the dispersivity of at least one kind of polyimide precursor are in the above ranges. In addition, it is also preferable that the weight-average molecular weight, the number-average molecular weight, and the dispersivity, calculated by using the plurality of kinds of polyimide precursors as one resin, are within the above ranges.

[Polyimide]

The polyimide that is used in the present invention may be an alkali-soluble polyimide or may be a polyimide soluble in a developer containing an organic solvent as a main component.

In the present specification, the alkali-soluble polyimide refers to a polyimide, 0.1 g or more of which is dissolved in 100 g of an aqueous solution of 2.38% by mass of tetramethylammonium at 23°C, and from the viewpoint of pattern formation properties, it is preferably a polyimide, 0.5 g or more of which is dissolved therein and still more preferably a polyimide, 1.0 g or more of which is dissolved therein. The upper limit of the dissolution amount is not particularly limited; however, it is preferably 100 g or less.

In addition, the polyimide is preferably a polyimide having a plurality of imide structures in the main chain from the viewpoint of the film hardness and the insulating properties of the organic film to be obtained.

In the present specification, the "main chain" refers to the relatively longest bonding chain in the molecule of the polymer compound that constitutes the resin, and the "side chain" refers to other bonding chains other than the main chain.

- Fluorine atom -

From the viewpoint of the film hardness of the organic film to be obtained, the polyimide preferably has a fluorine atom.

The fluorine atom is preferably contained in, for example, $R^{132}$ in a repeating unit represented by Formula (4) described later or $R^{131}$ in a repeating unit represented by Formula (4) described later, and it is more preferably contained, as a fluorinated alkyl group, in $R^{132}$ in a repeating unit represented by Formula (4) described later or $R^{131}$ in a repeating unit represented by Formula (4) described later.

The amount of fluorine atoms with respect to the total mass of the polyimide is preferably 5% by mass or more, and it is preferably 20% by mass or less.

- Silicon atom -

From the viewpoint of the film hardness of the organic film to be obtained, it is also preferable that the polyimide has a silicon atom.

The silicon atom is preferably contained in, for example, $R^{131}$ in a repeating unit represented by Formula (4) described later, and more preferably contained in $R^{131}$ in a repeating unit represented by Formula (4) described later as an organically modified (poly)siloxane structure.

In addition, the silicon atom or the organically modified (poly)siloxane structure may be contained in the side chain of the polyimide; however, it is preferably contained in the main chain of the polyimide.

The amount of silicon atoms with respect to the total mass of the polyimide is preferably 1% by mass or more and more preferably 20% by mass or less.

- Ethylenically unsaturated bond -

From the viewpoint of the film hardness of the organic film to be obtained, the polyimide preferably has an ethylenically unsaturated bond.

The polyimide may have an ethylenically unsaturated bond at the terminal of the main chain or the side chain; however, it preferably has an ethylenically unsaturated bond at the side chain.

The ethylenically unsaturated bond preferably has radical polymerizability.

The ethylenically unsaturated bond is preferably contained in $R^{132}$ in a repeating unit represented by Formula (4) described later or $R^{131}$ in a repeating unit represented by Formula (4) described later, and it is more preferably contained, as a group having an ethylenically unsaturated bond, in $R^{132}$ in a repeating unit represented by Formula (4) described later or $R^{131}$ in a repeating unit represented by Formula (4) described later.

Among the above, the ethylenically unsaturated bond is preferably contained in $R^{131}$ in a repeating unit represented by Formula (4) described later, and it is more preferably contained, as a group having an ethylenically unsaturated bond, in $R^{131}$ in a repeating unit represented by Formula (4) described later.

Examples of the group having an ethylenically unsaturated bond include a group having a vinyl group which may be substituted, which is directly bonded to an aromatic ring such as a vinyl group, an allyl group, or a vinylphenyl group, a (meth)acrylamide group, a (meth)acryloyloxy group, and a group represented by Formula (IV).

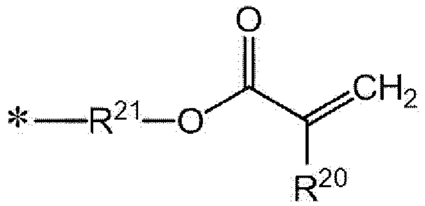

(IV)

In Formula (IV), $R^{20}$ represents a hydrogen atom, a methyl group, an ethyl group, or a methylol group, where a hydrogen atom or a methyl group is preferable.

In Formula (IV), $R^{21}$ represents an alkylene group having 2 to 12 carbon atoms, $-O-CH_2CH(OH)CH_2-$, $-C(=O)O-$, $-O(C=O)NH-$, a (poly)alkyleneoxy group having 2 to 30 carbon atoms (the alkylene group preferably has 2 to 12 carbon atoms, more preferably 2 to 6 carbon atoms, and particularly preferably 2 or 3 carbon atoms; the number of repetitions thereof is preferably 1 to 12, more preferably 1 to 6, and particularly preferably 1 to 3), or a group obtained by combining two or more of these.

In addition, the alkylene group having 2 to 12 carbon atoms may be a linear one, a branched one, or a cyclic one, or may be any alkylene group represented by a combination of these.

The alkylene group having 2 to 12 carbon atoms is preferably an alkylene group having 2 to 8 carbon atoms and more preferably an alkylene group having 2 to 4 carbon atoms.

Among the above, $R^{21}$ is preferably a group represented by any one of Formulae (R1) to (R3) and more preferably a group represented by Formula (R1).

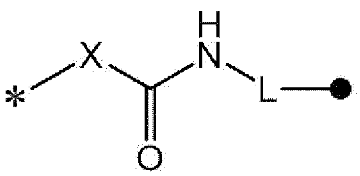

(R1)

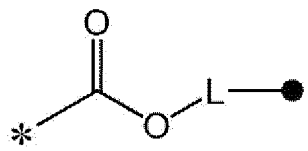

(R2)

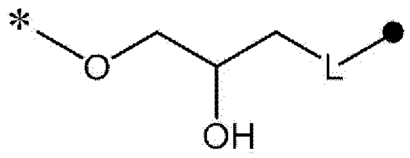

(R3)

In Formulae (R1) to (R3), L represents a single bond, an alkylene group having 2 to 12 carbon atoms, a (poly)alkyleneoxy group having 2 to 30 carbon atoms, or a group obtained by bonding two or more of these, X represents an oxygen atom or a sulfur atom, * represents a bonding site to another structure, and ● represents a bonding site to an oxygen atom to which $R^{21}$ in Formula (IV) is bonded.

In Formulae (R1) to (R3), a preferred aspect of the alkylene group having 2 to 12 carbon atoms in L or the (poly)alkyleneoxy group having 2 to 30 carbon atoms is the same as the preferred aspect of the alkylene group having 2 to 12 carbon atoms or the (poly)alkyleneoxy group having 2 to 30 carbon atoms as $R^{21}$ described above.

In Formula (R1), X is preferably an oxygen atom.

In Formulae (R1) to (R3), * has the same meaning as * in Formula (IV), and the same applies to the preferred aspect thereof.

The structure represented by Formula (R1) is obtained, for example, by reacting a polyimide having a hydroxy group such as a phenolic hydroxy group with a compound (for example, 2-isocyanatoethyl methacrylate) having an isocyanato group and an ethylenically unsaturated bond.

The structure represented by Formula (R2) is obtained, for example, by reacting a polyimide having a carboxy group with a compound (for example, 2-hydroxyethyl methacrylate) having a hydroxy group and an ethylenically unsaturated bond.

The structure represented by Formula (R3) is obtained, for example, by reacting a polyimide having a hydroxy group such as a phenolic hydroxy group with a compound (for example, glycidyl methacrylate) having a glycidyl group and an ethylenically unsaturated bond.

In Formula (IV), * represents a bonding site to another structure, and it is preferably a bonding site to the main chain of the polyimide.

The amount of the ethylenically unsaturated bond with respect to the total mass of the polyimide is preferably 0.0001 to 0.1 mol/g and more preferably 0.0005 to 0.05 mol/g.

- Polymerizable group other than group having ethylenically unsaturated bond -

The polyimide may have a polymerizable group other than the group having an ethylenically unsaturated bond.

Examples of the polymerizable group other than the group having an ethylenically unsaturated bond include a cyclic ether group such as an epoxy group or an oxetanyl group, an alkoxymethyl group such as a methoxymethyl group, and a methylol group.

The polymerizable group other than the group having an ethylenically unsaturated bond is preferably contained in, for example, $R^{131}$ in a repeating unit represented by Formula (4) described later.

The amount of the polymerizable group other than the group having an ethylenically unsaturated bond with respect to the total mass of the polyimide is preferably 0.0001 to 0.1 mol/g and more preferably 0.001 to 0.05 mol/g.

- Polarity converting group -

The polyimide may have a polarity converting group such as an acid-decomposable group. The acid-decomposable group in the polyimide is the same as the acid-decomposable group described in $R^{113}$ and $R^{114}$ in Formula (2) described above, and the same applies to the preferred aspect thereof.

The polarity converting group is contained, for example, in $R^{131}$ or $R^{132}$ in the repeating unit represented by Formula (4) described later, or a terminal of the polyimide.

- Acid value -

In a case where the polyimide is subjected to alkaline development, the acid value of the polyimide is preferably 30 mgKOH/g or more, more preferably 50 mgKOH/g or more, and still more preferably 70 mgKOH/g or more, from the viewpoint of improving developability.

In addition, the acid value thereof is preferably 500 mgKOH/g or less, more preferably 400 mgKOH/g or less, and still more preferably 200 mgKOH/g or less.

In addition, in a case where the polyimide is subjected to the development (for example, the "solvent development" described later) using a developer containing an organic solvent as a main component, the acid value of the polyimide is preferably 1 to 35 mgKOH/g, more preferably 2 to 30 mgKOH/g, and still more preferably 5 to 20 mgKOH/g.

The acid value is measured by a publicly known method, for example, by the method described in JIS K0070: 1992.

In addition, the acid group contained in the polyimide is preferably an acid group having a pKa of 0 to 10 and more preferably an acid group having a pKa of 3 to 8 from the viewpoint of achieving both storage stability and developability.

The "pKa" is represented by the negative common logarithm pKa of the equilibrium constant Ka of a dissociation reaction, in a case of assuming that hydrogen ions are released from the acid in the dissociation reaction. In the present specification, unless otherwise specified, pKa is a value calculated by ACD/ChemSketch (registered trade name). Alternatively, the values published in "Handbook of Chemistry, Pure Chemistry, 5th Edition" edited by the Chemical Society of Japan may be referred to.

In addition, in a case where the acid group is a polyvalent acid such as phosphoric acid, the pKa is the first dissociation constant.

As such an acid group, the polyimide preferably contains at least one selected from the group consisting of a carboxy group and a phenolic hydroxy group and more preferably contains a phenolic hydroxy group.

- Phenolic hydroxy group -

From the viewpoint of allowing the speed of development with an alkaline developer to be proper, the polyimide preferably has a phenolic hydroxy group.

The polyimide may have a phenolic hydroxy group at the terminal of the main chain or the side chain.

The phenolic hydroxy group is preferably contained in, for example, $R^{132}$ in a repeating unit represented by Formula (4) described later or $R^{131}$ in a repeating unit represented by Formula (4) described later.

The amount of the phenolic hydroxy group with respect to the total mass of the polyimide is preferably 0.1 to 30 mol/g and more preferably 1 to 20 mol/g.

The polyimide that is used in the present invention is not particularly limited as long as it is a polymer compound having an imide structure; however, it is preferable that the polyimide contains a repeating unit represented by Formula (4).

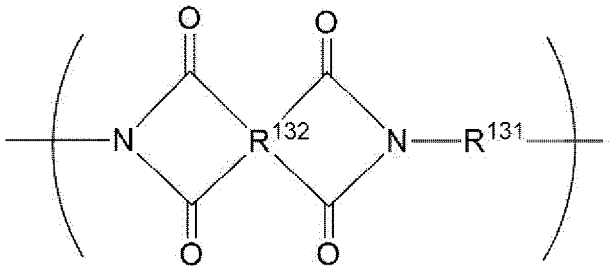

(4)

In Formula (4), $R^{131}$ represents a divalent organic group, and $R^{132}$ represents a tetravalent organic group.

In a case where a polymerizable group is contained, the polymerizable group may be located at at least one of $R^{131}$ or $R^{132}$ or may be located at the terminal of the polyimide as shown in Formula (4-1) or Formula (4-2).

Formula (4-1)

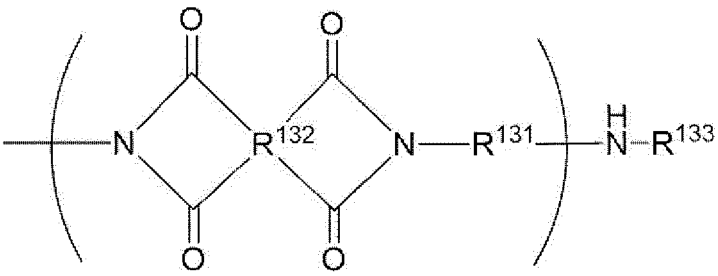

In Formula (4-1), $R^{133}$ is a polymerizable group, and the other groups respectively have the same meanings as those in Formula (4).

Formula (4-2)

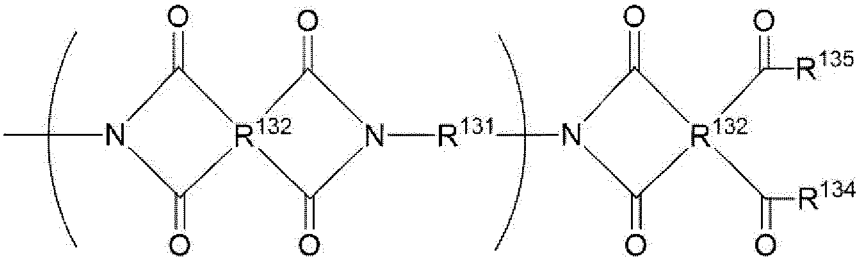

At least one of $R^{134}$ or $R^{135}$ is a polymerizable group, where it is an organic group in a case of not being a polymerizable group, and the other groups respectively have the same meanings as those in Formula (4).

Examples of the polymerizable group include the above-described group having an ethylenically unsaturated bond or a crosslinkable group other than the above-described group having an ethylenically unsaturated bond.

$R^{131}$ represents a divalent organic group. Examples of the divalent organic group include the same one as $R^{111}$ in Formula (2), and the same applies to the preferred range thereof.

In addition, examples of $R^{131}$ include a diamine residue that remains after the removal of an amino group of a diamine. Examples of the diamine include an aliphatic, a cyclic aliphatic, and an aromatic diamine. Specific examples thereof include the example of $R^{111}$ in Formula (2) which is contained in the polyimide precursor.

It is preferable that $R^{131}$ is a diamine residue having at least two alkylene glycol units in the main chain from the viewpoint of more effectively suppressing the occurrence of warping during baking. It is more preferably a diamine residue containing, in one molecule, a total of two or more chains of any one or both of the ethylene glycol chain and the propylene glycol chain, and it is still more preferably the above-described diamine which is a diamine residue containing no aromatic ring.

Examples of the diamine containing, in one molecule, a total of two or more chains of any one or both of the ethylene glycol chain and the propylene glycol chain include JEFFAMINE (registered trademark) KH-511, ED-600, ED-900, ED-2003, EDR-148, EDR-176, D-200, D-400, D-2000, D-4000 (all product names, manufactured by HUNTSMAN Corporation), 1-(2-(2-(2-aminopropoxy)ethoxy)propoxy)propane-2-amine, and 1-(1-(1-(2-aminopropoxy)propan-2-yl)oxy)propane-2-amine, which are not limited thereto.

$R^{132}$ represents a tetravalent organic group. Examples of the tetravalent organic group include the same one as $R^{115}$ in Formula (2), and the same applies to the preferred range thereof.

For example, four bonding partners of the tetravalent organic group exemplified as $R^{115}$ are bonded to four -C(=O)- moieties in Formula (4) to form a fused ring.

In addition, examples of $R^{132}$ include a tetracarboxylic acid residue that remains after the removal of the anhydride group from the tetracarboxylic acid dianhydride. Specific examples thereof include the example of $R^{115}$ in Formula (2) which is contained in the polyimide precursor. From the viewpoint of the hardness of the organic film, $R^{132}$ is preferably an aromatic diamine residue having 1 to 4 aromatic rings.

It is also preferable that an OH group is contained in at least one of $R^{131}$ or $R^{132}$. More specifically, preferred examples of $R^{131}$ include 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, and the above (DA-1) to (DA-18), and more preferred examples of $R^{132}$ include the above (DAA-1) to (DAA-5).

In addition, the polyimide preferably has a fluorine atom in the structure thereof. The content of fluorine atoms in the polyimide is preferably 10% by mass or more, and it is more preferably 20% by mass or less.

In addition, for intended the purpose of improving adhesiveness to a substrate, an aliphatic group having a siloxane structure may be subjected to copolymerization for the polyimide. Specific examples of the diamine component include bis(3-aminopropyl)tetramethyldisiloxane, and bis(p-aminophenyl)octamethyl pentasiloxane.

In addition, in order to improve the storage stability of the resin composition, the terminal of the main chain of the polyimide is preferably blocked with a terminal blocking agent such as a monoamine, an acid anhydride, a monocarboxylic acid, a monoacid chloride compound, or a monoactive ester compound. Among these, it is more preferable to use monoamine. Examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

- Ring closure rate -

The imidization rate (also referred to as the ring closure rate) of the polyimide is preferably 70% or more and more preferably 80% or more from the viewpoint of the film hardness, the insulating properties, or the like of the organic film to be obtained.

The upper limit of the imidization rate is not particularly limited, and it is preferably 95% or less and more preferably 90% or less.

The imidization rate is measured according to the method described above.

The polyimide may contain the repeating unit of Formula (4), the whole of which contains one kind of $R^{131}$ or $R^{132}$, or it may contain the repeating unit of Formula (4), in which two or more different kinds of $R^{131}$ or $R^{132}$ are contained. In addition, the polyimide may also contain another kind of repeating unit in addition to the above repeating unit represented by Formula (4). Examples of the other kind of repeating unit include the repeating unit represented by Formula (2) described above.

The polyimide can be synthesized by utilizing, for example, a method in which a tetracarboxylic acid dianhydride is reacted with a diamine (a part thereof is substituted with a terminal blocking agent which is a monoamine) at a low temperature, a method in which a tetracarboxylic acid dianhydride (a part thereof is substituted with a terminal blocking agent which is an acid anhydride, a monoacid chloride compound, or a monoactive ester compound) is reacted with a diamine at a low temperature, a method in which a diester is obtained from a tetracarboxylic acid dianhydride and alcohol and then reacted with a diamine (a part thereof is substituted with a terminal blocking agent which is a monoamine) in the presence of a condensing agent, a method in which a polyimide precursor is obtained, for example, by using a method in which a diester is obtained from a tetracarboxylic acid dianhydride and an alcohol, the remaining dicarboxylic acid is subjected to acid chloride modification and reacted with a diamine (a part thereof is substituted with a terminal blocking agent which is a monoamine), and the polyimide precursor is subjected to full imidization using a known imidization reaction method, or, a method in which the imidization reaction is stopped in the middle of the reaction and the imide structure is partially introduced, or furthermore a method in which a fully imidized polymer is blended with the polyimide precursor, whereby the imide structure is partially introduced. In addition, another publicly known method for

synthesizing polyimide can also be applied.

The weight-average molecular weight (Mw) of the polyimide is preferably 5,000 to 100,000, more preferably 10,000 to 50,000, and still more preferably 15,000 to 40,000. In a case where the weight-average molecular weight is set to 5,000 or more, it is possible to improve the breakage resistance of the film after curing. In order to obtain an organic film having excellent mechanical properties (for example, breaking elongation), the weight-average molecular weight is particularly preferably 15,000 or more.

In addition, the number-average molecular weight (Mn) of the polyimide is preferably 2,000 to 40,000, more preferably 3,000 to 30,000, and still more preferably 4,000 to 20,000.

The dispersivity of the molecular weight of the polyimide is preferably 1.5 or more, more preferably 1.8 or more, and still more preferably 2.0 or more. The upper limit value of the dispersivity of the molecular weight of the polyimide is not particularly limited; however, it is, for example, preferably 7.0 or less, more preferably 6.5 or less, and still more preferably 6.0 or less.

In addition, in a case where the resin composition contains a plurality of kinds of polyimides as the specific resin, it is preferable that the weight-average molecular weight, the number-average molecular weight, and the dispersivity of at least one kind of polyimide are in the above ranges. In addition, it is also preferable that the weight-average molecular weight, the number-average molecular weight, and the dispersivity, calculated by using the plurality of kinds of polyimides as one resin, are within the above ranges.

[Production method for polyimide precursor and like]

The polyimide precursor the like can be obtained, for example, by a method of reacting a tetracarboxylic acid dianhydride with a diamine at a low temperature, a method of reacting a tetracarboxylic acid dianhydride with a diamine at a low temperature to obtain a polyamic acid and subjecting the polyamic acid to esterification by using a condensing agent or an alkylating agent, a method of obtaining a diester with a tetracarboxylic acid dianhydride and alcohol and then reacting the diester with a diamine in the presence of a condensing agent, and a method of obtaining a diester with a tetracarboxylic acid dianhydride and alcohol, subsequently subjecting the rest dicarboxylic acid to acid-halogenation using a halogenating agent, and carrying out reaction with a diamine. Among the above production method, a method of obtaining a diester with a tetracarboxylic acid dianhydride and alcohol, subsequently subjecting the rest dicarboxylic acid to acid-halogenation using a halogenating agent, and carrying out a reaction with a diamine is more preferable.

Examples of the condensing agent include dicyclohexylcarbodiimide, diisopropylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate, and trifluoroacetic anhydride.

Examples of the alkylating agent include N,N-dimethylformamide dimethyl acetal, N,N-dimethylformamide diethyl acetal, N,N-dialkylformamide dialkyl acetal, trimethyl orthoformate, triethyl orthoformate.

Examples of the halogenating agent include thionyl chloride, oxalyl chloride, and phosphorus oxychloride.

In the production method for a polyimide precursor the like, it is preferable to use an organic solvent at the time of the reaction. One kind of organic solvent may be used, or two or more kinds thereof may be used.

The organic solvent can be appropriately determined depending on the raw material; however, examples thereof include pyridine, diethylene glycol dimethyl ether (diglyme), N-methylpyrrolidone, N-ethylpyrrolidone, ethyl propionate, dimethylacetamide, dimethylformamide, tetrahydrofuran, and $\gamma$-butyrolactone.

In the production method for a polyimide precursor the like, it is preferable to add a basic compound at the time of the reaction. One kind of basic compound may be used, or two or more kinds thereof may be used.

The basic compound can be appropriately determined depending on the raw material; however, examples thereof include triethylamine, diisopropylethylamine, pyridine, 1,8-diazabicyclo[5.4.0]undec-7-ene, and N,N-dimethyl-4-aminopyridine.

- Terminal blocking agent -

In the production method for a polyimide precursor the like, it is preferable to block the carboxylic acid anhydride, the acid anhydride derivative, or the amino group, remaining at the terminal of the resin such as the polyimide precursor, in order to further improve the storage stability. In a case of blocking the carboxylic acid anhydride and the acid anhydride derivative, remaining at the resin terminal, examples of the terminal blocking agent include a monoalcohol, phenol, thiol, thiophenol, and a monoamine. It is more preferable to use a monoalcohol, phenols, or a monoamine from the viewpoint of reactivity and film stability. Examples of the preferred monoalcohol compound include primary alcohol such as methanol, ethanol, propanol, butanol, hexanol, octanol, dodecynol, benzyl alcohol, 2-phenylethanol, 2-methoxyethanol, 2-chloromethanol, and furfuryl alcohol; secondary alcohol such as isopropanol, 2-butanol, cyclohexyl alcohol, cyclopentanol, and 1-methoxy-2-propanol; and tertiary alcohol such as t-butyl alcohol and adamantane alcohol. Examples of the preferred compounds of phenols include phenols such as phenol, methoxyphenol, methylphenol, naphthalene-1-ol,

naphthalene-2-ol, and hydroxystyrene. In addition, examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

In addition, in a case of blocking the amino group at the terminal of the resin, it is possible to carry out blocking with a compound having a functional group capable of reacting with the amino group. The preferred terminal blocking agent for the amino group is preferably a carboxylic acid anhydride, a carboxylic acid chloride, a carboxylic acid bromide, a sulfonic acid chloride, sulfonic acid anhydride, or a sulfonic acid carboxylic acid anhydride, and more preferably a carboxylic acid anhydride or a carboxylic acid chloride. Examples of the preferred carboxylic acid anhydride compound include acetic anhydride, propionic anhydride, oxalic anhydride, succinic anhydride, maleic acid anhydride, phthalic anhydride, and benzoic anhydride, 5-norbornen-2,3-dicarboxylic acid anhydride. Examples of the preferred carboxylic acid chloride compound include acetyl chloride, acrylic acid chloride, propionyl chloride, methacrylic acid chloride, pivaloyl chloride, cyclohexanecarbonyl chloride, 2-ethylhexanoyl chloride, cinnamoyl chloride, 1-adamantanecarbonyl chloride, heptafluorobutyryl chloride, stearic acid chloride, and benzoyl chloride.

In addition, in a case where a compound having a structure exhibiting a property of generating a base is used as the terminal blocking agent, it is also possible to introduce a structure exhibiting a property of generating a base at a terminal of the specific resin.

As such a terminal blocking agent, it is possible to use, for example, a compound having a structure exhibiting a property of generating a base, and a reactive group such as a hydroxy group, a thiol group, an amino group, a carboxy group, a carboxylic acid anhydride group, a carboxylic acid halide group, a sulfonic acid anhydride group, a sulfonic acid halide group, or a sulfonic acid carboxylic acid anhydride group.

As the terminal blocking agent, it is possible to use, for example, a compound having a structure exhibiting a property of generating one or more bases and one or more of the reactive groups described above.

The preferred aspect of the structure exhibiting a property of generating a base is as described above.

In addition, as the terminal blocking agent, a compound represented by Formula (T-1) may be used. In a case where the terminal is blocked with such a compound, it is possible to introduce a structure in which a base is likely to be generated at the terminal, and it is considered that the breaking elongation is easily improved even in a case where curing is carried out at a low temperature.

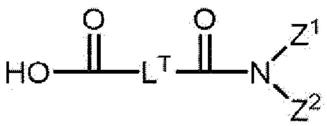

(T-1)

In Formula (T-1), $L^T$ represents a divalent organic group, and $Z^1$ and $Z^2$ each independently represent an organic group, where $Z^1$ and $Z^2$ may be bonded to each other to form a ring structure.

In Formula (T-1), $L^T$ is preferably a hydrocarbon group and may be any of an aromatic hydrocarbon group or an aliphatic hydrocarbon group; however, it is preferably any one of an aromatic hydrocarbon group, an unsaturated aliphatic hydrocarbon group, or a cyclic aliphatic hydrocarbon group.

The linking chain length in $L^T$ (that is, the minimum number of atoms among the numbers of atoms linking two carbonyl groups that are bonded to $L^T$) is preferably 2 to 4 and more preferably 2.

In Formula (T-1), $Z^1$ and $Z^2$ have the same meanings as $Z^1$ and $Z^2$ in Formula (3-1), and the same applies to the preferred aspects thereof.

In particular, an aspect in which at least one of $Z^1$, $Z^2$, or $L^T$ has a polymerizable group is also one of the preferred aspects of the present invention.

Examples of the polymerizable group include a radically polymerizable group, an epoxy group, an oxetanyl group, a methylol group, and an alkoxymethyl group, where a radically polymerizable group is preferable.

The radically polymerizable group is preferably a group having an ethylenically unsaturated group, and examples thereof include a (meth)acryloxy group, a (meth)acrylamide group, a vinylphenyl group, a maleimide group, a styryl group, a vinyl group, and a (meth)allyl group.

Among these, a (meth)acryloxy group is preferable from the viewpoint of reactivity.

These polymerizable groups may be directly bonded to the nitrogen atom in Formula (T-1) or may be bonded

through a linking group such as a hydrocarbon group (for example, an alkylene group).

- Solid precipitation -

In the production method for a polyimide precursor the like, a step of precipitating a solid may be included. Specifically, it is possible to obtain a polyimide precursor by filtering out a water-absorbing by-product of the dehydration condensing agent that is present together in the reaction solution as necessary, subsequently putting the obtained polymer component in a poor solvent such as water, an aliphatic lower alcohol, or a mixed solution thereof, precipitating the polymer component to be precipitated as a solid, and then carrying out drying. In order to improve the degree of purification, operations such as redissolution, reprecipitation, and drying of the polyimide precursor may be repeated. Further, a step of removing ionic impurities using an ion exchange resin may be included.

[Content]

The content of the specific resin in the resin composition according to the embodiment of the present invention is preferably 20% by mass or more, more preferably 30% by mass or more, still more preferably 40% by mass or more, and even still more preferably 50% by mass or more, with respect to the total solid content of the resin composition. In addition, the content of the resin in the resin composition according to the embodiment of the present invention is preferably 99.5% by mass or less, more preferably 99% by mass or less, still more preferably 98% by mass or less, still more preferably 97% by mass or less, and even still more preferably 95% by mass or less, with respect to the total solid content of the resin composition.

The resin composition according to the embodiment of the present invention may contain only one kind of specific resin or may contain two or more kinds thereof. In a case where two or more kinds thereof are contained, the total amount thereof is preferably within the above range.

In addition, it is also preferable that the resin composition according to the embodiment of the present invention contains at least two kinds of resins.

Specifically, the resin composition according to the embodiment of the present invention may contain in total two or more kinds of the specific resins and other resins described later or may contain two or more kinds of the specific resins; however, it is preferable to include two or more kinds of the specific resins.

In a case where the resin composition according to the embodiment of the present invention contains two or more kinds of the specific resins, it is preferable to contain, for example, two or more kinds of polyimide precursors which are polyimide precursors in which the structure ($R^{115}$ in Formula (2) described above) derived from the dianhydride is different.

<Another resin>

The resin composition according to the embodiment of the present invention may contain the above-described specific resin and another resin (hereinafter, also simply referred to as "the other resin") that is different from the specific resin.

Examples of the other resin include a phenol resin, polyamide, an epoxy resin, polysiloxane, a resin containing a siloxane structure, a (meth)acrylic resin, a (meth)acrylamide resin, a urethane resin, a butyral resin, a styryl resin, a polyether resin, and a polyester resin.

For example, in a case where a (meth)acrylic resin is further added, it is possible to obtain a resin composition having excellent coatability, and it is possible to obtain a pattern (a cured substance) having excellent solvent resistance.

For example, in a case where a (meth)acrylic resin having a high polymerizable base value and having a weight-average molecular weight of 20,000 or less (for example, a molar amount of a polymerizable group contained in 1 g of a resin is $1 \times 10^{-3}$ mol/g or more) is added to the resin composition instead of a polymerizable compound described later or in addition to a polymerizable compound described later, it is possible to improve the coatability of the resin composition, the solvent resistance of the pattern (the cured substance).

In a case where the resin composition according to the embodiment of the present invention contains the other resin, the content of the other resin is preferably 0.01% by mass or more, more preferably 0.05% by mass or more, still more preferably 1% by mass or more, even still more preferably 2% by mass or more, even still more preferably 5% by mass or more, and even further still more preferably 10% by mass or more, with respect to the total solid content of the resin composition.

In addition, the content of the other resin in the resin composition according to the embodiment of the present invention is preferably 80% by mass or less, more preferably 75% by mass or less, still more preferably 70% by mass or less, still more preferably 60% by mass or less, and even still more preferably 50% by mass or less, with respect to the total solid content of the resin composition.

In addition, as the preferred aspect of the resin composition according to the aspect of the present invention, an aspect in which the content of the other resin is a low content can be adopted. In the above aspect, the content of the other resin is preferably 20% by mass or less, more preferably 15% by mass or less, still more preferably 10% by mass or less, still more preferably 5% by mass or less, and even still more preferably 1% by mass or less, with respect to the total solid content of the resin composition. The lower limit of the content is not particularly limited, and it may be any content of 0% by mass or more.
The resin composition according to the embodiment of the present invention may contain only one kind of the other resin or may contain two or more kinds thereof. In a case where two or more kinds thereof are contained, the total amount thereof is preferably within the above range.

<Polymerizable compound>

The resin composition according to the embodiment of the present invention preferably contains a polymerizable compound.
Among the above, the resin composition according to the embodiment of the present invention preferably contains a polymerizable compound having a ring structure.
The ring structure may be an aliphatic ring structure or an aromatic ring structure, or may be a ring structure of a combination of these structures. However, it is preferable to include an aliphatic ring structure.
The aromatic ring structure may be an aromatic hydrocarbon ring structure or an aromatic heterocycle structure; however, it is preferably an aromatic hydrocarbon ring structure and more preferably a benzene ring structure.
The aliphatic ring structure may be an aliphatic hydrocarbon ring structure or an aliphatic heterocycle structure; however, it is preferably an aliphatic hydrocarbon ring structure.
Specific examples of the ring structure included in the polymerizable compound that includes a ring structure include a cyclohexane ring, a norbornene ring, an isonorbornene ring, a dicyclopentane ring, an adamantane ring, a polyphenyl ring, a fluorene ring, and an acenaphthyl ring.
The number of ring structures included in the polymerizable compound having a ring structure is preferably 1 to 6, more preferably 1 to 4, and still more preferably 1 or 2.
Examples of the polymerizable group in the polymerizable compound having a ring structure include a group having an ethylenically unsaturated bond, an alkoxymethyl group, a hydroxymethyl group, an acyloxymethyl group, an epoxy group, an oxetanyl group, and a benzoxazolyl group, where a group having an ethylenically unsaturated bond is preferable.
Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, a (meth)acrylamide group, and a (meth)acryloyloxy group, where a (meth)acryloyloxy group is preferable.
The number of polymerizable groups in the polymerizable compound having a ring structure is preferably 1 to 10, more preferably 1 to 6, still more preferably 1 or 2, and particularly preferably 2.
In addition, the resin composition according to the present invention preferably contains a polymerizable compound in which a glass transition temperature of a homopolymer is 200°C or higher.
The glass transition temperature (Tg) of the homopolymer is measured, for example, with a differential scanning calorimeter (DSC) in accordance with ASTM D3418-8. It is noted that although the glass transition temperature (Tg) changes depending on the molecular weight, the variation in Tg due to the molecular weight can be ignored in a case where the weight-average molecular weight is 10,000 or more.
The glass transition temperature thereof is preferably 210°C or higher and more preferably 220°C or higher. In addition, the lower limit of the glass transition temperature is not particularly limited; however, it can be set to, for example, 350°C or lower.
In a case of containing a polymerizable compound having such a high glass transition temperature, it is possible to reduce the cyclization rate of the polyimide at the time of the formation of the polyimide-containing precursor portion, which makes it easy to adjust a difference in the cyclization rate with respect to the polyimide-containing portion to be obtained after the subsequent bonding step.
Examples of the polymerizable compound include a radical crosslinking agent and another crosslinking agent.

[Radical crosslinking agent]

The resin composition according to the embodiment of the present invention preferably contains a radical crosslinking agent.
The radical crosslinking agent is a compound having a radically polymerizable group. The radically polymerizable group is preferably a group containing an ethylenically unsaturated bond. Examples of the group containing the ethylenically unsaturated bond include groups having an ethylenically unsaturated bond, such as a vinyl group, an allyl group,

a vinylphenyl group, a (meth)acryloyl group, a maleimide group, and a (meth)acrylamide group.

Among these, the group containing an ethylenically unsaturated bond is preferably a (meth)acryloyl group, a (meth)acrylamide group, or a vinylphenyl group, and more preferably a (meth)acryloyl group from the viewpoint of reactivity.

The radical crosslinking agent is preferably a compound having one or more ethylenically unsaturated bonds; however, a compound having two or more ethylenically unsaturated bonds is more preferable. The radical crosslinking agent may have three or more ethylenically unsaturated bonds.

The compound having 2 or more ethylenically unsaturated bonds is preferably a compound having 2 to 15 ethylenically unsaturated bonds, more preferably a compound having 2 to 10 ethylenically unsaturated bonds, and still more preferably a compound having 2 to 6 ethylenically unsaturated bonds.

In addition, from the viewpoint of the film hardness of the pattern (cured substance) to be obtained, the photocurable resin composition according to the embodiment of the present invention preferably contains a compound having two ethylenically unsaturated bonds and a compound having three or more ethylenically unsaturated bonds.

The molecular weight of the radical crosslinking agent is preferably 2,000 or less, more preferably 1,500 or less, and still more preferably 900 or less. The lower limit of the molecular weight of the radical crosslinking agent is preferably 100 or more.

Specific examples of the radical crosslinking agent include unsaturated carboxylic acids (for example, acrylic acid, methacrylic acid, itaconic acid, crotonic acid, isocrotonic acid, and maleic acid), and esters and amides thereof, and esters formed from unsaturated carboxylic acids and polyhydric alcohol compounds or amides formed from unsaturated carboxylic acids and polyvalent amine compounds are preferable. In addition, addition reaction products produced by reacting unsaturated carboxylic acid esters or amides, having a nucleophilic substituent such as a hydroxy group, an amino group, or a sulfanyl group, with monofunctional or polyfunctional isocyanates or epoxies, dehydration condensation reaction products produced by reacting the above esters or amides with a monofunctional or polyfunctional carboxylic acid, or the like are also suitably used. In addition, an addition reaction product produced by reacting unsaturated carboxylic acid esters or amides, having an electrophilic substituent such as an isocyanate group or an epoxy group, with monofunctional or polyfunctional alcohols, amines, or thiols, and In addition, a substitution reaction product produced by reacting unsaturated carboxylic acid esters or amides, having an eliminable substituent such as a halogen group or a tosyloxy group, with monofunctional or polyfunctional alcohols, amines, or thiols is also suitable. In addition, as other examples, it is also possible to use a group of compounds in which the unsaturated carboxylic acid described above is replaced with an unsaturated phosphonic acid, a vinylbenzene derivative such as styrene, a vinyl ether, an allyl ether, or the like. Regarding the specific examples thereof, reference can be made to the description of paragraphs 0113 to 0122 of JP2016-027357A, the content of which is incorporated in the present specification.

In addition, the radical crosslinking agent is also preferably a compound having a boiling point of 100°C or higher under atmospheric pressure. Examples of the compound having a boiling point of 100°C or higher under normal pressure include the compounds described in paragraph 0203 of WO2021/112189A. The content thereof is incorporated in the present specification.

Preferred examples of the preferred radical crosslinking agent other than those described above include the radically polymerizable compounds described in paragraphs 0204 to 0208 of WO2021/112189A. The content thereof is incorporated in the present specification.

As the radical crosslinking agent, dipentaerythritol triacrylate (as a commercially available product, KAYARAD D-330 (manufactured by Nippon Kayaku Co., Ltd.), dipentaerythritol tetraacrylate (as a commercially available product, KAYARAD D-320 (manufactured by Nippon Kayaku Co., Ltd.), A-TMMT (manufactured by Shin-Nakamura Chemical Co., Ltd.), dipentaerythritol penta(meth)acrylate (as a commercially available product, KAYARAD D-310 (manufactured by Nippon Kayaku Co., Ltd.), dipentaerythritol hexa(meth)acrylate (as a commercially available product, KAYARAD DPHA (manufactured by Nippon Kayaku Co., Ltd.), A-DPH (manufactured by Shin-Nakamura Chemical Co., Ltd.), or a structure in which a (meth)acryloyl group thereof is bonded through an ethylene glycol residue or a propylene glycol residue is preferable. Oligomer types thereof can also be used.

Examples of the commercially available product of the radical crosslinking agent include SR-494 which is a tetrafunctional acrylate having four ethyleneoxy chains, manufactured by Sartomer Company Inc., SR-209, 231, and 239 which are a difunctional methacrylate having four ethyleneoxy chains, manufactured by Sartomer Company Inc., DPCA-60 which is a hexafunctional acrylate having six pentyleneoxy chains, manufactured by Nippon Kayaku Co., Ltd., TPA-330 which is a trifunctional acrylate having three isobutylene oxy chains, a urethane oligomer UAS-10, UAB-140 (manufactured by Nippon Paper Industries Co., Ltd.), NK Ester M-40G, NK Ester 4G, NK Ester M-9300, NK Ester A-9300, UA-7200 (manufactured by Shin-Nakamura Chemical Co., Ltd.), DPHA-40H (manufactured by Nippon Kayaku Co., Ltd.), UA-306H, UA-306T, UA-306I, AH-600, T-600, AI-600 (manufactured by KYOEISHA CHEMICAL Co., Ltd.), and Brenmer PME400 (manufactured by NOF Corporation).

As the radical crosslinking agent, the urethane acrylates as described in JP1973-041708B (JP-S48-041708B), JP1976-037193A(JP-S51-037193A), JP1990-032293B (JP-H02-032293B), and JP1990-016765B (JP-H02-016765B),

and the urethane compounds having an ethylene oxide-based skeleton described in JP1983-049860B (JP-S58-049860B), JP1981-017654B (JP-S56-017654B), JP1987-039417B (JP-S62-039417B), and JP1987-039418B (JP-S62-039418B) are also suitable. Further, as the radical crosslinking agent, the compounds having an amino structure or a sulfide structure in a molecule as described in JP1988-277653A (JP-S63-277653A), JP1988-260909A (JP-S63-260909A), and JP1989-105238A (JP-H01-105238A) can also be used.

The radical crosslinking agent may be a radical crosslinking agent having an acid group such as a carboxy group or a phosphoric acid group. The radical crosslinking agent having an acid group is preferably an ester of an aliphatic polyhydroxy compound and an unsaturated carboxylic acid and more preferably a radical crosslinking agent obtained by reacting an unreacted hydroxy group of an aliphatic polyhydroxy compound with a non-aromatic carboxylic acid anhydride to have an acid group. The radical crosslinking agent is particularly preferably a compound in which an aliphatic polyhydroxy compound is pentaerythritol or dipentaerythritol in a radical crosslinking agent having an acid group obtained by reacting an unreacted hydroxy group of the aliphatic polyhydroxy compound with a non-aromatic carboxylic acid anhydride. Examples of the commercially available product thereof include M-510 and M-520 as polybasic acid-modified acrylic oligomers which are manufactured by Toagosei Co., Ltd.

The acid value of the radical crosslinking agent having an acid group is preferably 0.1 to 300 mgKOH/g, and particularly preferably 1 to 100 mgKOH/g. In a case where the acid value of the radical crosslinking agent is within the above-described range, excellent manufacturing handleability is exhibited, and furthermore, excellent developability is exhibited. In addition, good polymerization properties are exhibited. The acid value is measured according to the description of JIS K 0070: 1992.

In the resin composition, it is preferable to use difunctional methacrylate or acrylate from the viewpoint of pattern resolution and film elasticity.

As the specific compound, the following compound can be used; triethylene glycol diacrylate, triethylene glycol dimethacrylate, tetraethylene glycol dimethacrylate, tetraethylene glycol diacrylate, and polyethylene glycol (PEG) 200 diacrylate, PEG 200 dimethacrylate, PEG 600 diacrylate, PEG 600 dimethacrylate, polytetraethylene glycol diacrylate, polytetraethylene glycol dimethacrylate, neopentyl glycol diacrylate, neopentyl glycol dimethacrylate, 3-methyl-1, 5-pentanediol diacrylate, 1,6-hexanediol diacrylate, 1,6-hexanediol dimethacrylate, dimethylol-tricyclodecanediacrylate, dimethylol-tricyclodecanedimethacrylate, a diacrylate of an ethylene oxide (EO) adduct of bisphenol A, a dimethacrylate of an EO adduct of bisphenol A, a diacrylate of a propylene oxide (PO) adduct of bisphenol A, a dimethacrylate of a PO adduct of bisphenol A, 2-hydroxy-3-acryloyloxypropyl methacrylate, isocyanuric acid EO-modified diacrylate, isocyanuric acid-modified dimethacrylate, another difunctional acrylate having a urethane bond, and difunctional methacrylate having a urethane bond. As necessary, two or more of these can be mixedly used.

It is noted that, for example, the PEG 200 diacrylate refers to a polyethylene glycol diacrylate having a polyethylene glycol chain formula weight of about 200.

In the photocurable resin composition according to the embodiment of the present invention, a monofunctional radical crosslinking agent can be preferably used as the radical crosslinking agent from the viewpoint of suppressing warping associated with the control of the elastic modulus of the pattern (cured substance). As the monofunctional radical crosslinking agent, (meth)acrylic acid derivatives such as n-butyl (meth)acrylate, 2-ethylhexyl (meth)acrylate, 2-hydroxyethyl (meth)acrylate, butoxyethyl (meth)acrylate, carbitol (meth)acrylate, cyclohexyl (meth)acrylate, benzyl (meth)acrylate, phenoxyethyl (meth)acrylate, N-methylol (meth)acrylamide, glycidyl (meth)acrylate, polyethylene glycol mono(meth)acrylate, and polypropylene glycol mono(meth)acrylate, N-vinyl compounds such as N-vinylpyrrolidone and N-vinylcaprolactam, allyl glycidyl ethers, and the like are preferably used. As the monofunctional radical crosslinking agent, a compound having a boiling point of 100°C or higher under atmospheric pressure is also preferable in order to suppress volatilization before exposure.

In addition, examples of the difunctional or higher functional radical crosslinking agent include allyl compounds such as diallyl phthalate and triallyl trimellitate.

In a case where a radical crosslinking agent is contained, the content thereof is preferably more than 0% by mass and 60% by mass or less with respect to the total solid content of the photocurable resin composition according to the embodiment of the present invention. The lower limit thereof is more preferably 5% by mass or more. An upper limit thereof is more preferably 50% by mass or less and still more preferably 30% by mass or less.

One kind of radical crosslinking agent may be used alone, or two or more kinds thereof may be mixedly used. In a case where two or more kinds thereof are used in combination, the total amount thereof is preferably in the above range.

[Another crosslinking agent]

The photocurable resin composition according to the embodiment of the present invention also preferably contains another crosslinking agent different from the radical crosslinking agent described above.

In the present invention, the other crosslinking agent refers to a crosslinking agent other than the above-described radically crosslinking agent, where it is preferably a compound having a plurality of groups, in the molecule, which accelerates a reaction of forming a covalent bond between other compounds in the composition or reaction products thereof, by the photosensitization of the above-described photoacid generator photobase generator, and it is more preferably a compound having a plurality of groups, in the molecule, which accelerates a reaction of forming a covalent bond between other compounds in the composition or reaction products thereof, by the action of the acid or the base.

The acid or base is preferably an acid or base generated from a photoacid generator photobase generator in the exposure step.

The other crosslinking agent is preferably a compound having at least one group selected from the group consisting of an acyloxymethyl group, a methylol group, an ethylol group, and an alkoxymethyl group, and more preferably a compound having a structure in which at least one group selected from the group consisting of an acyloxymethyl group, a methylol group, an ethylol group, and an alkoxymethyl group is directly bonded to a nitrogen atom.

Examples of the other crosslinking agent include a compound having a structure in which formaldehyde, or formaldehyde and alcohol are reacted with an amino group-containing compound such as melamine, glycoluril, urea, an alkylene urea, or benzoguanamine to substitute a hydrogen atom of the amino group with an acyloxymethyl group, a methylol group, an ethylol group, or an alkoxymethyl group. The production method for these compounds is not particularly limited, and any compound having the same structure as the compound produced by the above method may be used. In addition, oligomers formed by the self-fusion of the methylol groups of these compounds may be used.

As the above amino group-containing compound, the crosslinking agent in which melamine is used is referred to as a melamine-based crosslinking agent, the crosslinking agent in which glycoluril, urea, or an alkylene urea is used is referred to a urea-based crosslinking agent, the crosslinking agent in which an alkylene urea is used is referred to as an alkylene urea-based crosslinking agent, and the crosslinking agent in which benzoguanamine is used is referred to as a benzoguanamine-based crosslinking agent.

Among these, the photocurable resin composition according to the embodiment of the present invention preferably contains at least one compound selected from the group consisting of a urea-based crosslinking agent and a melamine-based crosslinking agent and more preferably contains at least one compound selected from the group consisting of a glycoluril-based crosslinking agent described later and a melamine-based crosslinking agent.

Examples of the compound containing at least one of the alkoxymethyl group or the acyloxymethyl group in the present invention include, as a structural example, a compound in which an alkoxymethyl group or an acyloxymethyl group is directly substituted on an aromatic group or the nitrogen atom of the following urea structure, or on triazine.

The alkoxymethyl group or acyloxymethyl group contained in the above compound preferably has 2 to 5 carbon atoms, more preferably 2 or 3 carbon atoms, and still more preferably 2 carbon atoms.

The total number of alkoxymethyl groups and acyloxymethyl groups contained in the above compound is preferably 1 to 10, more preferably 2 to 8, and particularly preferably 3 to 6.

The molecular weight of the above compound is preferably 1,500 or less and more preferably 180 to 1,200.

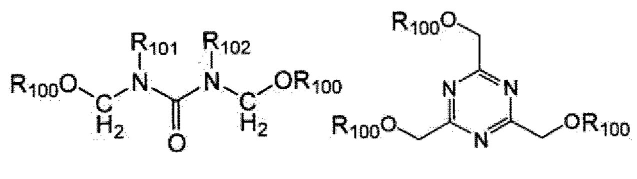

$R_{100}$ represents an alkyl group or an acyl group.

$R_{101}$ and $R_{102}$ each independently represent a monovalent organic group, and they may be bonded to each other to form a ring.

Examples of the compound in which an alkoxymethyl group or an acyloxymethyl group is directly substituted on an aromatic group include compounds such as those represented by the following general formulae.

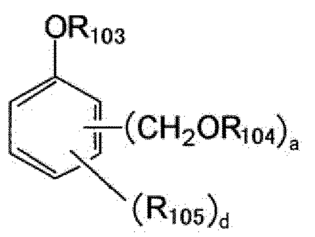

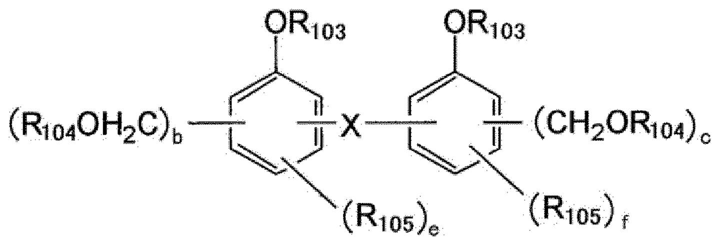

In the formula, X represents a single-bonded or divalent organic group, each $R_{104}$ independently represents

an alkyl or acyl group, and $R_{103}$ represents a hydrogen atom, an alkyl group, an alkenyl group, an aryl group, an aralkyl group, or a group that decomposes under the action of acid and generates an alkali-soluble group (for example, a group that is eliminated by under the action of acid, a group represented by $-C(R^4)_2COOR^5$ (each $R^4$ independently represents a hydrogen atom or an alkyl group having 1 to 4 carbon atoms, and $R^5$ represents a group eliminated under the action of acid)).

Each $R_{105}$ independently represents an alkyl group or an alkenyl group, a, b, and c are each independently 1 to 3, d is 0 to 4, e is 0 to 3, and f is 0 to 3, where a + d is 5 or less, b + e is 4 or less, and c + f is 4 or less.

Examples of $R^5$ in the group that decomposes under the action of an acid to generate an alkali-soluble group, a group that is eliminated under the action of acid, and a group represented by $-C(R^4)_2COOR^5$, include $-C(R_{36})(R_{37})(R_{38})$, $-C(R_{36})(R_{37})(OR_{39})$, and $-C(R_{01})(R_{02})(OR_{39})$.

In the formulae, $R_{36}$ to $R_{39}$ each independently an alkyl group, a cycloalkyl group, an aryl group, an aralkyl group, or an alkenyl group. $R_{36}$ and $R_{37}$ may be bonded to each other to form a ring.

The alkyl group is preferably an alkyl group having 1 to 10 carbon atoms and more preferably an alkyl group having 1 to 5 carbon atoms.

The alkyl group may be either linear or branched.

The cycloalkyl group is preferably a cycloalkyl group having 3 to 12 carbon atoms and more preferably a cycloalkyl group having 3 to 8 carbon atoms.

The cycloalkyl group may have a monocyclic structure or a polycyclic structure such as a fused ring.

The aryl group is preferably an aromatic hydrocarbon group having 6 to 30 carbon atoms and more preferably a phenyl group.

As the aralkyl group, an aralkyl group having 7 to 20 carbon atoms is preferable, and an aralkyl group having 7 to 16 carbon atoms is more preferable.

The above-described aralkyl group is intended to be an aryl group substituted with an alkyl group, and preferred aspects of these alkyl group and aryl group are respectively the same as the above-described preferred aspects of the alkyl group and the aryl group.

The alkenyl group is preferably an alkenyl group having 3 to 20 carbon atoms and more preferably an alkenyl group having 3 to 16 carbon atoms.

In addition, these groups may further have a publicly known substituent within the scope in which the effect of the present invention is obtained.

$R_{01}$ and $R_{02}$ each independently represent a hydrogen atom, an alkyl group, a cycloalkyl group, an aryl group, an aralkyl group, or an alkenyl group.

The group that decomposes under the action of an acid to generate an alkali-soluble group or the group that is eliminated under the action of an acid is preferably a tertiary alkyl ester group, an acetal group, a cumyl ester group, an enol ester group, or the like. It is more preferably a tertiary alkyl ester group or an acetal group.

In addition, a compound having at least one group selected from the group consisting of a urea bond and a urethane bond is also preferable as the compound having at least one group selected from the group consisting of an acyloxymethyl group, a methylol group, an ethylol group, and an alkoxymethyl group. A preferred aspect of the above-described compound is the same as the preferred aspect of the crosslinking agent U described above, except that the polymerizable group is not a radically polymerizable group but at least one group selected from the group consisting of an acyloxymethyl group, a methylol group, an ethylol group, and an alkoxymethyl group.

Specific examples of the compound having at least one group selected from the group consisting of an acyloxymethyl group, a methylol group, and an ethylol group include the following structures. Examples of the compound having an acyloxymethyl group include compounds in which the alkoxymethyl group of the following compounds is changed to an acyloxymethyl group. Examples of the compound having an alkoxymethyl group or acyloxymethyl group in the molecule include, but are not limited to, the following compounds.

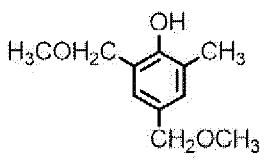 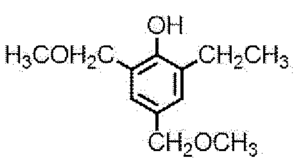 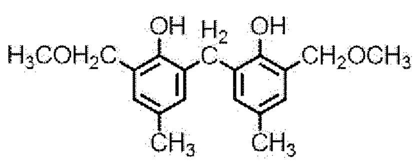

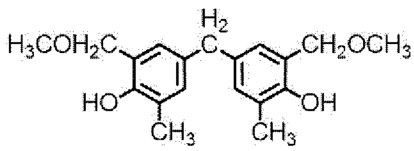
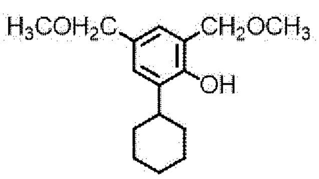
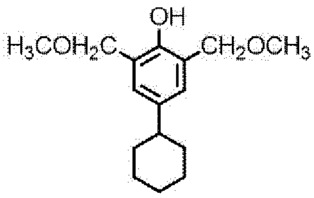

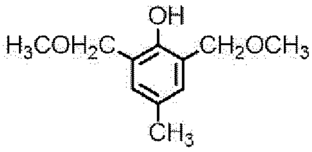
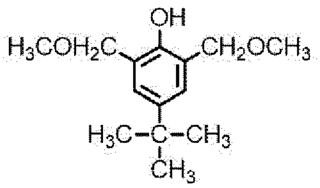
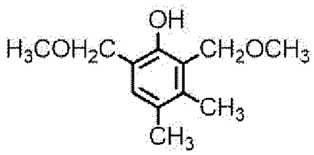

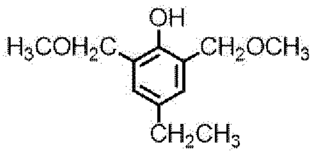
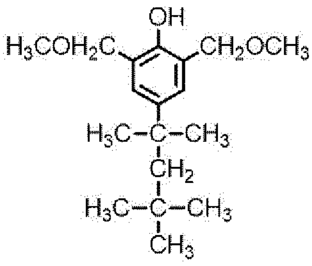
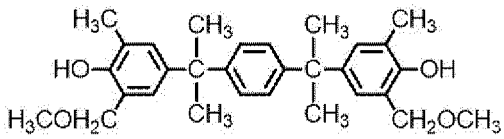

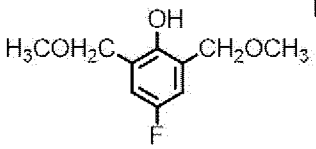
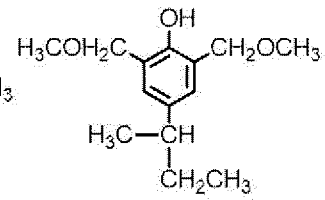
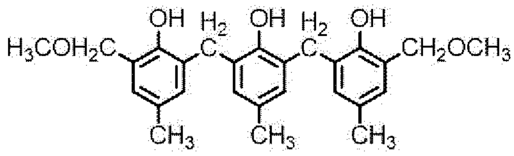

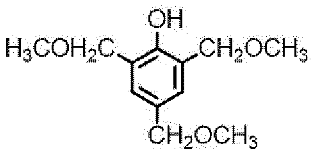
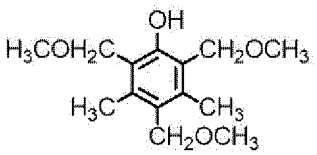
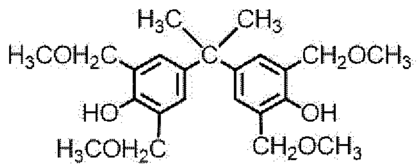

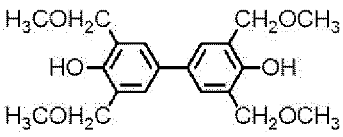
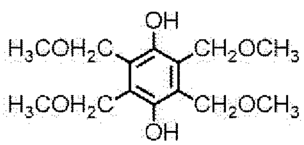
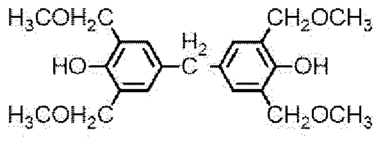

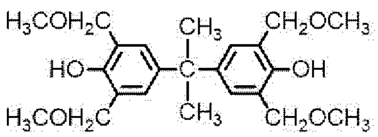
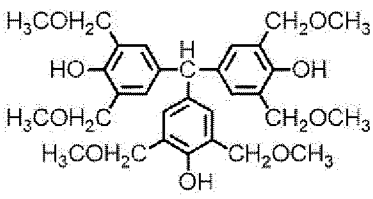
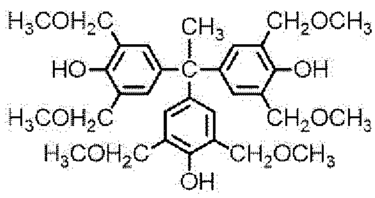

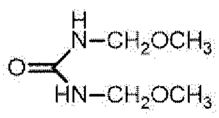

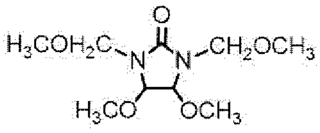

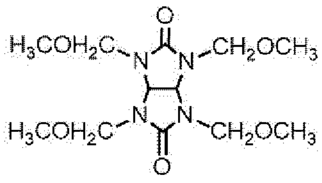

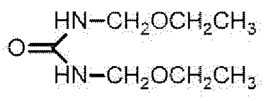

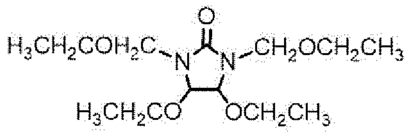

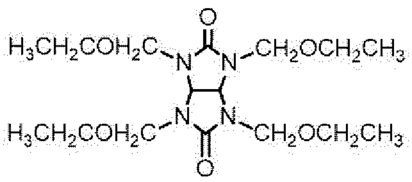

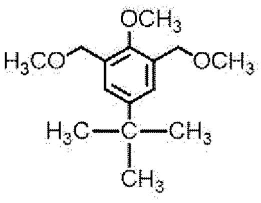

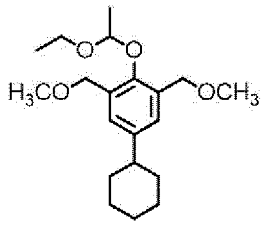

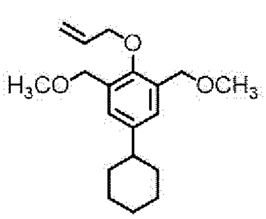

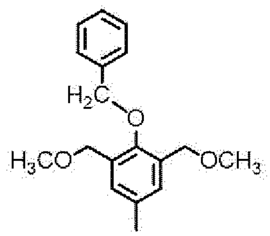

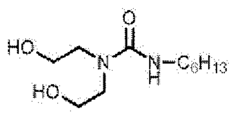

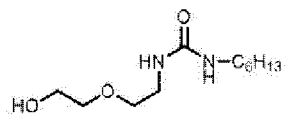

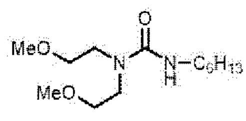

As the compound containing at least one of an alkoxymethyl group and an acyloxymethyl group, a commercially available compound may be used, or a compound synthesized by a publicly known method may be used.

From the viewpoint of heat resistance, a compound in which an alkoxymethyl group or an acyloxymethyl group is directly substituted on an aromatic ring or a triazine ring is preferable.

Specific examples of the melamine-based crosslinking agent include hexamethoxymethylmelamine, hexaethoxymethylmelamine, hexapropoxymethylmelamine, and hexabutoxybutylmelamine.

Specific examples of the urea-based crosslinking agent include glycoluril-based crosslinking agents such as monohydroxymethylated glycoluril, dihydroxymethylated glycoluril, trihydroxymethylated glycoluril, tetrahydroxymethylated glycoluril, monomethoxymethylated glycoluril, dimethoxymethylated glycoluril, trimethoxymethylated glycoluril, tetramethoxymethylated glycoluril, monoethoxymethylated glycoluril, diethoxymethylated glycoluril, triethoxymethylated glycoluril, tetraethoxymethylated glycoluril, monopropoxymethylated glycoluril, dipropoxymethylated glycoluril, tripropoxymethylated glycoluril, tetrapropoxymethylated glycoluril, monobutoxymethylated glycoluril, dibutoxymethylated glycoluril, tributoxymethylated glycoluril, and tetrabutoxymethylated glycoluril;

urea-based crosslinking agents such as bismethoxymethylurea, bisethoxymethylurea, bispropoxymethylurea, and bisbutoxymethylurea,

ethyleneurea-based crosslinking agents such as monohydroxymethylated ethylene urea or dihydroxymethylated ethylene urea, monomethoxymethylated ethylene urea, dimethoxymethylated ethylene urea, monoethoxymethylated ethylene urea, diethoxymethylated ethylene urea, monopropoxymethylated ethylene urea, dipropoxymethylated ethylene urea, monobutoxymethylated ethylene urea, and dibutoxymethylated ethylene urea,

propylene urea-based crosslinking agents such as monohydroxymethylated propylene urea, dihydroxymethylated propylene urea, monomethoxymethylated propylene urea, dimethoxymethylated propylene urea, monoethoxymethylated propylene urea, diethoxymethylated propylene urea, monopropoxymethylated propylene urea, dipropoxymethylated propylene urea, monobutoxymethylated propylene urea, and dibutoxymethylated propylene urea, and

1,3-di(methoxymethyl)-4,5-dihydroxy-2-imidazolidinone, and 1,3-di(methoxymethyl)-4,5-dimethoxy-2-imidazolidinone.

Specific examples of the benzoguanamine-based crosslinking agent include monohydroxymethylated benzoguanamine, dihydroxymethylated benzoguanamine, trihydroxymethylated benzoguanamine, tetrahydroxymethylated benzoguanamine, monoethoxymethylated benzoguanamine, diethoxymethylated benzoguanamine, triethoxymethylated benzoguanamine, tetramethoxymethylated benzoguanamine, monoethoxymethylated benzoguanamine, diethoxymethylated benzoguanamine, triethoxymethylated benzoguanamine, tetraethoxymethylated benzoguanamine, monopropoxymethylated benzoguanamine, dipropoxymethylated benzoguanamine, tripropoxymethylated benzoguanamine, tetrapropoxymethylated benzoguanamine, monobutoxymethylated benzoguanamine, dibutoxymethylated benzoguanamine, tributoxymethylated benzoguanamine, and tetrabutoxymethylated benzoguanamine.

In addition, as the compound having at least one group selected from the group consisting of a methylol group and an alkoxymethyl group, a compound in which at least one group selected from the group consisting of a methylol group and an alkoxymethyl group is directly bonded to an aromatic ring (preferably a benzene ring) can also be suitably used.

Specific examples of such compounds include benzenedimethanol, bis(hydroxymethyl)cresol, bis(hydroxymethyl)dimethoxybenzene, bis(hydroxymethyl)diphenyl ether, bis(hydroxymethyl)benzophenone, hydroxymethylphenyl hydroxymethylbenzoate, bis(hydroxymethyl)biphenyl, dimethylbis(hydroxymethyl)biphenyl, bis(methoxymethyl)benzene, bis(methoxymethyl)cresol, bis(methoxymethyl)dimethoxybenzene, bis(methoxymethyl)diphenyl ether, bis(methoxymethyl)benzophenone, methoxymethylphenyl methoxymethylbenzoate, bis(methoxymethyl)biphenyl, dimethylbis(methoxymethyl)biphenyl, 4,4',4"-ethylidenetris[2,6-bis(methoxymethyl)phenol], 5, 5'-[2,2,2-trifluoro-1-(trifluoromethyl)ethylidene]bis[2-hydroxy-1,3-benzenedimethanol], and 3,3',5,5'-tetrakis(methoxymethyl)-1,1'-biphenyl-4,4'-diol.

As the other crosslinking agent, a commercially available product may be used, and examples of the suitable commercially available product include 46DMOC and 46DMOEP (all of which are manufactured by ASAHI YUKIZAI Corporation), DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DML-BisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, and HMOM-TPHAP (all of which are manufactured by Honshu Chemical Industry Co., Ltd.), and NIKALAC (registered trademark, the same applies hereinafter) MX-290, NIKALAC MX-280, NIKALAC MX-270, NIKALAC MX-279, NIKALAC MW-100LM, and NIKALAC MX-750LM (all of which are manufactured by Sanwa Chemical Co., Ltd.).

In addition, the resin composition according to the embodiment of the present invention preferably contains, as the other crosslinking agent, at least one compound selected from the group consisting of an epoxy compound, an oxetane compound, and a benzoxazine compound.

- Epoxy compound (compound having epoxy group) -

The epoxy compound is preferably a compound having two or more epoxy groups in one molecule. Since the epoxy group undergoes a crosslinking reaction at 200°C or lower and a dehydration reaction derived from crosslinking does not occur, film shrinkage hardly occurs. Therefore, containing an epoxy compound is effective for the low-temperature curing of the resin composition according to the embodiment of the present invention and the suppression of warping.

The epoxy compound preferably contains a polyethylene oxide group. As a result, it is possible to further decrease the elastic modulus and suppress the warping. The polyethylene oxide group means a group in which the number of repeating units of ethylene oxide is 2 or higher, and the number of repeating units is preferably 2 to 15.

Examples of the epoxy compound include a bisphenol A type epoxy resin; a bisphenol F type epoxy resin; an alkylene glycol type epoxy resin or a polyhydric alcohol hydrocarbon type epoxy resin, such as propylene glycol diglycidyl ether, neopentyl glycol diglycidyl ether, ethylene glycol diglycidyl ether, butylene glycol diglycidyl ether, hexamethylene glycol diglycidyl ether, or trimethylolpropane triglycidyl ether; a polyalkylene glycol type epoxy resin such as polypropylene glycol diglycidyl ether; and an epoxy group-containing silicone such as polymethyl (glycidyloxypropyl)siloxane; however, the epoxy compound is not limited thereto. Specific examples thereof include EPICLON (registered trademark) 850-S, EPICLON (registered trademark) HP-4032, EPICLON (registered trademark) HP-7200, EPICLON (registered trademark) HP-820, EPICLON (registered trademark) HP-4700, EPICLON (registered trademark) HP-4770, EPICLON (registered trademark) EXA-830LVP, EPICLON (registered trademark) EXA-8183, EPICLON (registered trademark) EXA-8169, EPICLON (registered trademark) N-660, EPICLON (registered trademark) N-665-EXP-S, EPICLON (registered trademark) N-740 (all, product names, manufactured by DIC Corporation); RIKARESIN (registered trademark) BEO-20E, RIKARESIN (registered trademark) BEO-60E, RIKARESIN (registered trademark) HBE-100, RIKARESIN (registered trademark) DME-100, and RIKARESIN (registered trademark) L-200 (registered trademark, manufactured by New Japan Chemical Co., Ltd.); EP-4003S, EP-4000S, EP-4088S, EP-3950S (all, product names, manufactured by ADEKA Corporation); CELLOXIDE (registered trademark) 2021P, CELLOXIDE (registered trademark) 2081, CELLOXIDE (registered trademark) 2000, EHPE3150, EPOLEAD (registered trademark) GT401, EPOLEAD (registered trademark) PB4700, EPOLEAD (registered trademark) PB3600 (all product names, manufactured by Daicel Corporation); and NC-3000, NC-3000-L, NC-3000-H, NC-3000-FH-75M, NC-3100, CER-3000-L, NC-2000-L, XD-1000, NC-7000L, NC-7300L, EPPN-501H, EPPN-501HY, EPPN-502H, EOCN-1020, EOCN-102S, EOCN-103S, EOCN-104S, CER-1020, EPPN-201, BREN-S, and BREN-10S (all product names, manufactured by Nippon Kayaku Co., Ltd.). In addition, the following compounds are also preferably used.

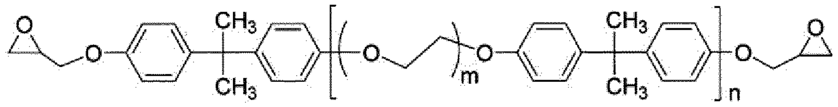

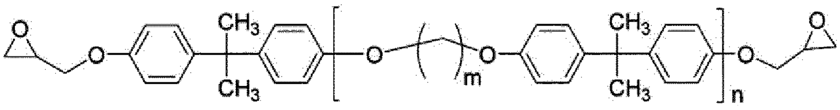

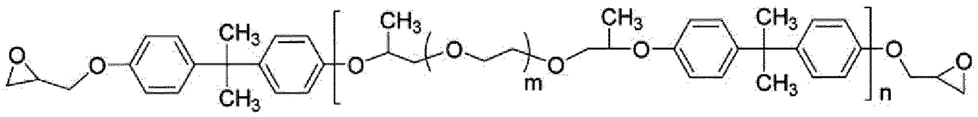

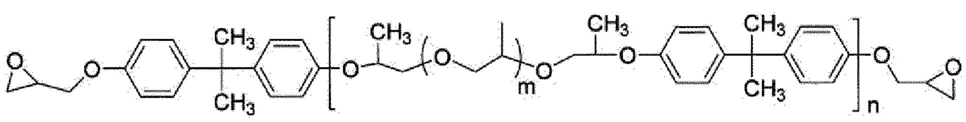

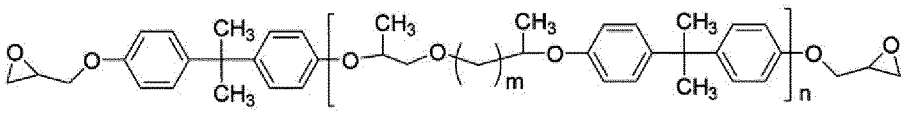

In the formulae, n is an integer of 1 to 5, and m is an integer of 1 to 20.

Among the above structures, n is preferably 1 to 2, and m is preferably 3 to 7 from the viewpoint of achieving both heat resistance and improvement in elongation.

- Oxetane compound (compound having oxetanyl group) -

Examples of the oxetane compound include a compound having two or more oxetane rings in one molecule, 3-ethyl-3-hydroxymethyloxetane, 1,4-bis{[(3-ethyl-3-oxetanyl)methoxy]methyl}benzene, 3-ethyl-3-(2-ethylhexylmethyl)oxetane, and 1,4-benzenedicarboxylic acid-bis[(3-ethyl-3-oxetanyl)methyl]ester. As specific examples thereof, ARON OXETANE series (for example, OXT-121 and OXT-221) manufactured by Toagosei Co., Ltd., can be suitably used, and these can be used alone or two or more thereof may be mixedly used.

- Benzoxazine compound (compound having benzoxazolyl group) -

Due to a crosslinking reaction derived from a ring-opening addition reaction, the benzoxazine compound does not result in degassing during curing and results in decreased heat shrinkage, and thus the occurrence of warping is suppressed, which is preferable.

Preferred examples of the benzoxazine compound include P-d type benzoxazine, F-a type benzoxazine (product names, all of which are manufactured by Shikoku Chemicals Corporation), a benzoxazine adduct of polyhydroxystyrene resin, and a phenol novolak type dihydrobenzoxazine compound. These may be used alone, or two or more thereof may be mixed and used.

The content of the other crosslinking agent is preferably 0.1% to 30% by mass, more preferably 0.1% to 20% by mass, still more preferably 0.5% to 15% by mass, and particularly preferably 1.0% to 10% by mass, with respect to the total solid content of the resin composition according to the embodiment of the present invention. One kind of the other crosslinking agent may be contained, or two or more kinds thereof may be contained. In a case where two or more kinds of the other crosslinking agents are contained, the total thereof is preferably within the above-described range.

[Polymerization initiator]

The resin composition according to the embodiment of the present invention preferably contains a polymerization initiator that is capable of initiating polymerization by light and/or heat. In particular, it is preferable to contain a photopolymerization initiator.

The photopolymerization initiator is preferably a photoradical polymerization initiator. The photoradical polymerization initiator is not particularly limited and can be appropriately selected from publicly known photoradical polymerization initiators. For example, a photoradical polymerization initiator having photosensitivity to rays ranging from an ultraviolet ray range to a visible light range is preferable. In addition, the photoradical polymerization initiator may be an activator that produces an active radical by any action with a photo-excited sensitizing agent.

The photoradical polymerization initiator preferably contains at least one compound having a molar absorption coefficient of at least about 50 $L \cdot mol^{-1} \cdot cm^{-1}$ within a range of a wavelength of about 240 to 800 nm (preferably 330 to 500 nm). The molar absorption coefficient of a compound can be measured using a well-publicly known method. For example, it is preferable to carry out a measurement at a concentration of 0.01 g/L using an ethyl acetate solvent with an ultraviolet-visible spectrophotometer (Cary-5 spectrophotometer manufactured by Varian Medical Systems, Inc.).

As a photoradical polymerization initiator, well-publicly known compounds can be optionally used. Examples thereof include a halogenated hydrocarbon derivative (for example, a compound having a triazine skeleton, a compound having an oxadiazole skeleton, or a compound having a trihalomethyl group), an acylphosphine compound such as an acylphosphine oxide, hexaarylbiimidazole, an oxime compound such as an oxime derivative, an organic peroxide, a thio compound, a ketone compound, an aromatic onium salt, a keto oxime ether, an $\alpha$-amino ketone compound such as aminoacetophenone, an $\alpha$-hydroxy ketone compound such as hydroxyacetophenone, an azo-based compound, an azide compound, a metallocene compound, an organic boron compound, and an iron arene complex. With regard to details thereof, reference can be made to the description of paragraphs 0165 to 0182 of JP2016-027357A and paragraphs 0138 to 0151 ofWO2015/199219A, the contents of which are incorporated in the present specification. In addition, examples thereof include the compounds described in paragraphs 0065 to 0111 of JP2014-130173A and JP6301489B, the peroxide-based photopolymerization initiator described in MATERIAL STAGE 37 to 60 p, vol. 19, No. 3, 2019, the photopolymerization initiator described in WO2018/221177A, the photopolymerization initiator described in WO2018/110179A, the photopolymerization initiator described in JP2019-043864A, the photopolymerization initiator described in JP2019-044030A, and the peroxide-based initiator described in JP2019-167313AA, the contents of which are also incorporated in the present specification.

Examples of the ketone compound include compounds described in paragraph 0087 of JP2015-087611A, the content of which is incorporated in the present specification. As a commercially available product thereof, KAYACURE DETX-S (manufactured by Nippon Kayaku Co., Ltd.) is also suitably used.

In one embodiment according to the present invention, a hydroxyacetophenone compound, an aminoacetophenone compound, and an acylphosphine compound can be suitably used as the photoradical polymerization initiator. More specifically, for example, the aminoacetophenone-based initiator described in JP1998-291969A (JP-H10-291969A) and the acylphosphine oxide-based initiator described in JP4225898B can be used, the contents of which are incorporated in the present specification.

As the $\alpha$-hydroxy ketone-based initiator, Omnirad 184, Omnirad 1173, Omnirad 2959, Omnirad 127 (all of which manufactured by IGM Resins B.V), IRGACURE 184 (IRGACURE is a registered trademark), DAROCUR 1173, IRGACURE 500, and IRGACURE-2959, and IRGACURE 127 (product names: all of which are manufactured by BASF SE) can be used.

As the $\alpha$-amino ketone-based initiator, Omnirad 907, Omnirad 369, Omnirad 369E, Omnirad 379EG (all of which are manufactured by IGM Resins B.V), IRGACURE 907, IRGACURE 369, and IRGACURE 379 (product names: all of which are manufactured by BASF SE) can be used.

As the aminoacetophenone-based initiator, the acylphosphine oxide-based initiator, and the metallocene compound, it is also possible to suitably use, for example, the compounds described in paragraphs 0161 to 0163 of WO2021/112189A. The content thereof is incorporated in the present specification.

Examples of the more preferred photoradical polymerization initiator include an oxime compound. In a case where an oxime compound is used, exposure latitude can be more effectively improved. The oxime compound is particularly preferable since the oxime compound has a wide exposure latitude (a wide exposure margin) and also works as a photocuring accelerator.

Specific examples of the oxime compound include the compounds described in JP2001-233842A, the compounds described in JP2000-080068A, the compounds described in JP2006-342166A, the compounds described in J. C. S. Perkin II (1979, pp. 1653-1660), the compounds described in J. C. S. Perkin II (1979, pp. 156-162), the compounds described in Journal of Photopolymer Science and Technology (1995, pp. 202-232), the compounds described in JP2000-066385A, the compounds described in JP2004-534797A, the compounds described in JP2017-019766A, the compounds described in JP6065596B, the compounds described in WO2015/152153A, the compounds described in

WO2017/051680A, the compounds described in JP2017-198865A, the compounds described in paragraphs 0025 to 0038 of WO2017/164127A, and the compounds described in WO2013/167515A, the content of which is incorporated in the present specification.

Examples of the preferred oxime compound include compounds having the following structures, 3-(benzoyloxy(imino))butan-2-one, 3-(acetoxy(imino))butan-2-one, 3-(propionyloxy(imino))butan-2-one, 2-(acetoxy(imino))pentan-3-one, 2-(acetoxy(imino))-1-phenylpropan-1-one, 2-(benzoyloxy(imino))-1-phenylpropan-1-one, 3-((4-toluenesulfonyloxy)imino)butan-2-one, and 2-(ethoxycarbonyloxy(imino))-1-phenylpropan-1-one. In the resin composition, it is particularly preferable to use an oxime compound (an oxime-based photoradical polymerization initiator) as the photoradical polymerization initiator. The oxime-based photoradical polymerization initiator has a linking group of >C=N-O-C(=O)-in the molecule.

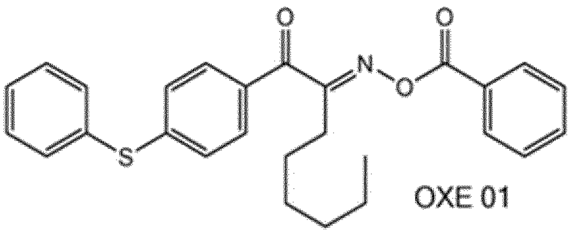
OXE 01

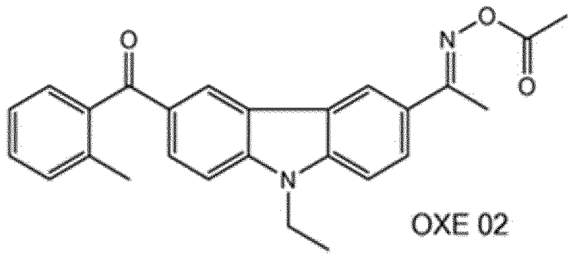
OXE 02

As commercially available products, IRGACURE OXE 01, IRGACURE OXE 02, IRGACURE OXE 03, IRGACURE OXE 04 (all of which are manufactured by BASF SE), ADEKA OPTOMERN-1919 (manufactured by ADEKA Corporation, the photoradical polymerization initiator 2 described in JP2012-014052A) are also suitably used. In addition, TR-PBG-304 and TR-PBG-305 (manufactured by Changzhou Tronly New Electronic Materials Co., Ltd.), ADEKA ARKLS NCI-730, NCI-831, and ADEKAARKLS NCI-930 (manufactured by ADEKA Corporation) can also be used. In addition, DFI-091 (manufactured by DAITO CHEMIX Co., Ltd.) and SpeedCure PDO (manufactured by SARTOMER ARKEMA) can be used. In addition, oxime compounds having the following structures can also be used.

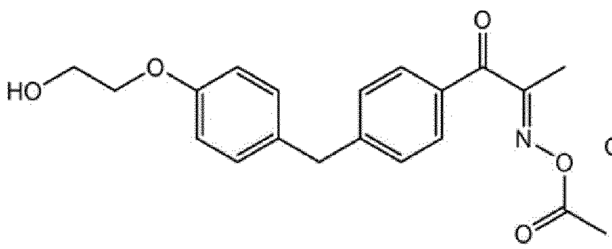

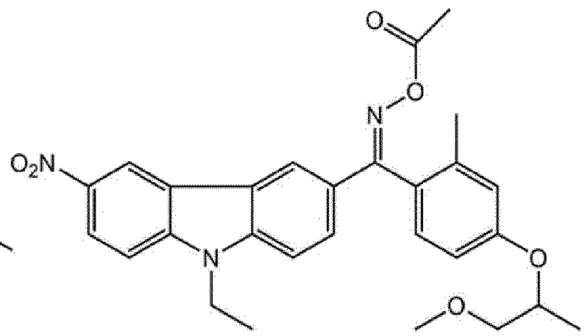

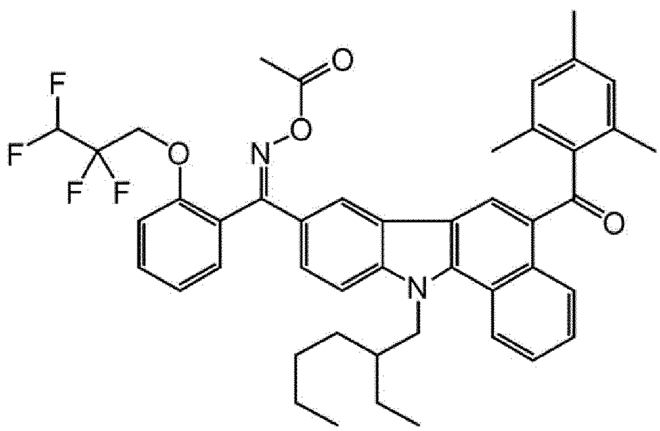

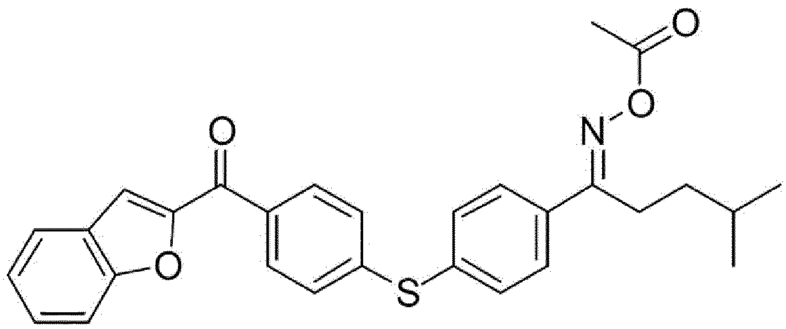

As the photoradical polymerization initiator, it is also possible to use, for example, the oxime compounds having a fluorene ring, which are described in paragraphs 0169 to 0171 of WO2021/112189A, an oxime compound having a skeleton in which at least one benzene ring of a carbazole ring is a naphthalene ring, or an oxime compound having a fluorine atom. The contents of which are incorporated in the present specification.

In addition, as the photopolymerization initiator, it is also possible to use the oxime compounds having a nitro group, which are described in paragraphs 0208 to 0210 of WO2021/020359A, an oxime compound having a benzofuran skeleton, or an oxime compound in which a substituent having a hydroxy group is bonded to a carbazole skeleton. The contents of which are incorporated in the present specification.

As the photopolymerization initiator, an oxime compound having an aromatic ring group $Ar^{OX1}$ in which an electron withdrawing group is introduced into an aromatic ring (hereinafter, also referred to as an oxime compound OX) can also be used. Examples of the electron withdrawing group contained in the aromatic ring group $Ar^{OX1}$ include an acyl group, a nitro group, a trifluoromethyl group, an alkylsulfinyl group, an arylsulfinyl group, an alkylsulfonyl group, an arylsulfonyl group, and a cyano group. Here, an acyl group or a nitro group is preferable, and due to the reason that a film having excellent light resistance is easily formed, an acyl group is more preferable, and a benzoyl group is still more preferable. The benzoyl group may have a substituent. The substituent is preferably a halogen atom, a cyano group, a nitro group, a hydroxy group, an alkyl group, an alkoxy group, an aryl group, an aryloxy group, a heterocyclic group, a heterocyclic oxy group, an alkenyl group, an alkylsulfanyl group, an arylsulfanyl group, an acyl group, or an amino group, more preferably an alkyl group, an alkoxy group, an aryl group, an aryloxy group, a heterocyclic oxy group, an alkylsulfanyl group, an arylsulfanyl group, or an amino group, and still more preferably an alkoxy group, an alkylsulfanyl group, or an amino group.

The oxime compound OX is preferably at least one selected from a compound represented by Formula (OX1) or a compound represented by Formula (OX2), and more preferably a compound represented by Formula (OX2).

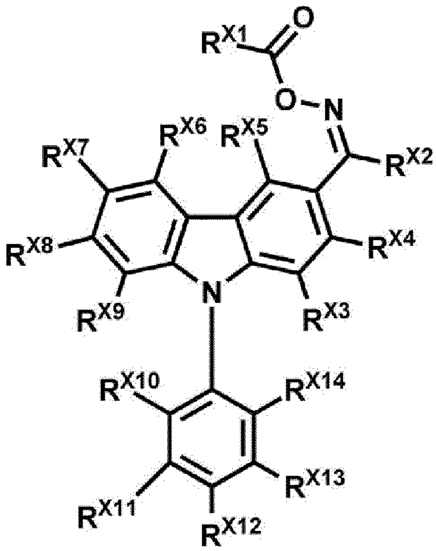

(OX1)

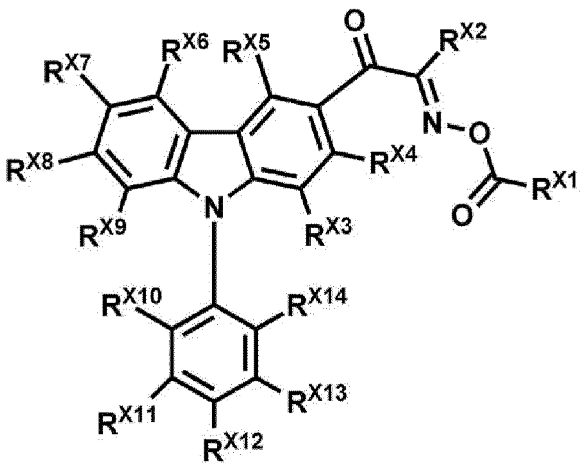

(OX2)

In the formulae, $R^{X1}$ represents an alkyl group, an alkenyl group, an alkoxy group, an aryl group, an aryloxy group, a heterocyclic group, a heterocyclic oxy group, an alkylsulfanyl group, an arylsulfanyl group, an alkylsulfinyl group, an arylsulfinyl group, an alkylsulfonyl group, an arylsulfonyl group, an acyl group, an acyloxy group, an amino group, a phosphinoyl group, a carbamoyl group, or a sulfamoyl group,

$R^{X2}$ represents an alkyl group, an alkenyl group, an alkoxy group, an aryl group, an aryloxy group, a heterocyclic group, or a heterocyclic oxy group, an alkylsulfanyl group, an arylsulfanyl group, an alkylsulfinyl group, an arylsulfinyl group, an alkylsulfonyl group, an arylsulfonyl group, an acyloxy group, or an amino group, and

$R^{X3}$ to $R^{X14}$ each independently represent a hydrogen atom or a substituent.

However, at least one of $R^{X10}$, ..., or $R^{X14}$ is an electron withdrawing group.

In the above formulae, it is preferable that $R^{X12}$ is an electron withdrawing group, and $R^{X10}$, $R^{X11}$, $R^{X13}$, and $R^{X14}$ are a hydrogen atom.

Specific examples of the oxime compound OX include the compounds described in paragraphs 0083 to 0105 of JP4600600B, the content of which is incorporated in the present specification.

Examples of the most preferred oxime compound include the oxime compound having a specific substituent described in JP2007-269779A and the oxime compound having a thioaryl group described in JP2009-191061A, the contents of which are incorporated in the present specification.

From the viewpoint of exposure sensitivity, the photoradical polymerization initiator is preferably a compound selected from the group consisting of a trihalomethyltriazine compound, a benzyl dimethyl ketal compound, an $\alpha$-hydroxy ketone compound, an $\alpha$-amino ketone compound, an acylphosphine compound, a phosphine oxide compound, a metallocene compound, an oxime compound, a triaryl imidazole dimer, an onium salt compound, a benzothiazole compound, a benzophenone compound, an acetophenone compound and a derivative thereof, a cyclopentadiene-benzene-iron complex and a salt thereof, a halomethyl oxadiazole compound, and a 3-aryl substituted coumarin compound.

The photoradical polymerization initiator is more preferably a trihalomethyltriazine compound, an $\alpha$-amino ketone compound, an acylphosphine compound, a phosphine oxide compound, a metallocene compound, an oxime compound, a triaryl imidazole dimer, an onium salt compound, a benzophenone compound, or an acetophenone compound, still more preferably at least one compound selected from the group consisting of a trihalomethyltriazine compound, an $\alpha$-amino ketone compound, a metallocene compound, an oxime compound, a triaryl imidazole dimer, and a benzophenone compound. A metallocene compound or an oxime compound is still more preferably used.

In addition, as the photoradical polymerization initiator, it is also possible to use the compounds described in paragraphs 0175 to 0179 of WO2021/020359A. The content thereof is incorporated in the present specification.

In addition, as the photoradical polymerization initiator, the compounds described in paragraphs 0048 to 0055 of WO2015/125469A can also be used, the content of which is incorporated in the present specification.

As the photoradical polymerization initiator, a photoradical polymerization initiator which is difunctional or trifunctional or higher functional may be used. In a case where such a photoradical polymerization initiator is used, two or more radicals are generated from one molecule of the photoradical polymerization initiator, and thus good sensitivity is obtained. In addition, in a case where a compound having an asymmetric structure is used, the crystallinity is reduced, the solubility in a solvent or the like is improved, and the compound is hardly precipitated over time, and the temporal stability of the resin composition can be improved. Specific examples of the photoradical polymerization initiator which is difunctional or trifunctional or higher functional include dimers of the oxime compounds described in JP2010-527339A, JP2011-524436A, WO2015/004565A, paragraphs 0407 to 0412 of JP2016-532675A, and paragraphs 0039 to 0055 of WO2017/033680A, the compound (E) and compound (G) described in JP2013-522445A, Cmpd 1 to 7 described in WO2016/034963A; the oxime ester photoinitiators described in paragraph 0007 of JP2017-523465A, the photoinitiators described in paragraphs 0020 to 0033 of JP2017-167399A, the photopolymerization initiator (A) described in paragraphs 0017 to 0026 of JP2017-151342A, the oxime ester photoinitiator described in JP6469669B, the contents of which are incorporated in the present specification.

In a case where a photopolymerization initiator is contained, the content thereof is preferably 0.1% to 30% by mass, more preferably 0.1% to 20% by mass, still more preferably 0.5% to 15% by mass, and still more preferably 1.0% to 10% by mass, with respect to the total solid content of the resin composition according to the embodiment of the present invention. Only one kind of photopolymerization initiator may be contained, or two or more kinds thereof may be contained. In a case where two or more kinds of photopolymerization initiators are contained, the total amount thereof is preferably within the above-described range.

It is noted that since the photopolymerization initiator may also function as a thermal polymerization initiator, crosslinking with the photopolymerization initiator may be further promoted by heating an oven, a hot plate, or the like.

[Sensitizing agent]

The resin composition may contain a sensitizing agent. The sensitizing agent absorbs a specific radioactive ray to be in an electronically excited state. The sensitizing agent in the electronically excited state is brought into contact

with a thermal radical polymerization initiator, a photoradical polymerization initiator, or the like, to cause actions such as electron migration, energy transfer, and heat generation. As a result, the thermal radical polymerization initiator the photoradical polymerization initiator undergoes a chemical change and decomposes to generate a radical, an acid, or a base.

In addition, as a usable sensitizing agent, a benzophenone-based, a Michler's ketone-based, a coumarin-based, a pyrazole azo-based, an anilino azo-based, a triphenylmethane-based, an anthraquinone-based, an anthracene-based, an anthrapylidene-based, a benzylidene-based, an oxonol-based, a pyrazolotriazole azo-based, a pyridone azo-based, a cyanine-based, a phenothiazine-based, a pyrrolopyrazole azomethine-based, a xanthene-based, a phthalocyaninebased, a benzopyran-based, and an indigo-based compound can be used.

Examples of the sensitizing agent include, Michler's ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylaminocinnamylidene indanone, p-dimethylamino benzylidene indanone, 2-(p-dimethylaminophenylbiphenylene)-benzothiazole, 2-(p-dimethylaminophenylvinylene)benzothiazole, 2-(p-dimethylaminophenylvinylene)isonaphtothiazole, 1,3-bis(4'-dimethylaminobenzal)acetone, 1,3-bis(4'-diethylaminobenzal)acetone, 3,3'-carbonyl-bis(7-diethylaminocoumarin), 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin (ethyl 7-(diethylamino)coumarin-3-carboxylate), N-phenyl-N'-ethylethanolamine, N-phenyldiethanolamine, N-p-tolyldiethanolamine, N-phenylethanolamine, 4-morpholinobenzophenone, isoamyl dimethylaminobenzoate, isoamyl diethylaminobenzoate, 2-mercaptobenzimidazole, 1-phenyl-5-mercaptotetrazole, 2-mercaptobenzothiazole, 2-(p-dimethylaminostyryl)benzoxazole, 2-(p-dimethylaminostyryl)benzothiazole, 2-(p-dimethylaminostyryl)naphtho (1,2-d)thiazole, 2-(p-dimethylaminobenzoyl)styrene, diphenylacetamide, benzanilide, N-methylacetanilide, and 3',4'-dimethylacetanilide.

In addition, other sensitizing dyes may be used.

For details of the sensitizing dye, reference can be made to the description in paragraphs 0161 to 0163 of JP2016-027357A, the content of which is incorporated in the present specification.

In a case where the resin composition contains a sensitizing agent, the content of the sensitizing agent is preferably 0.01% to 20% by mass, more preferably 0.1% to 15% by mass, and still more preferably 0.5% to 10% by mass, with respect to the total solid content of the resin composition. One kind of sensitizing agent may be used alone, or two or more kinds thereof may be used in combination.

[Chain transfer agent]

The resin composition according to the embodiment of the present invention may contain a chain transfer agent. The chain transfer agent is defined, for example, in Polymer Dictionary, 3rd Edition, pp. 683 to 684 (edited by The Society of Polymer Science, 2005). As the chain transfer agent, for example, the following compound is used; a group of compounds having -S-S-, $-SO_2-S-$, -N-O-, SH, PH, SiH, or GeH in the molecule, or a dithiobenzoate compound, a trithiocarbonate compound, dithiocarbamate, or a xanthate compound, which has a thiocarbonylthio group that is used for the reversible addition fragmentation chain transfer (RAFT) polymerization. These can donate hydrogen to a low active radical to generate a radical or can be oxidized and then deprotonated to generate a radical. In particular, a thiol compound can be preferably used.

In addition, as the chain transfer agent, the compounds described in paragraphs 0152 and 0153 of WO2015/199219A can also be used, the content of which is incorporated in the present specification.

In a case where the resin composition according to the embodiment of the present invention has a chain transfer agent, the content of the chain transfer agent is preferably 0.01 to 20 parts by mass, more preferably 0.1 to 10 parts by mass, and still more preferably 0.5 to 5 parts by mass, with respect to 100 parts by mass of the total solid content of the resin composition according to the embodiment of the present invention. One kind of chain transfer agent may be used, or two or more kinds thereof may be used. In a case where two or more kinds of chain transfer agents are used, the total thereof is preferably within the above-described range.

<Base generator>

The resin composition according to the embodiment of the present invention may contain a base generator. Here, the base generator is a compound that is capable of generating a base under a physical or chemical action. Examples of the preferred base generator for the resin composition according to the embodiment of the present invention include a thermal-base generator and a photobase generator.

In particular, in a case where the resin composition contains a precursor of a cyclization resin, it is preferable that the resin composition contains a base generator. In a case where the resin composition contains a thermal-base generator, it is possible to, for example, accelerate the cyclization reaction of the precursor by heating, whereby the

mechanical properties and chemical resistance of the cured substance are improved and for example, the performance as an interlayer insulating film for a re-distribution layer, included in a semiconductor package, is improved.

The base generator may be an ionic base generator or may be a nonionic base generator. Examples of the base that is generated from the base generator include a secondary amine and a tertiary amine.

The base generator according to the embodiment of the present invention is not particularly limited, and a publicly known base generator can be used. It is possible to use a publicly known base generator, for example, a carbamoyloxime compound, a carbamoylhydroxylamine compound, a carbamic acid compound, a formamide compound, an acetamide compound, a carbamate compound, a benzylcarbamate compound, a nitrobenzylcarbamate compound, a sulfonamide compound, an imidazole derivative compound, an aminimide compound, a pyridine derivative compound, an α-aminoacetophenone derivative compound, a quaternary ammonium salt derivative compound, a pyridinium salt, an α-lactone ring derivative compound, a phthalimide derivative compound, or an acyloxyimino compound.

The nonionic base generator is, for example, preferably the compounds represented by Formula (B1) or Formula (B2), which are described in paragraphs 0275 to 0285 of WO2021/112189A, or the compounds represented by Formula (N1), which is described in paragraphs 0102 to 00162 of WO2020/066416A, and the base generators is preferably the thermal-base generators described in paragraphs 0013 to 0041 of WO2020/054226A.

The contents of which are incorporated in the present specification.

Examples of the thermal base generator include the following examples, but the present invention is not construed as being limited thereto.

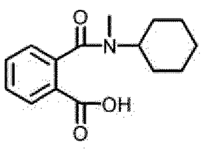
(B-1)

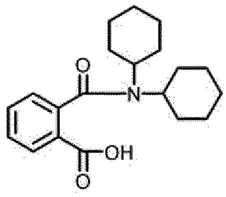
(B-2)

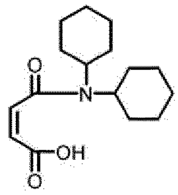
(B-3)

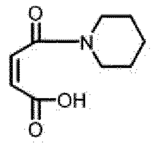
(B-4)

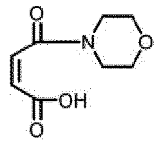
(B-5)

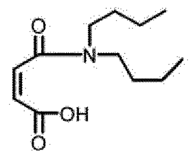
(B-6)

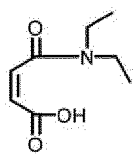
(B-7)

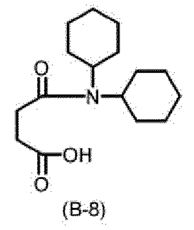
(B-8)

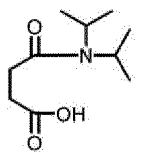
(B-9)

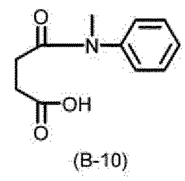
(B-10)

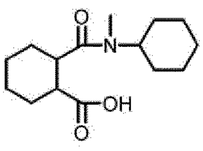
(B-11)

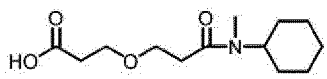
(B-12)

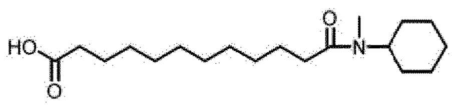
(B-13)

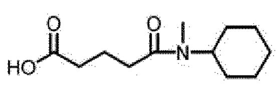
(B-14)

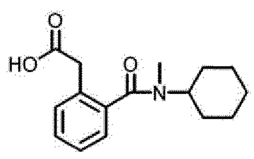
(B-15)

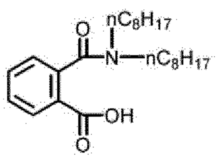
(B-16)

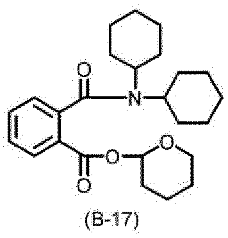
(B-17)

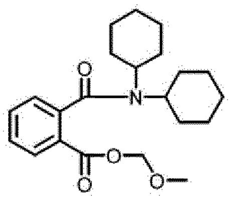
(B-18)

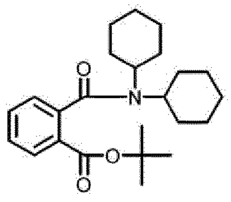
(B-19)

The molecular weight of the nonionic base generator is preferably 800 or less, more preferably 600 or less, and still more preferably 500 or less. The lower limit thereof is preferably 100 or more, more preferably 200 or more, and still more preferably 300 or more.

Examples of the specific preferred compound of the ionic base generator include the compounds described in paragraphs 0148 to 0163 of WO2018/038002A.

Specific examples of the ammonium salt include compounds shown below; however, the present invention is not limited thereto.

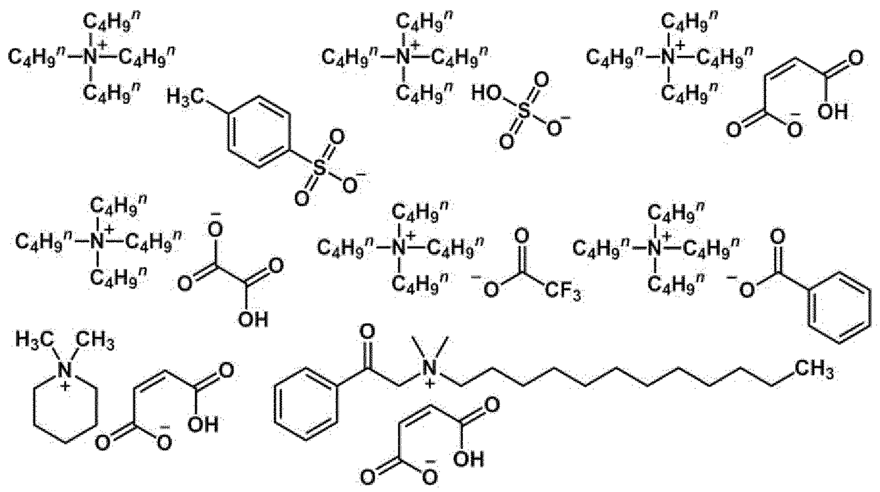

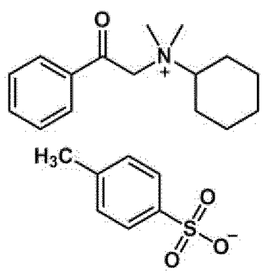

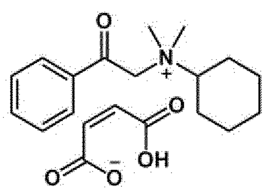

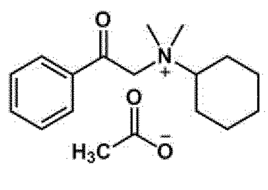

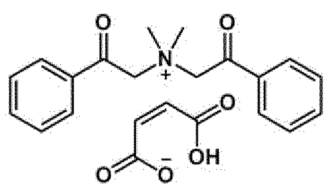

Specific examples of the iminium salt include compounds shown below; however, the present invention is not limited thereto.

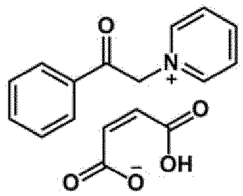
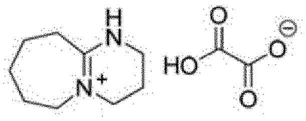
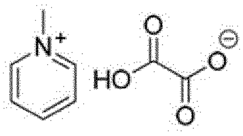

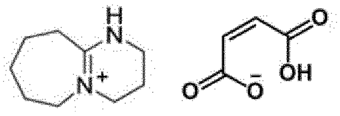
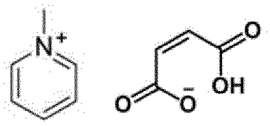

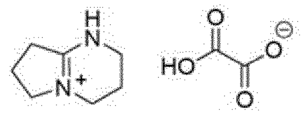
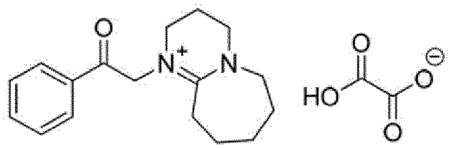

In a case where the resin composition according to the embodiment of the present invention contains a base generator, the content of the base generator is preferably 0.1 to 50 parts by mass with respect to 100 parts by mass of the resin in the resin composition according to the embodiment of the present invention. The lower limit thereof is preferably 0.3 parts by mass or more and more preferably 0.5 parts by mass or more. The upper limit thereof is more preferably 30 parts by mass or less, still more preferably 20 parts by mass or less, and even still more preferably 10 parts by mass or less, and it may be 5 parts by mass or less or may be 4 parts by mass or less.

In addition, an aspect in which the base generator is substantially not contained is also one of the preferred aspects of the present invention. The phrase "substantially not contained" refers to that a content is 0.1% by mass or less with respect to the total solid content of the composition according to the embodiment of the present invention, where 0.01% by mass or less is more preferable.

One kind or two or more kinds of base generators can be used. In a case where two or more kinds thereof are used, the total amount is preferably within the above-described range.

<Solvent>

The resin composition according to the embodiment of the present invention preferably contains a solvent.

As the solvent, any publicly known solvent can be used. The solvent is preferably an organic solvent. Examples of the organic solvent include compounds such as esters, ethers, ketones, cyclic hydrocarbons, sulfoxides, amides, ureas, and alcohols.

Suitable examples of the esters include ethyl acetate, n-butyl acetate, isobutyl acetate, hexyl acetate, amyl formate, isoamyl acetate, butyl propionate, isopropyl butyrate, ethyl butyrate, butyl butyrate, methyl lactate, ethyl lactate, γ-butyrolactone, γ-butyrolactone, ε-caprolactone, δ-valerolactone, alkyl alkyloxyacetate (for example, methyl alkyloxyacetate, ethyl alkyloxyacetate, and butyl alkyloxyacetate (for example, methyl methoxyacetate, ethyl methoxyacetate, butyl methoxyacetate, methyl ethoxy acetate, and ethyl ethoxy acetate)), 3-alkyloxypropionic acid alkyl esters (for example, methyl 3-alkyloxypropionate, and ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (for example, methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methylpropionate and ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, ethyl 2-oxobutanoate, ethyl hexanoate, ethyl heptanoate, dimethyl malonate, and diethyl malonate.

Suitable examples of ethers include ethylene glycol dimethyl ether, diethylene glycol dimethyl ether, diethylene glycol diethyl ether, diethylene glycol ethyl methyl ether, diethylene glycol butyl methyl ether, triethylene glycol dimethyl ether, tetraethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol dimethyl ether, propylene glycol monomethyl ether acetate, propylene glycol monoethyl ether acetate, ethylene glycol monobutyl ether, ethylene glycol monobutyl ether acetate, diethylene glycol ethyl methyl ether, propylene glycol monopropyl ether acetate,

and dipropylene glycol dimethyl ether.

Suitable examples of the ketones include methyl ethyl ketone, cyclohexanone, cyclopentanone, 2-heptanone, 3-heptanone, 3-methylcyclohexanone, levoglucosenone, and dihydrolevoglucosenone.

Suitable examples of the cyclic hydrocarbon include aromatic hydrocarbons such as toluene, xylene, and anisole, and cyclic terpenes such as limonene.

Suitable examples of the sulfoxides include dimethyl sulfoxide.

Suitable examples of the amide include N-methyl-2-pyrrolidone, N-ethyl-2-pyrrolidone, N-cyclohexyl-2-pyrrolidone, N,N-dimethylacetamide, N,N-dimethylformamide, N,N-dimethylisobutylamide, 3-methoxy-N,N-dimethylpropionamide, 3-butoxy-N,N-dimethylpropionamide, N-formylmorpholine, and N-acetylmorpholine.

Suitable examples of the urea include N,N,N',N'-tetramethylurea and 1,3-dimethyl-2-imidazolidinone.

Examples of the alcohols include methanol, ethanol, 1-propanol, 2-propanol, 1-butanol, 1-pentanol, 1-hexanol, benzyl alcohol, ethylene glycol monomethyl ether, 1-methoxy-2-propanol, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenyl carbinol, n-amyl alcohol, methylamyl alcohol, and diacetone alcohol.

From the viewpoint of improving the properties of a coated surface or the like, it is also preferable to mix two or more kinds of solvents.

In the present invention, the solvent is preferably one solvent selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, γ-butyrolactone, 3-methoxy-N,N-dimethylpropionamide, dimethyl sulfoxide, ethyl carbitol acetate, butyl carbitol acetate, N-methyl-2-pyrrolidone, propylene glycol methyl ether, and propylene glycol methyl ether acetate, as well as levoglucosenone and dihydrolevoglucosenone, or a mixed solvent composed of two or more of these. A combined use of dimethyl sulfoxide and γ-butyrolactone, a combined use of dimethyl sulfoxide and γ-valerolactone, a combined use of 3-methoxy-N,N-dimethylpropionamide and γ-butyrolactone, a combined use of 3-methoxy-N,N-dimethylpropionamide and dimethyl sulfoxide, or, a combined use of N-methyl-2-pyrrolidone and ethyl lactate is particularly preferable. An aspect in which an amount of about 1% to 10% by mass of toluene with respect to the total mass of the solvent is further added to these combinedly used solvents is also one of the preferred aspects of the present invention.

In particular, from the viewpoint of the storage stability of the resin composition, an aspect in which γ-valerolactone is included as the solvent is also one of the preferred aspects of the present invention. In such an aspect, the content of γ-valerolactone with respect to the total mass of the solvent is preferably 50% by mass or more, more preferably 60% by mass or more, and still more preferably 70% by mass or more. In addition, the upper limit of the above-described content is not particularly limited, and it may be 100% by mass. The above-described content may be determined in consideration of the solubility or the like of the component contained in the resin composition, such as the specific resin.

In addition, in a case where dimethyl sulfoxide and γ-valerolactone are used in combination, with respect to the total mass of the solvent, it is preferable to contain 60% to 90% by mass of γ-valerolactone and 10% to 40% by mass of dimethyl sulfoxide, it is more preferable to contain 70% to 90% by mass of γ-valerolactone and 10% to 30% by mass of dimethyl sulfoxide, and it is still more preferable to contain 75% to 85% by mass of γ-valerolactone and 15% to 25% by mass of dimethyl sulfoxide.

From the viewpoint of coatability, the content of the solvent is such that the concentration of the total solid contents of the resin composition according to the embodiment of the present invention is preferably 5% to 80% by mass, more preferably 5% to 75% by mass, still more preferably 10% to 70% by mass, and even still more preferably 20% to 70% by mass. The content of the solvent may be adjusted depending on the desired thickness of the coating film and the coating method.

The resin composition according to the embodiment of the present invention may contain only one kind of solvent or two or more kinds thereof. In a case where two or more kinds of solvents are contained, the total thereof is preferably within the above-described range.

<Metal adhesiveness improving agent>

The resin composition according to the embodiment of the present invention preferably contains a metal adhesiveness improving agent for improving adhesiveness to a metal material used for an electrode or a wire. Examples of the metal adhesiveness improving agent include a silane coupling agent having an alkoxysilyl group, an aluminum-based auxiliary adhesive agent, a titanium-based auxiliary adhesive agent, a compound having a sulfonamide structure and a compound having a thiourea structure, a phosphoric acid derivative compound, a β-ketoester compound, and an amino compound.

[Silane coupling agent]

Examples of the silane coupling agent include the compounds described in paragraph 0316 of WO2021/112189A and the compounds described in paragraphs 0067 to 0078 of JP2018-173573A, the contents of which are incorporated in the present specification. In addition, it is also preferable to use two or more kinds of different silane coupling agents as described in paragraphs 0050 to 0058 of JP2011-128358A. In addition, as the silane coupling agent, the following compounds are also preferably used. In the following formulae, Me represents a methyl group, and Et represents an ethyl group. In addition, examples of R shown below include a structure derived from a blocking agent in a blocked isocyanate group. The blocking agent may be selected depending on the desorption temperature; however, examples thereof include an alcohol compound, a phenol compound, a pyrazole compound, a triazole compound, a lactam compound, and an active methylene compound. It is preferably caprolactam or the like, for example, from the viewpoint of setting the desorption temperature to 160°C to 180°C. Examples of the commercially available product of such a compound include X-12-1293 (manufactured by Shin-Etsu Chemical Co., Ltd.).

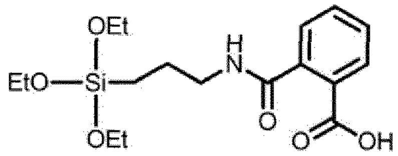

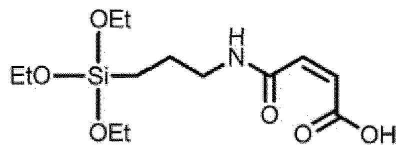

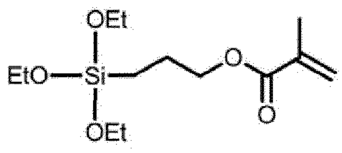

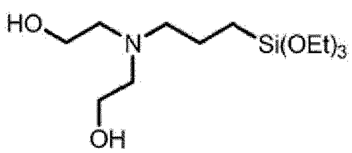

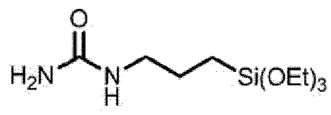

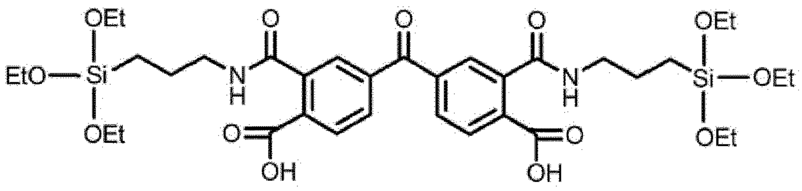

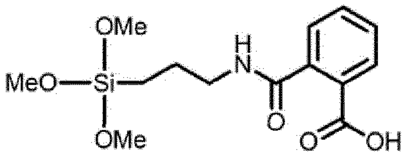

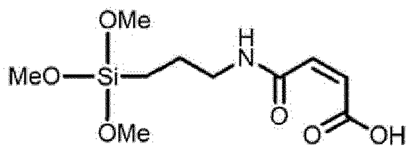

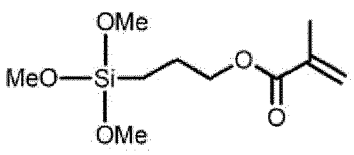

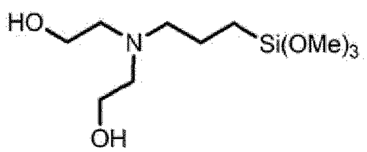

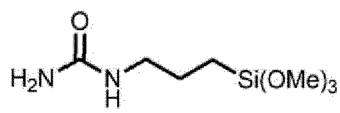

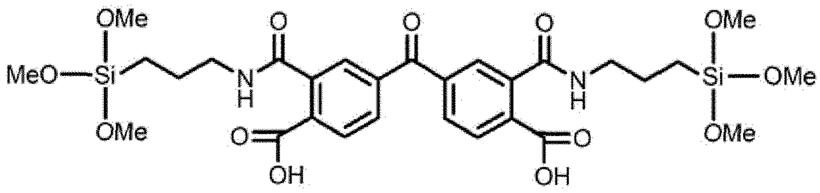

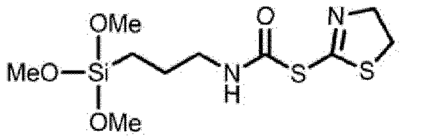

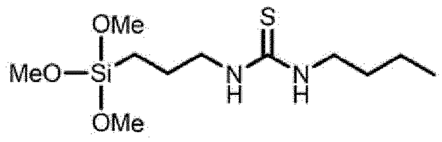

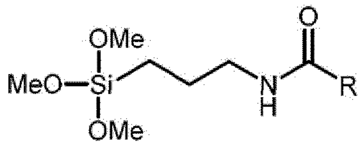

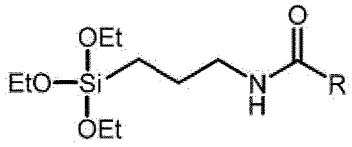

Examples of the other silane coupling agent include vinyltrimethoxysilane, vinyltriethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethylbutylidene)propylamine, N-phenyl-3-aminopropyltrimethoxysilane, tris-(trimethoxysilylpropyl)isocyanurate, a 3-ureidopropyltrialkoxysilane, 3-mercaptopropylmethyldimethoxysilane, 3-mercaptopropyltrimethoxysilane, 3-isocyanatepropyltriethoxysilane, and a 3-trimethoxysilylpropylsuccinic acid anhydride. These can be used alone or in a combination of two or more thereof.

In addition, an oligomer type compound having a plurality of alkoxysilyl groups can also be used as the silane coupling agent.

Examples of such an oligomer type compound include a compound containing a repeating unit represented by Formula (S-1).

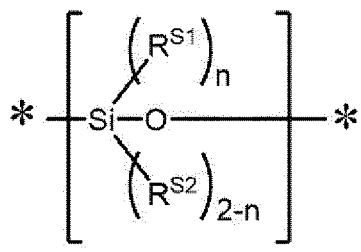

(S-1)

In Formula (S-1), $R^{S1}$ represents a monovalent organic group, $R^{S2}$ represents a hydrogen atom, a hydroxy group, or an alkoxy group, and n represents an integer of 0 to 2.

$R^{S1}$ preferably has a structure including a polymerizable group. Examples of the polymerizable group include a group having an ethylenically unsaturated bond, an epoxy group, an oxetanyl group, a benzoxazolyl group, a blocked isocyanate group, and an amino group. Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, and a (meth)acrylamide group, a (meth)acryloyloxy group, where a vinylphenyl group, a (meth)acrylamide group, or a (meth)acryloyloxy group is preferable, a vinylphenyl group or a (meth)acryloyloxy group is more preferable, and a (meth)acryloyloxy group is still more preferable.

$R^{S2}$ is preferably an alkoxy group, and more preferably a methoxy group or an ethoxy group.

n represents an integer of 0 to 2, and it is preferably 1.

Here, structures of a plurality of repeating units represented by Formula (S-1) may be the same, where the plurality of repeating units are contained in the oligomer type compound.

Here, among a plurality of repeating units represented by Formula (S-1), which are contained in the oligomer type compound, it is preferable that at least one repeating unit has n of 1 or 2, it is more preferable that at least two repeating units have n of 1 or 2, and it is still more preferable that at least two repeating units have n of 1.

As such an oligomer type compound, a commercially available product can be used, and examples thereof include KR-513 (manufactured by Shin-Etsu Chemical Co., Ltd.).

[Aluminum-based auxiliary adhesive agent]

Examples of the aluminum-based auxiliary adhesive agent include aluminum tris(ethyl acetoacetate), aluminum tris(acetyl acetate), and ethyl acetoacetate aluminum diisopropylate.

In addition, as another metal adhesiveness improving agent, the compounds described in paragraphs 0046 to 0049 of JP2014-186186A, and the sulfide-based compounds described in paragraphs 0032 to 0043 of JP2013-072935A can also be used, the contents of which are incorporated in the present specification.

The content of the metal adhesiveness improving agent is preferably in a range of 0.01 to 30 parts by mass, more preferably in a range of 0.1 to 10 parts by mass, and still more preferably in a range of 0.5 to 5 parts by mass, with respect to 100 parts by mass of the specific resin. In a case where the content is set to be equal to or larger than the above-described lower limit value, good adhesiveness between a pattern and a metal layer is exhibited, and in a case where the content is set to be equal to or smaller than the above-described upper limit value, good heat resistance of the pattern and good mechanical properties are exhibited. One kind of metal adhesiveness improving agent may be used, or two or more kinds thereof may be used. In a case where two or more kinds thereof are used, the total content thereof is preferably within the above-described range.

<Migration suppressing agent>

The resin composition according to the embodiment of the present invention preferably further contains a migration suppressing agent. The incorporation of the migration suppressing agent makes it possible to effectively inhibit the movement of metal ions derived from a metal layer (a metal wire) into a film.

The migration suppressing agent is not particularly limited; however, examples thereof include a compound having a heterocycle (a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a pyrazine ring, a piperidine ring, a piperazine ring, a morpholine ring, a 2H-pyran ring and a 6H-pyran ring, or a triazine ring), a compound having thioureas and a sulfanyl group, a hindered phenol-based compound, a salicylic acid derivative-based compound, and a hydrazide derivative-based compound. In particular, it is possible to preferably use a triazole-based compound such as 1,2,4-triazole, benzotriazole, 3-amino-1,2,4-triazole, or 3,5-diamino-1,2,4-triazole, or a tetrazole-based compound such as 1H-tetrazole, 5-phenyltetrazole or 5-amino-1H-tetrazole.

Alternatively, an ion trapping agent that captures an anion such as a halogen ion can also be used.

Examples of another migration suppressing agent include the compounds described in paragraph 0304 of WO2021/112189A. The content thereof is incorporated in the present specification.

Specific examples of the migration suppressing agent include the following compounds. In addition, preferred specific examples thereof include E-2 to E-5 in Examples described later.

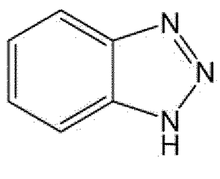
M-1

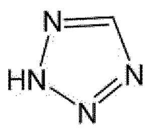
M-2

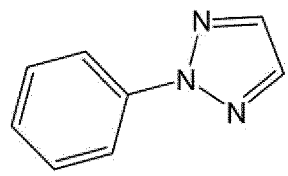
M-3

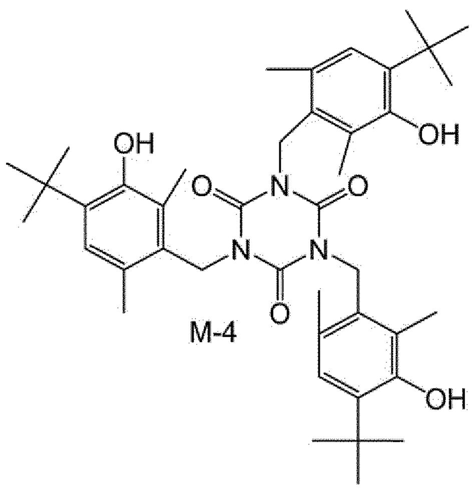
M-4

In a case where the resin composition according to the embodiment of the present invention contains the migration suppressing agent, the content of the migration suppressing agent is preferably 0.01% to 5.0% by mass, more preferably 0.05% to 2.0% by mass, and still more preferably 0.1% to 1.0% by mass, with respect to the total solid content of the resin composition according to the embodiment of the present invention.

One kind of migration suppressing agent may be used alone, or two or more kinds thereof may be used. In a case where two or more kinds of migration suppressing agents are used, the total thereof is preferably within the above-described range.

<Polymerization Inhibitor>

The resin composition according to the embodiment of the present invention preferably contains a polymerization inhibitor. Examples of the polymerization inhibitor include a phenol-based compound, a quinone-based compound, an amino-based compound, an N-oxyl free radical-based compound, a nitro-based compound, a nitroso-based compound, a heteroaromatic ring-based compound, and a metal compound.

Specific examples of the polymerization inhibitor include the compounds described in paragraph 0310 of WO2021/112189A, p-hydroquinone, o-hydroquinone, a 4-hydroxy-2,2,6,6-tetramethylpiperidine-1-oxyl free radical, and phenoxazine. The content thereof is incorporated in the present specification.

In a case where the resin composition according to the embodiment of the present invention has a polymerization inhibitor, the content of the polymerization inhibitor is preferably 0.01% to 20% by mass, more preferably 0.02% to 15% by mass, and still more preferably 0.05% to 10% by mass, with respect to the total solid content of the resin composition according to the embodiment of the present invention.

One kind of polymerization inhibitor may be used, or two or more kinds thereof may be used. In a case where two or more kinds of polymerization inhibitors are used, the total thereof is preferably within the above-described range.

<Acid trapping agent>

The resin composition according to the embodiment of the present invention preferably contains an acid trapping agent in order to reduce a change in performance during the period from exposure to heating. Here, the acid trapping agent refers to a compound that can trap a generated acid by being present in the system, and it is preferably a compound having a low acidity and a high pKa. The acid trapping agent is preferably a compound having an amino group, more preferably a primary amine, a secondary amine, a tertiary amine, an ammonium salt, or a tertiary amide, still more preferably a primary amine, a secondary amine, a tertiary amine, or an ammonium salt, and even more preferably a secondary amine, a tertiary amine, or an ammonium salt.

Preferred examples of the acid trapping agent include a compound having an imidazole structure, a diazabicyclo structure, an onium structure, a trialkylamine structure, an aniline structure, or a pyridine structure, an alkylamine derivative having a hydroxyl group and/or an ether bond, and aniline having a hydroxyl group and/or an ether bond. In a case having an onium structure, the acid trapping agent is preferably a salt having a cation selected from ammonium, diazonium, iodonium, sulfonium, phosphonium, pyridinium, or the like, and an anion of an acid having an acidity lower than that of the acid generated by the acid generator.

Examples of the acid trapping agent having an imidazole structure include imidazole, 2,4,5-triphenylimidazole, benzimidazole, and 2-phenylbenzoimidazole.

Examples of the acid trapping agent having a diazabicyclo structure include 1,4-diazabicyclo[2,2,2]octane, 1,5-diazabicyclo[4,3,0]nona-5-ene, and 1,8-diazabicyclo[5,4,0]undec-7-ene. Examples of the acid trapping agent having an onium structure include tetrabutylammonium hydroxide, a triarylsulfonium hydroxide, phenacylsulfonium hydroxide, and a sulfonium hydroxide having a 2-oxoalkyl group, and specifically, triphenylsulfonium hydroxide, tris (t-butylphenyl)sulfonium hydroxide, bis(t-butylphenyl)iodonium hydroxide, phenacylthiophenium hydroxide, and 2-oxopropylthiophenium hydroxide. Examples of the acid trapping agent having a trialkylamine structure include tri(n-butyl)amine and tri(n-octyl)amine. Examples of the acid trapping agent having an aniline structure include 2,6-diisopropylaniline, N,N-dimethylaniline, N,N-dibutylaniline, and N,N-dihexylaniline. Examples of the acid trapping agent having a pyridine structure include pyridine and 4-methylpyridine. Examples of the alkylamine derivative having a hydroxyl group and/or an ether bond include ethanolamine, diethanolamine, triethanolamine, N-phenyldiethanolamine, and tris(methoxyethoxyethyl)amine. Examples of the aniline derivative having a hydroxyl group and/or an ether bond include N,N-bis(hydroxyethyl)aniline.

Specific examples of the preferred acid trapping agent include ethanolamine, diethanolamine, triethanolamine, ethylamine, diethylamine, triethylamine, hexylamine, dodecylamine, cyclohexylamine, cyclohexylmethylamine, cyclohexyldimethylamine, aniline, N-methylaniline, N,N-dimethylaniline, diphenylamine, pyridine, butylamine, isobutylamine, dibutylamine, tributylamine, dicyclohexylamine, diazabicycloundecene (DBU), 1,4-diazabicyclo[2.2.2]octane (DABCO), N,N-diisopropylethylamine, tetramethylammonium hydroxide, ethylenediamine, 1,5-diaminopentane, N-methylhexylamine, N-methyldicyclohexylamine, trioctylamine, N-ethylethylenediamine, N,N-diethylethylenediamine, N,N,N',N'-tetrabutyl-1,6-hexanediamine, spermidine, diaminocyclohexane, bis(2-methoxyethyl)amine, piperidine, methylpiperidine, piperazine, tropane, N-phenylbenzylamine, 1,2-dianilinoethane, 2-aminoethanol, toluidine, aminophenol, hexylaniline, phenylenediamine, phenylethylamine, dibenzylamine, pyrrole, N-methylpyrrole, guanidine, aminopyrrolidine, pyrazole, pyrazoline, aminomorpholine, and aminoalkylmorpholine.

One of these acid trapping agents may be used alone, or two or more kinds thereof may be used in combination.

The composition according to the present invention may contain or may not contain an acid trapping agent. However, in a case of being contained, the content of the acid trapping agent is generally from 0.001% to 10% by mass and preferably 0.01% to 5% by mass based on the total solid content of the composition.

The using ratio of the acid generator to the acid trapping agent is preferably, acid generator/acid trapping agent (in terms of molar ratio) = 2.5 to 300. That is, from the viewpoint of sensitivity and resolution, the molar ratio is preferably 2.5 or more, and from the viewpoint of suppressing the decrease in resolution due to the thickening of the relief pattern during the period from the exposure to the heat treatment, it is preferably 300 or less. The "acid generator/acid trapping agent (in terms of molar ratio)" is more preferably 5.0 to 200 and still more preferably 7.0 to 150.

<Other additives>

The resin composition according to the embodiment of the present invention can be blended with various additives as necessary, for example, a surfactant, a higher fatty acid derivative, a thermal polymerization initiator, inorganic particles, an ultraviolet absorbing agent, an organic titanium compounds, an antioxidant, an aggregation preventing agent, a phenol-based compound, another polymer compound, a plasticizer, and other auxiliary agents (for example, an antifoaming agent, and a flame retardant) within the scope in which the effect of the present invention is obtained. By appropriately containing these components, properties such as film properties can be adjusted. The details of the components can be found in, for example, paragraph 0183 and subsequent paragraphs of JP2012-003225A (corresponding to paragraph 0237 of US2013/0034812A) and paragraphs 0101 to 0104 and 0107 to 0109 of JP2008-250074A, the contents of which are incorporated in the present specification. In a case where these additives are blended, the total blending amount thereof is preferably 3% by mass or less of the solid content of the resin composition according to the embodiment of the present invention.

[Surfactant]

As the surfactant, various surfactants such as a fluorine-based surfactant, a silicone-based surfactant, and a hydrocarbon-based surfactant can be used. The surfactant may be a nonionic surfactant, a cationic surfactant, or an anionic surfactant.

In a case where a surfactant is contained in the photosensitive resin composition according to the embodiment of the present invention, the liquid characteristics (particularly, the fluidity) in a case of being prepared as a coating liquid are further improved, and thus the uniformity of the coating thickness and the liquid saving property can be further improved. That is, in a case where a film is formed using a coating liquid to which a composition containing a surfactant is applied, the interfacial tension between a surface to be coated and a coating liquid is reduced, the wettability to the surface to be coated is improved, and thus the coatability to the surface to be coated is improved. Therefore, a film having a uniform thickness with reduced unevenness in thickness can be formed more suitably.

Examples of the fluorine-based fluorine-based surfactant include the compounds described in paragraph 0328 of WO2021/112189A. The content thereof is incorporated in the present specification.

As the fluorine-based surfactant, a fluorine-containing polymer compound containing a repeating unit derived from a (meth)acrylate compound having a fluorine atom and a repeating unit derived from a (meth)acrylate compound having 2 or more (preferably 5 or more) alkyleneoxy groups (preferably ethyleneoxy groups or propyleneoxy groups) can also be preferably used, and examples of the fluorine-based surfactant that is used in the present invention include the following compounds as well.

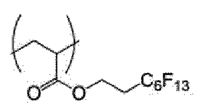
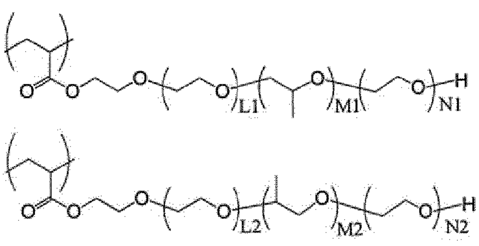

L1+N1+L2+N2=14
M1+M2=17

62% 38%

The weight-average molecular weight of the compounds is preferably 3,000 to 50,000 and more preferably 5,000 to 30,000.

Regarding the fluorine-based surfactant, a fluorine-containing polymer having an ethylenically unsaturated group in the side chain can also be used as the fluorine-based surfactant. Specification examples thereof include the

compounds described in paragraphs "0050" to "0090" and "0289" to "0295" of JP2010-164965A, the content of which is incorporated in the present specification. In addition, examples of the commercially available product thereof include MEGAFACE RS-101, RS-102, and RS-718-K, all manufactured by DIC Corporation.

The fluorine content in the fluorine-based surfactant is preferably 3 to 40% by mass, more preferably 5 to 30% by mass, and particularly preferably 7 to 25% by mass. The fluorine-based surfactant in which the fluorine content is in the above-described range is effective from the viewpoints of the uniformity in the thickness of the coating film and liquid saving properties, and the solubility thereof in the composition is also excellent.

Examples of each of the silicone-based surfactant, the hydrocarbon-based surfactant, the nonionic surfactant, the cationic surfactant, and the anionic surfactant include the compounds described in paragraphs 0329 to 0334 of WO2021/112189A. The contents of which are incorporated in the present specification.

Only one kind of surfactant may be used, or two or more kinds thereof may be used in combination.

The content of the surfactant is preferably 0.001% to 2.0% by mass and more preferably 0.005% to 1.0% by mass with respect to the total solid content of the composition.

[Higher fatty acid derivative]

In the resin composition according to the embodiment of the present invention, in order to prevent polymerization inhibition due to oxygen, a higher fatty acid derivative such as behenic acid or behenic acid amide may be added and be caused to be localized on a surface of the composition in the process of drying after coating.

In addition, as the higher fatty acid derivative, the compounds described in paragraph 0155 of WO2015/199219A can also be used, the content of which is incorporated in the present specification.

In a case where the resin composition according to the embodiment of the present invention has a higher fatty acid derivative, the content of the higher fatty acid derivative is preferably 0.1% to 10% by mass with respect to the total solid content of the composition according to the embodiment of the present invention. One kind of higher fatty acid derivative may be used, or two or more kinds thereof may be used. In a case where two or more kinds of higher fatty acid derivatives are used, the total thereof is preferably within the above-described range.

[Thermal polymerization initiator]

The resin composition according to the embodiment of the present invention may contain a thermal polymerization initiator and particularly may contain a thermal radical polymerization initiator. The thermal radical polymerization initiator is a compound that generates a radical by heat energy and initiates or accelerates a polymerization reaction of a compound having polymerization properties. In a case where a thermal radical polymerization initiator is added, the polymerization reaction of the resin and the polymerizable compound can be allowed to proceed, and thus the solvent resistance can be further improved. In addition, there is a case where the above-described photopolymerization initiator also has a function of initiating polymerization by heat, and thus there is a case where it can be added as a thermal polymerization initiator.

Examples of the thermal polymerization initiator include a publicly known azo-based compound and a publicly known peroxide-based compound. Examples of the azo compound include an azobis-based compound. The azo-based compound may be a compound having a cyano group or may be a compound having no cyano group. Examples of the peroxide-based compound include a ketone peroxide, a peroxyketal, a hydroperoxide, a dialkyl peroxide, a diacyl peroxide, a peroxydicarbonate, and a peroxyester.

A commercially available product can also be used as the thermal polymerization initiator, and examples thereof include V-40, V-601, and VF-096, manufactured by Fujifilm Wako Pure Chemical Corporation, and PERHEXYL O, PERHEXYL D, PERHEXYL I, PERHEXA25O, PERHEXA25Z, PERCUMYL D, PERCUMYL D-40, PERCUMYL D-40MB, PERCUMYL H, PERCUMYL P, and PERCUMYL ND, manufactured by NOF Corporation.

Specific examples of thermal radical polymerization initiator include compounds described in paragraphs 0074 to 0118 of JP2008-063554A, the content of which is incorporated in the present specification.

In a case where thermal polymerization initiator is contained, the content thereof is preferably 0.1% to 30% by mass, with respect to the total solid content of the resin composition according to the embodiment of the present invention, more preferably 0.1% to 20% by mass, and still more preferably 0.5% to 15% by mass. Only one kind of thermal polymerization initiator may be contained, or two or more kinds thereof may be contained. In a case where two or more kinds of thermal polymerization initiators are contained, the total amount thereof is preferably within the above-described range.

[Inorganic particle]

The resin composition according to the embodiment of the present invention may contain inorganic particles.

Specific examples of the inorganic particle include calcium carbonate, calcium phosphate, silica, kaolin, talc, titanium dioxide, alumina, barium sulfate, calcium fluoride, lithium fluoride, zeolite, molybdenum sulfide, glass, boron nitride, a boron nitride nanotube, boron carbon nitride, aluminum nitride, and silicon nitride.

The average particle diameter of the inorganic particles is preferably 0.01 to 2.0 μm, more preferably 0.02 to 1.5 μm, still more preferably 0.03 to 1.0 μm, and particularly preferably 0.04 to 0.5 μm.

The average particle diameter of the inorganic particles is the primary particle diameter and the volume average particle diameter. The volume average particle diameter can be measured by a dynamic light scattering method with Nanotrac WAVE II EX-150 (manufactured by Nikkiso Co., Ltd.).

In a case where the above measurement is difficult, the measurement can also be carried out by a centrifugal sedimentation light transmission method, an X-ray transmission method, or a laser diffraction/light scattering method.

[Ultraviolet absorbing agent]

The composition according to the embodiment of the present invention may contain an ultraviolet absorbing agent. As the ultraviolet absorbing agent, an ultraviolet absorbing agent such as a salicylate-based, a benzophenone-based, a benzotriazole-based, a substituted acrylonitrile-based, or a triazine-based ultraviolet absorbing agent can be used.

Specific examples of the ultraviolet absorbing agent include the compounds described in paragraphs 0341 and 0342 of WO2021/112189A. The content thereof is incorporated in the present specification.

In the present invention, the above-described various ultraviolet absorbing agents may be used alone, or two or more thereof may be used in combination.

The composition according to the embodiment of the present invention may contain or may not contain an ultraviolet absorbing agent. However, in a case of containing it, the content of the ultraviolet absorbing agent is preferably 0.001% by mass or more and 1% by mass or less, and more preferably 0.01% by mass or more and 0.1% by mass or less, with respect to the total solid content mass of the composition according to the embodiment of the present invention.

[Organic titanium compound]

The resin composition of the present embodiment may contain an organic titanium compound. In a case where the resin composition contains an organic titanium compound, it is possible to form a resin layer having excellent chemical resistance even in a case where curing is carried out at a low temperature.

Examples of the usable organic titanium compound include those in which an organic group is bonded to a titanium atom through a covalent bond or an ionic bond.

Specific examples of the organic titanium compound are described in I) to VII) below.

I) Titanium chelate compounds: among them, a titanium chelate compound having two or more alkoxy groups is more preferable since the resin composition has good storage stability and a good curing pattern can be obtained. Specific examples thereof include titanium bis(triethanolamine)diisopropoxide, titanium di(n-butoxide) bis(2,4-pentanedionate), titanium diisopropoxide bis(2,4-pentanedionate), titanium diisopropoxide bis(tetramethylheptandionate), and titanium diisopropoxide bis(ethyl acetoacetate).

II) Tetraalkoxy titanium compounds: examples thereof include titanium tetra(n-butoxide), titanium tetraethoxide, titanium tetra(2-ethylhexoxide), titanium tetraisobutoxide, titanium tetraisopropoxide, titanium tetramethoxide, titanium tetramethoxypropoxide, titanium tetramethylphenoxide, titanium tetra(n-nonyloxide), titanium tetra(n-propoxide), and titanium tetrastearyloxide, titanium tetrakis[bis{2,2-(aryloxymethyl)butoxide}].

III) Titanocene compounds: examples thereof include pentamethylcyclopentadienyl titanium trimethoxide, bis(η5-2,4-cyclopentadiene-1-yl) bis(2,6-difluorophenyl)titanium, and bis(η5-2,4-cyclopentadiene-1-yl) bis(2,6-difluoro-3-(1H-pyrrole-1-yl)phenyl)titanium.

IV) Monoalkoxytitanium compounds: examples thereof include titanium tris(dioctyl phosphate)isopropoxide, and titanium tris(dodecylbenzene sulfonate)isopropoxide.

V) Titanium oxide compounds: examples thereof include titanium oxide bis(pentanedionate), titanium oxide bis(tetramethylheptandionate), and phthalocyanine titanium oxide.

VI) Titanium tetraacetylacetonate compounds: examples thereof include titanium tetraacetylacetoneate.

VII) Titanate coupling agents: examples thereof include isopropyltridodecylbenzenesulfonyl titanate.

Among them, it is preferable that the organic titanium compound is at least one compound selected from the group consisting of the above-described I) titanium chelate compound, II) tetraalkoxytitanium compound, and III) titanocene compound, from the viewpoint that better chemical resistance is exhibited. In particular, titanium diisopropoxide bis(ethyl acetoacetate), titanium tetra(n-butoxide), or bis(η5-2,4-cyclopentadiene-1-yl) bis(2,6-difluoro-3-(1H-pyrrole-1-yl)phenyl)titanium is preferable.

In a case where an organic titanium compound is blended, the blending amount thereof is preferably 0.05 to 10 parts by mass and more preferably 0.1 to 2 parts by mass with respect to 100 parts by mass of the specific resin. In a case where the blending amount is 0.05 parts by mass or more, good heat resistance and good chemical resistance are more effectively exhibited in the curing pattern to be obtained. On the other hand, in a case where it is 10 parts by mass or less, the storage stability of the composition is more excellent.

[Antioxidant]

The composition according to the embodiment of the present invention may contain an antioxidant. In a case where an antioxidant is contained as an additive, it is possible to improve the elongation characteristics of the film after curing and the adhesiveness to the metal material. Examples of the antioxidant include a phenol compound, a phosphorous acid ester compound, and a thioether compound. Specific examples of the antioxidant include the compounds described in paragraphs 0348 to 0357 of WO2021/112189A. The content thereof is incorporated in the present specification.

The adding amount of the antioxidant is preferably 0.1 to 10 parts by mass and more preferably 0.5 to 5 parts by mass with respect to the resin. In a case where the adding amount is set to 0.1 parts by mass or more, the effect of improving the elongation characteristics and the adhesiveness to the metal material can be easily obtained even in a high temperature and high humidity environment, and in a case where the adding amount is set to 10 parts by mass or less, the sensitivity of the resin composition is improved, for example, by the interaction with the photosensitizing agent. In the present invention, the antioxidant may be used singly or in a combination of two or more kinds thereof. In a case where two or more kinds thereof are used, the total amount thereof is preferably within the above-described range.

[Aggregation preventing agent]

The resin composition of the present embodiment may contain an aggregation preventing agent, as necessary. Examples of the aggregation preventing agent include sodium polyacrylate.

In the present invention, one kind of aggregation preventing agent may be used alone, or two or more thereof may be used in combination.

The composition according to the embodiment of the present invention may contain or may not contain an aggregation preventing agent. However, in a case of being contained, the content of the aggregation preventing agent is preferably 0.01% by mass or more and 10% by mass or less, and more preferably 0.02% by mass or more and 5% by mass or less, with respect to the total solid content mass of the composition according to the embodiment of the present invention.

[Phenol-based compound]

The resin composition of the present embodiment may contain a phenol-based compound, as necessary. Examples of the phenol-based compound include Bis-Z, BisP-EZ, TekP-4HBPA, TrisP-HAP, TrisP-PA, BisOCHP-Z, BisP-MZ, BisP-PZ, BisP-IPZ, BisOCP-IPZ, BisP-CP, BisRS-2P, BisRS-3P, BisP-OCHP, Methylene tris-FR-CR, BisRS-26X (all, product names, manufactured by Honshu Chemical Industry Co., Ltd.), BIP-PC, BIR-PC, BIR-PTBP, and BIR-BIPC-F (all, product names, manufactured by ASAHI YUKIZAI Corporation).

In the present invention, one kind of phenol-based compound may be used alone, or two or more thereof may be used in combination.

The composition according to the embodiment of the present invention may contain or may not contain a phenol-based compound. However, in a case of being contained, the content of the phenol-based compound is preferably 0.01% by mass or more and 30% by mass or less, and more preferably 0.02% by mass or more and 20% by mass or less, with respect to the total solid content mass of the composition according to the embodiment of the present invention.

[Polymer compound A]

Examples of the other polymer compound include a siloxane resin, a (meth)acrylic polymer obtained by copolymerizing (meth)acrylic acid, a novolak resin, a resol resin, a polyhydroxystyrene resin, and a copolymer thereof. The other polymer compound may be a modified polymer into which a crosslinking group such as a methylol group, an alkoxymethyl group, or an epoxy group has been introduced.

In the present invention, one kind of the other polymer compound may be used alone, or two or more thereof may be used in combination.

The composition according to the embodiment of the present invention may contain or may not contain another

polymer compound. However, in a case of being contained, the content of the other polymer compound is preferably 0.01% by mass or more and 30% by mass or less, and more preferably 0.02% by mass or more and 20% by mass or less, with respect to the total solid content mass of the composition according to the embodiment of the present invention.

<Characteristics of resin composition>

The viscosity of the resin composition according to the embodiment of the present invention can be adjusted by adjusting the concentration of solid contents of the resin composition. From the viewpoint of the coating film thickness, it is preferably 1,000 $mm^2/s$ to 12,000 $mm^2/s$, more preferably 2,000 $mm^2/s$ to 10,000 $mm^2/s$, and still more preferably 2,500 $mm^2/s$ to 8,000 $mm^2/s$. Within the above range, it is easy to obtain a coating film having high uniformity. In a case of being 1,000 $mm^2/s$ or more, it is easy to carry out coating at a film thickness to be required as, for example, an insulating film for re-distribution of a wiring line, and in a case of being 12,000 $mm^2/s$ or less, a coating film having an excellent coating surface shape is obtained.

<Restrictions on substances contained in resin composition>

The moisture content of the resin composition according to the embodiment of the present invention is preferably less than 2.0% by mass, more preferably less than 1.5% by mass, and still more preferably less than 1.0% by mass. In a case of being less than 2.0%, the storage stability of the resin composition is improved.

Examples of the method of maintaining the water content include adjusting the humidity under storage conditions and reducing the void volume of the storage container during storage.

From the viewpoint of insulating properties, the metal content of the resin composition according to the embodiment of the present invention is preferably less than 5 parts per million (ppm) by mass, more preferably less than 1 ppm by mass, and still more preferably less than 0.5 ppm by mass. Examples of the metal include sodium, potassium, magnesium, calcium, iron, copper chromium, and nickel, however, a metal contained as a complex of an organic compound and a metal is excluded. In a case where a plurality of metals are contained, the total of these metals is preferably within the above-described range.

In addition, as a method of reducing metal impurities which are unintentionally contained in the resin composition according to the embodiment of the present invention, a method of selecting a raw material containing a low metal content as the raw material that constitutes the resin composition according to the embodiment of the present invention, a method of filtering a raw material constituting the resin composition according to the embodiment of the present invention, a method of distilling under the conditions in which the inside of the device is lined with polytetrafluoroethylene or the like to suppress the contamination as little as possible, and the like can be mentioned.

In the resin composition according to the embodiment of the present invention, in a case of considering the use application as a semiconductor material, the content of halogen atoms is preferably less than 500 ppm by mass, more preferably less than 300 ppm by mass, and still more preferably less than 200 ppm by mass, from the viewpoint of wire corrosiveness. Among these, in a case of being present in a halogen ion state, the content is preferably less than 5 ppm by mass, more preferably less than 1 ppm by mass, and still more preferably less than 0.5 ppm by mass. Examples of the halogen atom include a chlorine atom and a bromine atom. It is preferable that the total content of the chlorine atom and the bromine atom, or the total content of the chlorine ion and the bromine ion is within the above-described range.

Preferred examples of the method of adjusting the content of halogen atoms include ion exchange treatment.

A conventionally publicly known storage container can be used as a storage container for the resin composition according to the embodiment of the present invention. In addition, as the storage container, for the intended purpose of suppressing the incorporation of impurities into the raw materials and the resin composition according to the embodiment of the present invention, a multilayer bottle in which an inner wall of a container is composed of six kinds of six layers of resin, and a bottle with six kinds of resin being made as a seven-layer structure are preferably used. Examples of such a container include the container described in JP2015-123351A.

## Examples

Hereinafter, the present invention will be described more specifically with reference to Examples. Materials, using amounts, proportions, treatment details, treatment procedures, and the like shown in the following examples can be appropriately changed without departing from the gist of the present invention. Therefore, it is to be understood that the scope of the present invention should not be interpreted in a limited manner based on the specific examples shown below.

<Synthesis Example 1; Synthesis of polymer P-1>

7.76 g (25 mmol) of 4,4'-oxydiphthalic acid dianhydride (ODPA) and 6.23 g (25 mmol) of 3,3',4,4'-biphenyltetracarboxylic acid dianhydride were placed in a reaction container, and then 13.4 g of 2-hydroxyethyl methacrylate (HEMA) and 100 mL of γ-butyrolactone were added thereto. 7.91 g of pyridine was added thereto with stirring at room temperature to obtain a reaction mixture. After the heat generation due to the reaction was stopped, the reaction mixture was further allowed to cool to room temperature and left to stand for 16 hours.

Next, under ice-cooling, a solution obtained by dissolving 20.6 g (99.9 mmol) of dicyclohexylcarbodiimide (DCC) in 30 mL of γ-butyrolactone was added to the reaction mixture over 40 minutes with stirring. Subsequently, a suspension obtained by suspending 9.3 g (46 mmol) of 4,4'-diaminodiphenyl ether (DADPE) in 350 mL of γ-butyrolactone was added thereto over 60 minutes with stirring.

Further, the suspension was stirred at room temperature for 2 hours, and 3 mL of ethyl alcohol was added thereto, followed by stirring for 1 hour. Then, 100 mL of γ-butyrolactone was added thereto. The precipitate formed in the reaction mixture was removed by filtration to obtain a reaction solution.

The obtained reaction solution was added to 3 liters of ethyl alcohol to form a precipitate consisting of a crude polymer. The produced crude polymer was filtered and collected and then dissolved in 200 mL of tetrahydrofuran to obtain a crude polymer solution. The obtained crude polymer solution was added dropwise to 3 liters of water to precipitate the polymer, and the obtained precipitate was filtered and collected, and then vacuum dried to obtain a powdery polymer P-1.

As a result of measuring the weight-average molecular weight (Mw) of this polymer, it was 23,000.

The polymer P-1 is a resin having the following structure. The subscript attached to the parenthesis indicates the molar ratio of each repeating unit.

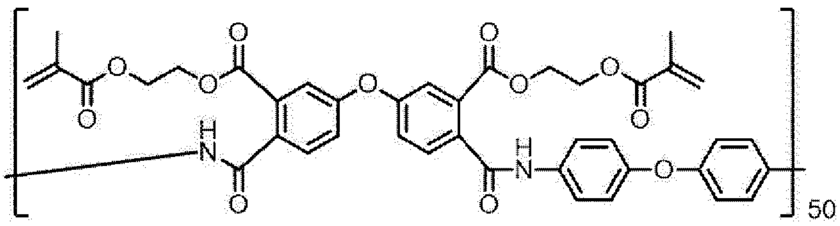

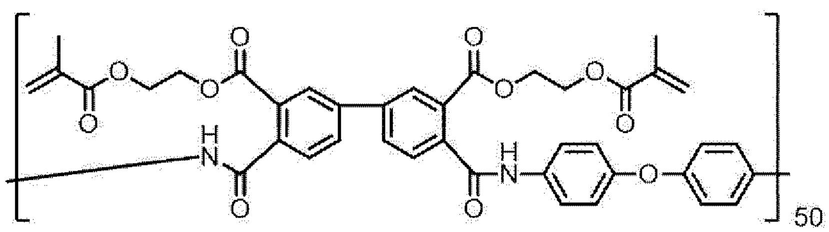

<Synthesis Example 2; Synthesis of polymer P-2>

20.0 g (64.5 mmol) of 4,4'-oxydiphthalic acid anhydride (dried at 140°C for 12 hours), 16.8 g (129 mmol) of 2-hydroxyethyl methacrylate, 0.05 g of hydroquinone, 20.4 g (258 mmol) of pyridine, 100 g of diglyme were mixed and stirred at a temperature of 60°C for 18 hours to produce a diester of 4,4'-oxydiphthalic acid and 2-hydroxyethyl methacrylate. Next, the reaction mixture was cooled, and 16.12 g (135.5 mmol) of $SOCL_2$ was added thereto over 2 hours. Then, a solution prepared by dissolving 12.74 g (60.0 mmol) of 2,2'-dimethylbiphenyl-4,4'-diamine in 100 mL of N-methylpyrrolidone was dropwise added to the reaction mixture over 2 hours while adjusting the temperature in a range of -5°C to 0°C. The reaction mixture was reacted at 0°C for 1 hour, and then 70 g of ethanol was added thereto, followed by stirring at room temperature for 1 hour. The polyimide precursor was then precipitated in 5 L of water and the water-polyimide precursor mixture was stirred for 15 minutes at a speed of 5,000 rpm. The polyimide precursor was filtered off, stirred again in 4 liters of water for 30 minutes, and filtered again. Next, the obtained polyimide precursor was dried under reduced pressure for 2 days. The weight-average molecular weight of this polyimide precursor (the polymer P-2) was 29,000.

The polymer P-2 is a resin having the following structure.

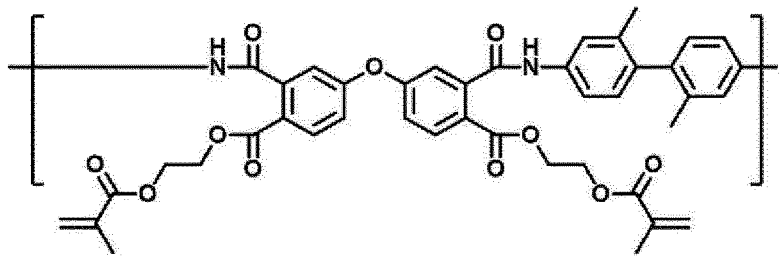

<Synthesis Example 3; Synthesis of polymer P-3>

20.0 g (64.5 mmol) of 4,4'-oxydiphthalic acid anhydride (dried at 140°C for 12 hours), 16.8 g (129 mmol) of 2-hydroxyethyl methacrylate, 0.05 g of hydroquinone, 20.4 g (258 mmol) of pyridine, 100 g of diglyme were mixed and stirred at a temperature of 60°C for 18 hours to produce a diester of 4,4'-oxydiphthalic acid and 2-hydroxyethyl methacrylate. Next, after chlorinating the obtained diester with $SOCL_2$, a solution obtained by dissolving 4,4'-diaminodiphenyl ether in N-methylpyrrolidone was dropwise added to the reaction mixture in the same manner as in Synthesis Example 2, and then the obtained reaction mixture was purified and dried. The weight-average molecular weight of this polyimide precursor (the polymer P-3) was 18,000.

The polymer P-3 is a resin having the following structure.

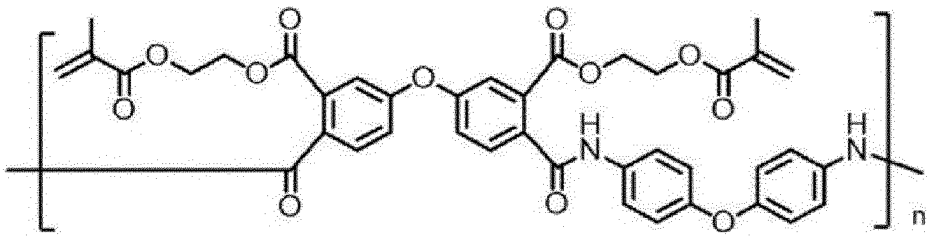

As shown in Table 1 or Table 2, the respective components were mixed to prepare a uniform solution. The obtained solution was subjected to pressure filtration through a filter having a micropore width of 20 μm at a pressure of 0.4 MPa to obtain each of resin compositions (compositions 1 to 20).

Specifically, the content of the component described in the table was set to the amount (parts by mass) described in the table. In addition, in the table, the description of "-" indicates that the corresponding component is not contained in the composition.

[Table 1]

| | Composition | | | | | | | | | |
|---|---|---|---|---|---|---|---|---|---|---|
| Component | 1 | 2 | 3 | 4 | 5 | 6 | 7 | 8 | 9 | 10 |
| P-1 | 40.00 | - | - | - | - | - | - | 37.00 | - | - |
| P-2 | - | - | - | - | - | - | 37.00 | - | - | - |
| P-3 | - | 37.00 | 37.00 | 37.00 | 37.00 | 37.00 | - | - | 37.00 | 37.00 |
| B-1 | - | 5.40 | 5.40 | - | 2.70 | 2.70 | 2.70 | 2.70 | 2.70 | 5.40 |
| B-2 | - | - | - | 5.40 | 2.70 | 2.70 | 2.70 | 2.70 | 2.70 | - |
| C-1 | - | 1.20 | - | - | - | - | - | - | 1.20 | 1.20 |
| C-2 | 1.20 | - | 1.20 | 1.20 | 1.20 | 1.20 | 1.20 | 1.20 | - | - |
| D-1 | 0.74 | 0.74 | 0.74 | 0.74 | 0.74 | 0.74 | 0.74 | 0.74 | 0.74 | 0.74 |
| E-1 | 0.12 | 0.12 | 0.12 | 0.12 | 0.12 | 0.12 | 0.12 | 0.12 | 0.12 | 0.12 |
| A-1 | 0.05 | 0.05 | 0.05 | 0.05 | 0.05 | 0.05 | 0.05 | 0.05 | 0.05 | 0.05 |
| G-1 | 0.90 | - | - | - | - | 0.90 | 0.90 | 0.90 | 0.90 | 1.60 |

(continued)

| | Composition | | | | | | | | | |
|---|---|---|---|---|---|---|---|---|---|---|
| Component | 1 | 2 | 3 | 4 | 5 | 6 | 7 | 8 | 9 | 10 |
| G-2 | - | - | 0.90 | 0.90 | 0.90 | - | - | - | - | - |
| H-1 | 45.99 | 44.59 | 43.89 | 43.89 | 43.89 | 43.89 | 43.89 | 43.89 | 43.89 | 43.19 |
| H-2 | 11.00 | 10.90 | 10.70 | 10.70 | 10.70 | 10.70 | 10.70 | 10.70 | 10.70 | 10.70 |

[Table 2]

| | Composition | | | | | | | | | |
|---|---|---|---|---|---|---|---|---|---|---|
| Component | 11 | 12 | 13 | 14 | 15 | 16 | 17 | 18 | 19 | 20 |
| P-3 | 33 | 33 | 24 | 24 | 28 | 28 | 28 | 37.00 | 24.00 | 29.00 |
| B-1 | 2.4 | 2.4 | 1.7 | 1.7 | - | - | - | 5.40 | 1.70 | 1.70 |
| B-3 | - | - | - | - | 4.2 | 4.2 | 4.2 | - | - | - |
| C-2 | 1 | - | 0.8 | 0.8 | 0.8 | 0.8 | 0.8 | 1.20 | 0.80 | 0.80 |
| C-3 | - | 1 | - | - | - | - | - | - | - | - |
| D-1 | - | - | - | - | - | - | - | 0.74 | 0.50 | 0.50 |
| D-2 | - | 0.6 | - | - | - | - | - | - | - | - |
| D-3 | 0.6 | - | 0.5 | 0.5 | 0.6 | 0.6 | 0.6 | - | - | - |
| E-1 | - | - | - | - | - | - | - | 0.12 | 0.08 | 0.08 |
| E-2 | 0.1 | - | - | - | 0.1 | 0.1 | 0.1 | - | - | - |
| E-3 | - | 0.1 | - | - | - | - | - | - | - | - |
| E-4 | - | - | 0.08 | - | - | - | - | - | - | - |
| E-5 | - | - | - | 0.08 | - | - | - | - | - | - |
| A-1 | 0.05 | 0.05 | 0.04 | 0.04 | 0.04 | 0.04 | 0.04 | 0.05 | 0.04 | 0.04 |
| G-1 | 0.75 | 0.75 | 0.6 | 0.6 | 0.7 | 0.7 | 0.7 | 0.90 | 0.60 | 0.60 |
| H-1 | - | - | 37.28 | 37.28 | 52.2 | - | - | 43.89 | 37.28 | 37.28 |
| H-2 | 10 | - | 10 | 10 | 13.0 | 13.0 | - | 10.70 | 10.00 | 10.00 |
| H-3 | 37.1 | - | - | - | - | 52.2 | - | - | - | - |
| H-4 | - | 47.1 | - | - | - | - | 65.2 | - | - | - |
| F-1 | 15 | 10 | - | - | - | - | - | - | - | 5.00 |
| F-2 | - | - | - | 25 | - | - | - | - | - | - |
| F-3 | - | 5 | - | - | - | - | - | - | 25.00 | - |
| F-4 | - | - | 25 | - | - | - | - | - | - | 15.00 |

The details of the abbreviations listed in the table are as follows.

[Resin]

· P-1 to P-3: Polymers P-1 to P-3 synthesized as above

[Polymerizable compound]

· ·B-1: Tetraethylene glycol dimethacrylate (manufactured by Arkema S.A.)
· B-2: OGSOL EA-0200 (manufactured by Osaka Gas Chemicals Co., Ltd.)
· B-3: KAYARAD DPHA (manufactured by Nippon Kayaku Co., Ltd.)

[Initiator]

· ·C-1: Irgacure OXE 01 (manufactured by BASF SE)
· ·C-2: PERCUMYL D (manufactured by NOF Corporation)
· C-3: Irgacure 784

[Metal adhesiveness improving agent]

· D-1: N-[3-(triethoxysilyl)propyl]maleamic acid
· D-2: X-12-1293 (manufactured by Shin-Etsu Chemical Co., Ltd.)
· D-3: KR-513 (manufactured by Shin-Etsu Chemical Co., Ltd.)

[Migration suppressing agent]

· E-1: 5-aminotetrazole
· E-2 to E-5: Compounds having the following structures

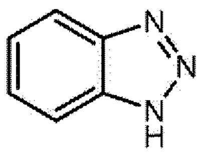

E-2

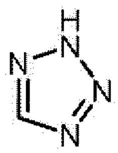

E-3

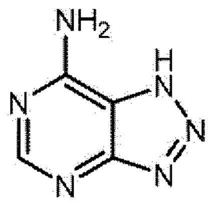

E-4

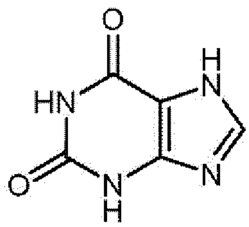

E-5

[Polymerization inhibitor]

· A-1: 4MeHQ (4-methoxyphenol)

[Base generator]

· G-1: The following compound

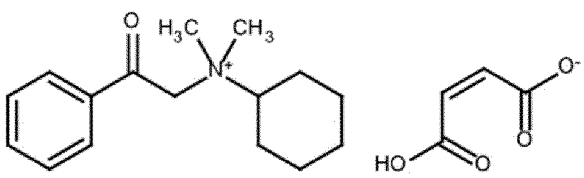

· G-2: The following compound

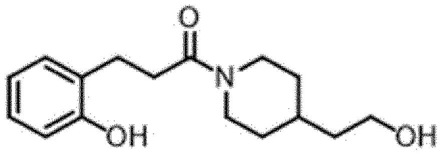

[Solvent]

· H-1: γ-butyrolactone (GBL)
· H-2: dimethyl sulfoxide (DMSO)
· H-3: γ-valerolactone
· H-4: 3-methoxy-N,N-dimethylpropanamide

[Filler]

· F-1: Boron nitride/Platelets 001 manufactured by 3M Company (average particle diameter: 500 nm)
· F-2: Alumina/manufactured by Sumitomo Chemical Co., Ltd., Sumicorundum AA-03NF (average particle diameter: 250 nm)
· F-3: Alumina/manufactured by Sumitomo Chemical Co., Ltd., NXA-150 (average particle diameter: 150 nm)
· F-4: Alumina/manufactured by Sumitomo Chemical Co., Ltd., NXA-100 (average particle diameter: 100 nm)

<Production of substrate>

A pillar substrate having the following size and metal species was produced by plating.

a) Pitch: 45 μm, copper pillar diameter: 10 μm, copper pillar height: 10 μm
b) Pitch: 45 μm, copper/tin pillar diameter: 20 μm, copper/tin pillar height: 2/8 μm, silicon wafer: on which copper and tin are formed in this order.
c) A $SiO_2$ film having a thickness of 5 μm was formed on an 8-inch silicon wafer by chemical vapor deposition (CVD), and a pattern of holes having a pitch of 45 μm and a diameter of 20 μm was formed in a square arrangement by photolithography and dry etching. A thin layer of titanium and a thin layer of copper were formed in this order, by CVD, on the surface on which the hole pattern had been formed, and then the hole pattern was filled with copper by plating. Then, the $SiO_2$ film in which the pattern had been filled with copper was polished together with the internal copper by CMP until a thickness reached 3 μm was obtained.

The details of the produced pillar substrate are described below.
Fig. 6A is a schematic cross-sectional view of the a) described above.
In Fig. 6A, 10 indicates a substrate, and 12 indicates a wiring line terminal (pillar) formed from copper.
In Fig. 6A, the arithmetic average value of pillar diameters d, in each pillar, is the pillar diameter, and it is 10 μm in the a).
In Fig. 6A, the arithmetic average value of pillar spacings p, in each pillar, is the pitch, and it is 45 μm in the a).
In Fig. 6A, the arithmetic average value of pillar heights h, in each pillar, is the pillar height, and it is 10 μm in the a).
Fig. 6B is a schematic cross-sectional view of the b) described above.
In Fig. 6B, 10 indicates a substrate, and 12 indicates a wiring line terminal, where the wiring line terminal 12 is formed from a pillar (conduction path) 14 formed from tin and a pillar (electrode) 16 formed from copper.
In Fig. 6B, the arithmetic average value of pillar diameters d, in each pillar, is the pillar diameter, and it is 20 μm in the b).
In Fig. 6B, the arithmetic average value of pillar spacings p, in each pillar, is the pitch, and it is 45 μm in the b).
In Fig. 6B, the arithmetic average value of conduction path heights h1, in each pillar, is the tin pillar height, and it is 8 μm in the b).
In Fig. 6B, the arithmetic average value of electrode heights h2, in each pillar, is the copper pillar height, and it is 2 μm in the b).

<Production of substrate/substrate laminate (bonded body) (Examples 1 to 11 and 15 to 19, and Comparative Examples 1 and 2)>

In Examples 1 to 11 and 15 to 19, the substrates A and B were coated with each composition described in the table to have a film thickness of 15 μm and baked at 100°C for 5 minutes. Further, additional baking was carried out under the conditions of the temperature and the time, which are described in the columns of "Film formation temperature" and "Film formation time" in the table, to obtain a polyimide-containing precursor portion. Then, using a chemical mechanical polishing (CMP) machine manufactured by Fujikoshi Machinery Corp., the surface of the polyimide-containing precursor portion was flattened so that the residual film on the surface was 5 μm. Then, cutting was carried out into a 5 mm × 5 mm square with a dicing machine to produce a chip, and bonding was carried out using a flip chip bonder manufactured by TORAY ENGINEERING Co., Ltd., under the conditions described in the columns of "Bonding temperature", "Bonding time", and "Pressurizing force" described in the table. Thereafter, the maximum peeling resistance force was measured.

In these examples, since a chip which is the substrate A and a chip which is the substrate B are bonded to each other, it is described as "Chip·chip" in the column of "Bonding" in the table.

<Production of substrate/substrate laminate (bonded body) (Examples 12 and 13)>

In Examples 12 and 13, the substrates A coated with a composition 6 to have a film thickness of 15 μm and baked at 100°C for 5 minutes. Further, additional baking was carried out under the conditions of the temperature and the time, which are described in the columns of "Film formation temperature" and "Film formation time" in the table, to obtain a polyimide-containing precursor portion. Then, using a chemical mechanical polishing (CMP) machine manufactured by Fujikoshi Machinery Corp., the surface of the polyimide-containing precursor portion was flattened so that the residual film on the surface was 5 μm. Further, the surface on the side of the polyimide-containing precursor portion was attached to a dicing tape, polished with a polishing machine so that the residual film of the silicon substrate was 50 μm, and cutting was carried out into a 5 mm × 5 mm square with a dicing machine. Then, using a flip chip bonder manufactured by TORAY ENGINEERING Co., Ltd., three chips were bonded in the case of Example 12, and six chips were bonded in the case of Example 13. The bonding was carried out under the conditions described in the columns of "Bonding temperature", "Bonding time", and "Pressurizing force" in the table. Thereafter, the maximum peeling resistance force was measured. In these Examples, since three chips which are the substrate A and six chips which are the substrate B are bonded to each other, it is described as "Chip chip × 3" or "Chip·chip × 6" in the column of "Bonding" in the table.

<Production of substrate/substrate laminate (bonded body) (Example 14)>

In Example 14, the substrate A and the substrate B, which are described in the table, were coated with each composition described in the table to have a film thickness of 15 μm and baked at 100°C for 5 minutes. Further, additional baking was carried out under the conditions of the temperature and the time, which are described in the columns of "Film formation temperature" and "Film formation time" in the table, to obtain a polyimide-containing precursor portion. Then, using a chemical mechanical polishing (CMP) machine manufactured by Fujikoshi Machinery Corp., the surface of the polyimide-containing portion was flattened so that the residual film on the surface was 5 μm. Then, the polyimide surfaces of the substrate B and the substrate A were subjected to mutual bonding using a Bonder 540 manufactured by EV Group. The bonding was carried out under the conditions described in the columns of "Bonding temperature", "Bonding time", and "Pressurizing force" in the table. After the bonding, the laminate was cut into a 5 mm × 5 mm square with a dicing machine, and the maximum peeling resistance force was measured. In this Example, since a wafer (substrate a) which is the substrate A and a wafer (substrate c) which is the substrate B were bonded to each other, it was described as "Wafer wafer" in the column of "Bonding" in the table.

<Production of substrate/substrate laminate (bonded body) (Examples 20 to 22)>

In Example 20, the substrate A and the substrate B, which are described in the table, were coated with each composition described in the table to have a film thickness of 7.5 μm and baked at 100°C for 5 minutes. Further, using an i-ray stepper exposure device FPA-3000 i5+ (manufactured by CANON INC.), the entire surface of the film was exposed at an exposure amount of 400 $mJ/cm^2$. Then, additional baking was carried out under the conditions of the temperature and the time, which are described in the columns of "Film formation temperature" and "Film formation time", to obtain a first layer of a polyimide-containing precursor portion. Further, the process from the above-described coating to the additional baking was repeated on the first layer of the polyimide-containing precursor portion to carry out two-layer coating. Thereafter, the treatment was carried out in the same manner as in Example 19. Examples 21 and 22 were also subjected to treatment in the same manner as described above.

<Production of substrate/substrate laminate (bonded body) (Examples 23 and 24)>

In Examples 23 and 24, the substrates A, which is described in the table, was coated with each composition described in the table to have a film thickness of 15 μm and baked at 100°C for 5 minutes. Further, additional baking was carried out under the conditions of the temperature and the time, which are described in the columns of "Film formation temperature" and "Film formation time" in the table, to obtain a polyimide-containing precursor portion. Then, using a chemical mechanical polishing (CMP) machine manufactured by Fujikoshi Machinery Corp., the surface of the polyimide-containing portion was flattened so that the residual film on the surface was 5 μm. Then, cutting was carried out into a 5 mm × 5 mm square with a dicing machine to produce a chip, and bonding was carried out using a flip chip bonder manufactured by TORAY ENGINEERING Co., Ltd., under the conditions described in the columns of "Bonding temperature", "Bonding time", and "Pressurizing force" described in the table. Thereafter, the maximum peeling resistance force was measured.

In this Example, since a chip (substrate a) which is the substrate A and a chip (substrate c) which is the substrate B were bonded to each other, it was described as "Chip·chip" in the column of "Bonding" in the table.

<Production of substrate/substrate laminate (bonded body) (Examples 25 and 26)>

<Test element group (TEG) chip>

A TEG wafer having a Cu wiring line under the pillar of the pillar substrate and an interposer wafer were prepared. The insides of these wafers include a daisy chain pattern for measuring conduction resistance.

Pitch of TEG wafer: 7 μm, copper/tin pillar diameter: 3.5 μm, copper/tin pillar height: 1/3 μm, silicon wafer: on which $SiO_2$, copper, and tin are formed in this order.

Since the interposer included a lead-out wiring line in the periphery thereof, a chip having a size of a 10 mm square was prepared.

Pitch of interposer: 7 μm, copper pillar diameter: 4 μm, silicon wafer: on which $SiO_2$ and copper are formed in this order.

The interposer was flattened using a CMP machine manufactured by Fujikoshi Machinery Corp. so that the tin pillar was not formed and copper and $SiO_2$ had the same planar shape.

In Examples 25 and 26, the substrate A (TEG wafer), which is described in the table, was coated with each composition described in the table to have a film thickness of 15 μm and baked at 100°C for 5 minutes. Further, additional baking was carried out under the conditions of the temperature and the time, which are described in the columns of "Film formation temperature" and "Film formation time" in the table, to obtain a polyimide-containing precursor portion. Then, using a chemical mechanical polishing (CMP) machine manufactured by Fujikoshi Machinery Corp., the surface of the polyimide-containing portion was flattened so that the residual film on the surface was 3 μm. Then, the substrate A was cut into a 5 mm × 5 mm square, and the substrate B was cut into a 10 mm × 10 mm square with a dicing machine to produce chips, and then bonding was carried out using a flip chip bonder manufactured by TORAY ENGINEERING Co., Ltd., under the conditions described in the columns of "Bonding temperature", "Bonding time", and "Pressurizing force" described in the table.

Figs. 7A to 7C and Figs. 8A and 8B are schematic cross-sectional views showing the details of the operations carried out in Examples 25 and 26.

Fig. 7A is a schematic cross-sectional view of a substrate A (TEG wafer) 60. The substrate A 60 includes a $SiO_2$ layer 62 and an electrode (daisy chain pattern) 63 on a silicon wafer 61. In addition, the electrode 63 is formed from a Cu wiring line 63a and a tin pillar 63b formed in a portion of the Cu wiring line 63a, where the portion is exposed from the $SiO_2$ layer 62. The pitch, the copper/tin pillar diameter, and the copper/tin pillar height in the TEG wafer are as described above.

Fig. 7B shows a state in which a polyimide-containing precursor portion 64 is formed from the composition described in the table and then flattened.

Fig. 7C is a schematic cross-sectional view of a chip 65 that is obtained by cutting the substrate A 60 shown in Fig. 7B to a 5 mm × 5 mm square with the dicing machine. A width W1 is 5 mm.

Fig. 8A is a schematic cross-sectional view of a substrate B (interposer wafer) 70. The substrate B 70 includes a $SiO_2$ layer 72 and an electrode (daisy chain pattern) 73 on a silicon wafer 71. An electrode 73 is formed from copper, and the pitch and the copper pillar diameter in the interposer wafer are as described above.

Fig. 8B shows a chip 74 that is obtained by cutting the substrate B 70 shown in Fig. 8A to a 10 mm × 10 mm square with the dicing machine. A width W2 is 10 mm.

Fig. 8C shows a state in which the chip 65 and the chip 74 are bonded to each other by the above-described method. Here, it is possible to determine whether or not the circuit formed from the electrode 63 and the electrode 73 is conductively connected, by checking the electric resistance between a terminal a and a terminal b in the electrode 73.

In this Example, since a chip (TEG chip) which is the substrate A and a chip (interposer chip) which is the substrate B were bonded to each other, it was described as "Chip·chip" in the column of "Bonding" in the table.

<Production of substrate/substrate laminate (bonded body) (Examples 27 to 31)>

In Examples 27 to 31, the substrates A, which is described in the table, was coated with each composition described in the table to have a film thickness of 15 μm and baked at 100°C for 5 minutes. Further, additional baking was carried out under the conditions of the temperature and the time, which are described in the columns of "Film formation temperature" and "Film formation time" in the table, to obtain a polyimide-containing precursor portion. Then, using a chemical mechanical polishing (CMP) machine manufactured by Fujikoshi Machinery Corp., the surface of the polyimide-containing portion was flattened so that the residual film on the surface was 5 μm. Then, cutting was carried out into a 5 mm × 5 mm square with a dicing machine to produce a chip, and bonding was carried out using a flip chip bonder manufactured by TORAY ENGINEERING Co., Ltd., under the conditions described in the columns of "Bonding temperature", "Bonding time", and "Pressurizing force" described in the table. Thereafter, each of the obtained substrate laminates was subjected to a heating treatment using an oven under the conditions described in the columns of "Annealing temperature", "Annealing time", and "Annealing atmosphere" described in the table. Thereafter, the maximum peeling resistance force was measured. In this Example, since a chip (substrate a) which is the substrate A and a chip (substrate b) which is the substrate B were bonded to each other, it was described as "Chip·chip" in the column of "Bonding" in the table.

A measuring method for the maximum peeling resistance force was the same measuring method as the measuring method described in "Evaluation of maximum peeling resistance force" below, and the evaluation results are described in the column of "Maximum peeling resistance force after annealing" in the table. The evaluation standards were as follows.

It can be said that the larger the maximum peeling resistance force, the more excellent the adhesiveness of the bonded body.

In addition, the cyclization rate of the polyimide in the polyimide-containing portion after the annealing step was measured according to the same measuring method as in "Cyclization rate after bonding" described later and described in the column of "Cyclization rate after annealing" in the table. The unit of the numerical value is "%".

- Evaluation standards -

S: The maximum peeling resistance force was 400 kg/cm$^2$ or more.
A: The maximum peeling resistance force was 100 kg/cm$^2$ or more and less than 400 kg/cm$^2$.
B: The maximum peeling resistance force was less than 100 kg/cm$^2$ and 70 kg/cm$^2$ or more.
C: The maximum peeling resistance force was less than 70 kg/cm$^2$ and 40 kg/cm$^2$ or more.
D: The maximum peeling resistance force was less than 40 kg/cm$^2$.

Evaluation of maximum peeling resistance force

Each of the obtained substrate laminates was cut into a size of 5 mm × 5 mm using a dicing machine, and the maximum peeling resistance force (kg/cm$^2$) at a size of 7 mm × 7 mm was measured using a condor Sigma die tester, manufactured by XYZ TEC. Five test pieces were prepared for each level, the measurement was carried out five times, and the arithmetic average value therefrom was adopted. The maximum peeling resistance force was evaluated according to the following four stages. The evaluation results are described in the column of "Maximum peeling resistance force" in the table. It can be said that the larger the maximum peeling resistance force, the more excellent the adhesiveness of the bonded body.

A: The maximum peeling resistance force was 100 kg/cm$^2$ or more.
B: The maximum peeling resistance force was less than 100 kg/cm$^2$ and 70 kg/cm$^2$ or more.
C: The maximum peeling resistance force was less than 70 kg/cm$^2$ and 40 kg/cm$^2$ or more.
D: The maximum peeling resistance force was less than 40 kg/cm$^2$.

<Measurement of cyclization rate>

The cyclization rates of the polyimide in the polyimide-containing precursor portion formed on the substrate A and the second polyimide-containing precursor portion formed on the substrate B were measured according to the

above-described measuring method and described respectively in the column of "Cyclization rate before bonding" in the table.

In addition, the cyclization rate of the polyimide in the polyimide-containing portion after the bonding was measured according to the above-described measuring method and described in the column of "Cyclization rate after bonding" in the table. The unit of each numerical value is "%".

<Evaluation of conduction reliability>

A signal line for resistance measurement was soldered to the pads (that is, the terminal a and the terminal b in Fig. 8C) of the daisy chain pattern portion of the interposer, and the soldered sample was dried at 125°C × 24 h and subjected to a moisture absorption treatment at 85°C × 60 %RH × 168 hours. Next, a solder reflow treatment step (maximum temperature: 265°C) was carried out three times.

The sample that had undergone the above history was subjected to a temperature cycle test under a condition of (-65°C/+150°C).

The resistance value was measured every 100 cycles and measured up to 1,000 cycles. Based on the measurement results, a case where the rate of change in the resistance value was less than 5% was evaluated as "A", a case where the rate of change in the resistance value was 5% or more and less than 40% was evaluated as "B", and a case where the resistance value was changed by 40% or more was evaluated as "C". It is noted that regarding examples for which the column of the conduction reliability is not included or is described as "-" in the table, the conduction reliability was not evaluated. The results are presented in the following tables.

[Table 3]

| | Substrate A | Composition | Film formation temperature | Film formation time | Cyclization rate before bonding | Substrate B | Composition | Film formation temperature | Film formation time | Cyclization rate before bonding | Bonding | Bonding temperature | Bonding time | Pressurizing force | Maximum peeling resistant force | Cyclization rate after bonding |
|---|---|---|---|---|---|---|---|---|---|---|---|---|---|---|---|---|
| Example 1 | a | Composition 1 | 200°C | 10 m | 80 | b | Composition 1 | 200°C | 10 min | 80 | Chip·chip | 230°C | 8 sec | 100 N | A | 93 |
| Example 2 | a | Composition 2 | 200°C | 10 m | 45 | b | Composition 2 | 200°C | 10 min | 45 | Chip·chip | 350°C | 8 sec | 100 N | A | 95 |
| Example 3 | a | Composition 3 | 200°C | 10 m | 88 | b | Composition 3 | 200°C | 10 min | 88 | Chip·chip | 350°C | 8 sec | 100 N | A | 97 |
| Example 4 | a | Composition 4 | 200°C | 10 m | 73 | b | Composition 4 | 200°C | 10 min | 73 | Chip·chip | 350°C | 8 sec | 100 N | A | 95 |
| Example 5 | a | Composition 5 | 200°C | 10 m | 78 | b | Composition 5 | 200°C | 10 min | 78 | Chip·chip | 350°C | 8 sec | 100 N | A | 99 |
| Example 6 | a | Composition 6 | 200°C | 10 m | 88 | b | Composition 6 | 200°C | 10 min | 88 | Chip·chip | 230°C | 8 sec | 100 N | A | 96 |
| Example 7 | a | Composition 7 | 200°C | 10 m | 88 | b | Composition 7 | 200°C | 10 min | 88 | Chip·chip | 230°C | 8 sec | 100 N | A | 94 |
| Example 8 | a | Composition 8 | 200°C | 10 m | 89 | b | Composition 8 | 200°C | 10 min | 88 | Chip·chip | 230°C | 8 sec | 100 N | A | 95 |
| Example 9 | a | Composition 9 | 200°C | 10 m | 85 | b | Composition 9 | 200°C | 10 min | 85 | Chip·chip | 200°C | 8 sec | 100 N | B | 93 |
| Example 10 | a | Composition 5 | 180°C | 10 m | 63 | b | Composition 6 | 200°C | 10 min | 88 | Chip·chip | 200°C | 8 sec | 100 N | B | 91 |
| Example 11 | a | Composition 6 | 180°C | 10 m | 67 | b | Composition 6 | 200°C | 10 min | 88 | Chip·chip | 200°C | 8 sec | 100 N | B | 91 |
| Example 12 | a | Composition 6 | 200°C | 10 m | 88 | - | - | - | - | - | Chip·chip × 3 | 230°C | 8 sec | 100 N | A | 95 |
| Example 13 | a | Composition 6 | 200°C | 10 m | 88 | - | - | - | - | - | Chip·chip × 6 | 230°C | 8 sec | 100 N | A | 95 |
| Example 14 | a | Composition 6 | 200°C | 10 m | 88 | c | - | - | - | - | Wafer·wafer | 250°C | 10 min | 14 kN | C | 96 |
| Comparative Example 1 | a | Composition 10 | 200°C | 60 m | 100 | b | Composition 10 | 200°C | 60 min | 100 | Chip·chip | 230°C | 8 sec | 100 N | D | 100 |

[Table 4]

| | Substrate A | Composition | Film formation temperature | Film formation time | Cyclization rate before bonding | Substrate B | Composition | Film formation temperature | Film formation time | Cyclization rate before bonding | Bonding | Bonding temperature | Bonding time | Pressurizing force | Maximum peeling resistant force after bonding | Cyclization rate after bonding | Conduction reliability |
|---|---|---|---|---|---|---|---|---|---|---|---|---|---|---|---|---|---|
| Example 15 | a | Composition 11 | 190°C | 15 m | 85 | b | Composition 11 | 190°C | 15 m | 85 | Chip·chip | 260°C | 6 sec | 100 N | A | 96 | - |
| Example 16 | a | Composition 12 | 180°C | 20 m | 80 | b | Composition 12 | 180°C | 20 m | 80 | Chip·chip | 250°C | 8 sec | 100 N | A | 93 | - |
| Example 17 | a | Composition 13 | 180°C | 20 m | 80 | b | Composition 13 | 180°C | 20 m | 80 | Chip·chip | 260°C | 6 sec | 20 N | A | 94 | - |
| Example 18 | a | Composition 14 | 190°C | 15 m | 85 | b | Composition 14 | 190°C | 15 m | 85 | Chip·chip | 250°C | 8 sec | 50 N | A | 95 | - |
| Example 19 | a | Composition 13 | 200°C | 10 m | 88 | b | Composition 13 | 200°C | 60 m | 100 | Chip·chip | 260°C | 6 sec | 20 N | B | 100 | - |
| Example 20 | a | Composition 15 | 200°C | 10 m | 88 | b | Composition 15 | 200°C | 60 m | 100 | Chip·chip | 260°C | 6 sec | 100 N | B | 100 | - |
| Example 21 | a | Composition 16 | 200°C | 10 m | 88 | b | Composition 15 | 200°C | 60 m | 100 | Chip·chip | 260°C | 6 sec | 100 N | B | 100 | - |
| Example 22 | a | Composition 17 | 200°C | 10 m | 88 | b | Composition 15 | 200°C | 60 m | 100 | Chip·chip | 260°C | 6 sec | 100 N | B | 100 | - |
| Example 23 | a | Composition 13 | 200°C | 10 m | 88 | c | - | - | - | - | Chip·chip | 260°C | 6 sec | 100 N | B | 100 | - |
| Example 24 | a | Composition 13 | 200°C | 10 m | 88 | c | - | - | - | - | Chip·chip | 260°C | 6 sec | 10 N | B | 100 | - |
| Example 25 | TEG | Composition 13 | 200°C | 10 m | 88 | Interposer | - | - | - | - | Chip·chip | 260°C | 6 sec | 100 N | A | 100 | A |
| Example 26 | TEG | Composition 13 | 200°C | 10 m | 88 | Interposer | - | - | - | - | Chip·chip | 200°C | 6 sec | 100 N | B | 93 | B |
| Example 27 | a | Composition 18 | 200°C | 10 m | 89 | b | Composition 18 | 200°C | 10 m | 89 | Chip·chip | 260°C | 6 sec | 15 N | A | 97 | - |
| Example 28 | a | Composition 19 | 200°C | 10 m | 87 | b | Composition 19 | 200°C | 10 m | 87 | Chip·chip | 260°C | 6 sec | 15 N | B | 95 | - |
| Example 29 | a | Composition 18 | 200°C | 10 m | 89 | b | Composition 18 | 200°C | 10 m | 89 | Chip·chip | 260°C | 6 sec | 15 N | A | 97 | - |
| Example 30 | a | Composition 19 | 200°C | 10 m | 87 | b | Composition 19 | 200°C | 10 m | 87 | Chip·chip | 260°C | 6 sec | 15 N | B | 95 | - |
| Example 31 | a | Composition 20 | 200°C | 10 m | 86 | b | Composition 20 | 200°C | 10 m | 86 | Chip·chip | 260°C | 6 sec | 15 N | B | 93 | - |
| Comparative Example 2 | a | Composition 11 | 260°C | 10 m | 100 | b | Composition 11 | 260°C | 60 m | 100 | Chip·chip | 260°C | 6 sec | 100 N | D | 100 | - |

[Table 5]

| | Annealing temperature | Annealing time | Annealing environment | Cyclization rate after annealing | Maximum peeling resistant force after annealing |
|---|---|---|---|---|---|
| Example 27 | 230°C | 180 m | $N_2$ | 100 | S |
| Example 28 | 230°C | 180 m | $N_2$ | 100 | A |
| Example 29 | 250°C | 60 m | Air | 100 | S |
| Example 30 | 250°C | 60 m | Air | 100 | A |
| Example 31 | 210°C | 240 m | $N_2$ | 100 | A |

As is clear from the results in the above table, according to the manufacturing method for a bonded body according to an embodiment of the present invention, a bonded body having a large maximum peeling resistance force was obtained.

It can be seen that the maximum peeling resistance force is small in Comparative Example 1 in which the cyclization rate is already 100% in the polyimide-containing precursor portion.

In addition, as is clear from the results in the above table, it has been found that good conduction reliability can be obtained by carrying out the bonding at a temperature equal to or higher than the melting point (231.9°C) of tin formed

on the outermost surface of the pillar.

Explanation of References

1: substrate A (underlying substrate, daughter chip)
1x: silicon wafer
1y: polyimide-containing precursor portion arranged substrate
1z: laminate
2: substrate B (mother chip)
2a: surface of second polyimide-containing precursor portion on substrate B
2x: silicon wafer
2y: through-hole electrode
31: electrode (metal portion)
31a: distal end of electrode
32: electrode (metal portion)
4: resin composition layer
4a: surface of polyimide-containing precursor portion (before flattening)
4b: surface of polyimide-containing precursor portion (after flattening)
41: polyimide-containing precursor portion
42: second polyimide-containing precursor portion
51: polyimide-containing portion
8: electronic circuit region
10: substrate
12: wiring line terminal A
14: conduction path
16: electrode
60: substrate A (TEG wafer)
61: silicon wafer
62: $SiO_2$ layer
63: electrode (daisy chain pattern)
63a: Cu wiring line
63b: tin pillar
64: polyimide-containing precursor portion
65: chip
70: substrate B (interposer wafer)
71: silicon wafer
72: $SiO_2$ layer
73: electrode (daisy chain pattern)
74: chip
81: electronic circuit
90: semiconductor device
91: bonding film
93: solder electrode (bump)
94: underfill
95: sealing resin
96: wire bonding
97a: substrate electrode
97b: wire bonding pad
98: base substrate
99: solder ball
100: bonded body
101a to 101d: semiconductor element
101: bonded body
102b to 102d: through-electrode
103a to 103e: metal bump
105: re-distribution layer

110, 110a, 110b: resin layer
115: insulating layer
120: wiring board
120a: surface electrode
200: semiconductor device
a: terminal
b: terminal
d: diameter of pillar
p: pillar spacing
h: height of pillar
h1: height of conduction path
h2: height of electrode
W1: width of chip
W2: width of chip

## Claims

**1.** A manufacturing method for a bonded body, comprising:

a step of preparing a substrate A having a surface on which a wiring line terminal is provided;
a polyimide-containing precursor portion forming step of forming a polyimide-containing precursor portion on the surface of the substrate A, where the wiring line terminal is provided on the surface of the substrate A;
a step of preparing a substrate B having a surface on which a wiring line terminal is provided; and
a bonding step of bonding the surface of the substrate A, where the polyimide-containing precursor portion is provided on the surface of the substrate A, to the surface of the substrate B, where the wiring line terminal is provided on the surface of the substrate B,
wherein a difference between a cyclization rate of a polyimide in the polyimide-containing precursor portion before the bonding step and a cyclization rate of a polyimide in a polyimide-containing portion formed at a bonded portion after the bonding step is 5% or more.

**2.** The manufacturing method for a bonded body according to claim 1,
wherein the cyclization rate of the polyimide in the polyimide-containing precursor portion before the bonding step is 40% to 90%.

**3.** The manufacturing method for a bonded body according to claim 1 or 2,
wherein the cyclization rate of the polyimide in the polyimide-containing portion formed at the bonded portion after the bonding step is 91% to 100%.

**4.** The manufacturing method for a bonded body according to claim 1 or 2,
wherein a bonding temperature in the bonding step is 380°C or lower.

**5.** The manufacturing method for a bonded body according to claim 1 or 2,
wherein a bonding temperature in the bonding step is equal to or higher than a melting point of the wiring line terminal of the substrate A and equal to or higher than a melting point of the wiring line terminal of the substrate B.

**6.** The manufacturing method for a bonded body according to claim 1 or 2,

wherein the polyimide-containing precursor portion forming step includes;
applying a composition for forming a polyimide-containing precursor portion onto the surface of the substrate A, where the wiring line terminal is provided on the surface of the substrate A, and
heating the applied composition for forming a polyimide-containing precursor portion at a temperature lower than a melting point of the wiring line terminal of the substrate A.

**7.** The manufacturing method for a bonded body according to claim 1 or 2,
wherein a form of the substrate A is a wafer.

**8.** The manufacturing method for a bonded body according to claim 1 or 2,

wherein a form of the substrate B is a chip.

**9.** The manufacturing method for a bonded body according to claim 1 or 2, wherein a form of the substrate B is a wafer.

**10.** The manufacturing method for a bonded body according to claim 1 or 2, further comprising:

a flattening step of flattening a surface of the polyimide-containing precursor portion on the substrate A, wherein the polyimide-containing precursor portion forming step, the flattening step, and the bonding step are included in this order.

**11.** The manufacturing method for a bonded body according to claim 1 or 2, wherein in the bonding step, an electrode included on the surface of the substrate A, where the polyimide-containing precursor portion is provided on the surface of the substrate A, and an electrode on the surface of the substrate B, where the wiring line terminal is provided on the surface of the substrate B, are bonded to be in direct contact with each other.

**12.** The manufacturing method for a bonded body according to claim 1 or 2, further comprising:

a second polyimide-containing precursor portion forming step of forming a second polyimide-containing precursor portion on the surface of the substrate B, where the wiring line terminal is provided on the surface of the substrate B,
wherein the second polyimide-containing precursor portion forming step and the bonding step are included in this order.

**13.** The manufacturing method for a bonded body according to claim 12, wherein a difference between a cyclization rate of a polyimide in the second polyimide-containing precursor portion before the bonding step and the cyclization rate of the polyimide contained in the polyimide-containing portion formed at the bonded portion after the bonding step is 5% or more.

**14.** The manufacturing method for a bonded body according to claim 12, wherein the cyclization rate of the polyimide in the second polyimide-containing precursor portion before the bonding step is 40% to 90%.

**15.** The manufacturing method for a bonded body according to claim 1 or 2, wherein the substrate B includes an inorganic insulating film between the wiring line terminals of the substrate B.

**16.** The manufacturing method for a bonded body according to claim 1 or 2,

wherein the polyimide-containing precursor portion forming step is a step of applying a composition for forming a polyimide-containing precursor portion onto the surface of the substrate A, where the wiring line terminal is provided on the surface of the substrate A, and
the composition for forming a polyimide-containing precursor portion contains a polyimide precursor and a solvent.

**17.** The manufacturing method for a bonded body according to claim 16, wherein the composition for forming a polyimide-containing precursor portion contains a migration suppressing agent.

**18.** The manufacturing method for a bonded body according to claim 16, wherein the composition for forming a polyimide-containing precursor portion contains a polymerizable compound having a ring structure.

**19.** The manufacturing method for a bonded body according to claim 16, wherein the composition for forming a polyimide-containing precursor portion contains a polymerizable compound in which a glass transition temperature of a homopolymer is 200°C or higher.

**20.** The manufacturing method for a bonded body according to claim 16, wherein the composition for forming a polyimide-containing precursor portion contains a filler.

**21.** A bonded body that is obtained by the manufacturing method according to claim 1 or 2.

**22.** A manufacturing method for a laminate, comprising:

a step of preparing a substrate C having two or more surfaces on which a wiring line terminal is provided;
a step of preparing a plurality of substrates D each having a surface on which a wiring line terminal is provided;
a polyimide-containing precursor portion forming step of forming a polyimide-containing precursor portion on the surface of at least one of the substrate C or the substrate D, where the wiring line terminal is provided on the at least one of the substrate C or the substrate D; and
a bonding step of bonding the surface of the substrate D, where the wiring line terminal is provided, to each of at least two surfaces of the substrate C, where the wiring line terminal is provided,
wherein all of a plurality of bonded portions in the bonding step include the polyimide-containing precursor portion, and
in at least one bonded portion, a difference between a cyclization rate of a polyimide in the polyimide-containing precursor portion before the bonding step and a cyclization rate of a polyimide in a polyimide-containing portion formed at the bonded portion after the bonding step is 5% or more.

**23.** The manufacturing method for a laminate according to claim 22,
wherein the polyimide-containing precursor portion contains a filler.

**24.** A laminate that is obtained by the manufacturing method for a laminate according to claim 22 or 23.

**25.** A manufacturing method for a device, comprising:
the manufacturing method for a bonded body according to claim 1 or 2.

**26.** A device comprising:
the bonded body according to claim 21.

**27.** A composition for forming a polyimide-containing precursor portion, which is used in a manufacturing method for a bonded body, the manufacturing method including:

a step of preparing a substrate A having a surface on which a wiring line terminal is provided;
a polyimide-containing precursor portion forming step of forming a polyimide-containing precursor portion on the surface of the substrate A, where a wiring line terminal is provided on the surface of the substrate A;
a step of preparing a substrate B having a surface on which a wiring line terminal is provided; and
a bonding step of bonding the surface of the substrate A, where the polyimide-containing precursor portion is provided on the surface of the substrate A, to the surface of the substrate B, where the wiring line terminal is provided,
wherein the polyimide-containing precursor portion is a member formed from the composition for forming a polyimide-containing precursor portion, and
a difference between a cyclization rate of a polyimide in the polyimide-containing precursor portion before the bonding step and a cyclization rate of a polyimide in a polyimide-containing portion formed at a bonded portion after the bonding step is 5% or more.

**28.** The composition for forming a polyimide-containing precursor portion according to claim 27,
wherein the cyclization rate of the polyimide in the polyimide-containing precursor portion before the bonding step is 40% to 90%.

**29.** The composition for forming a polyimide-containing precursor portion according to claim 27 or 28,
wherein the cyclization rate of the polyimide in the polyimide-containing portion formed at the bonded portion after the bonding step is 91% to 100%.

**30.** The composition for forming a polyimide-containing precursor portion according to claim 27 or 28, further comprising a filler.

FIG. 1

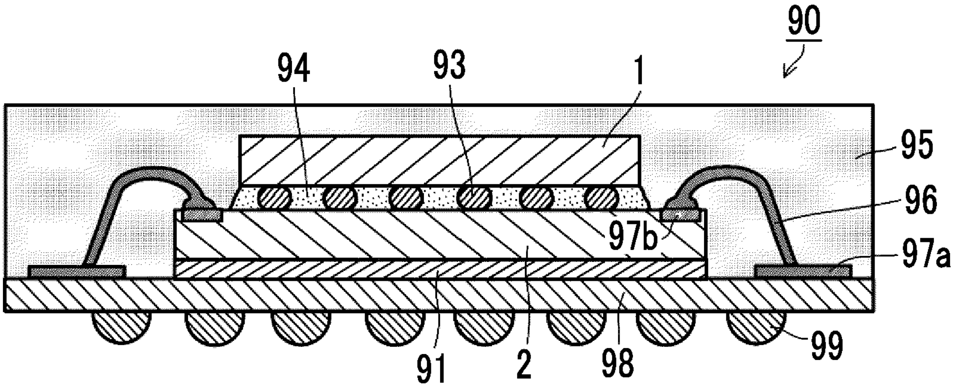


FIG. 2A

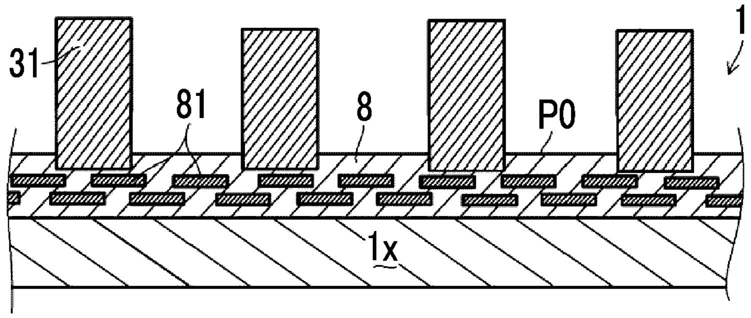


FIG. 2B

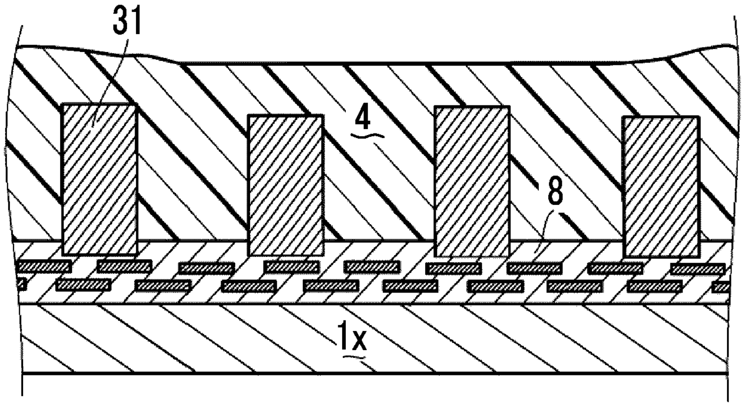


FIG. 2C

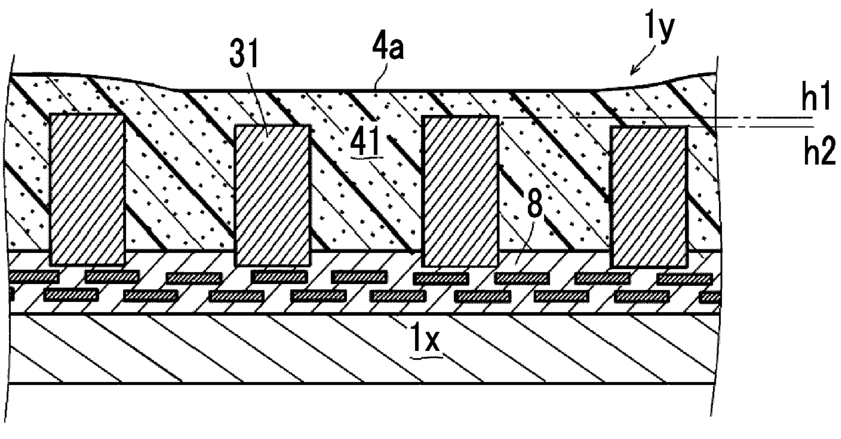

FIG. 3A

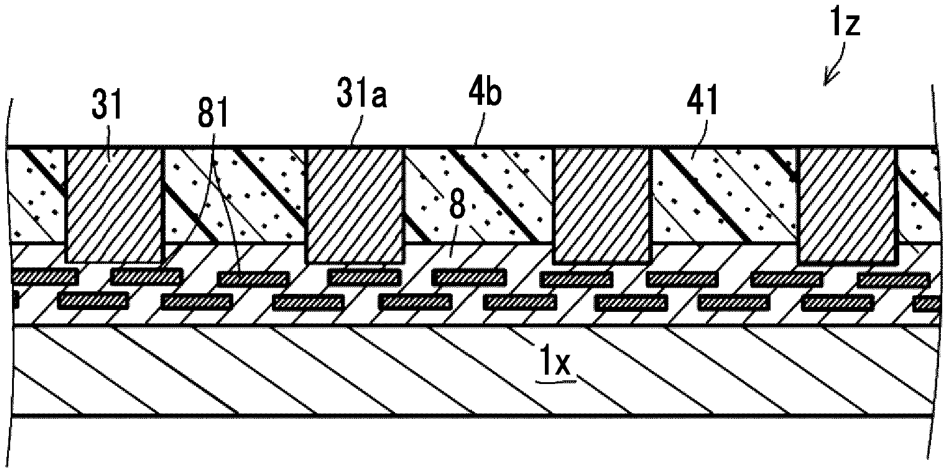


FIG. 3B

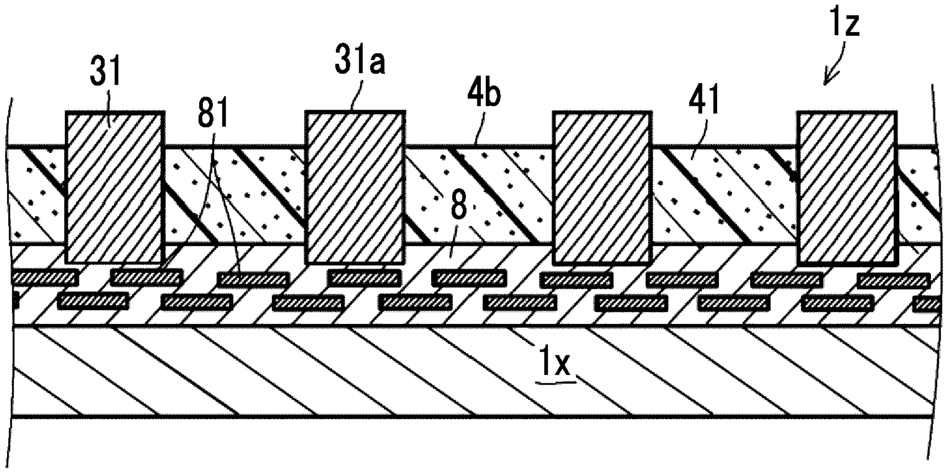


FIG. 3C

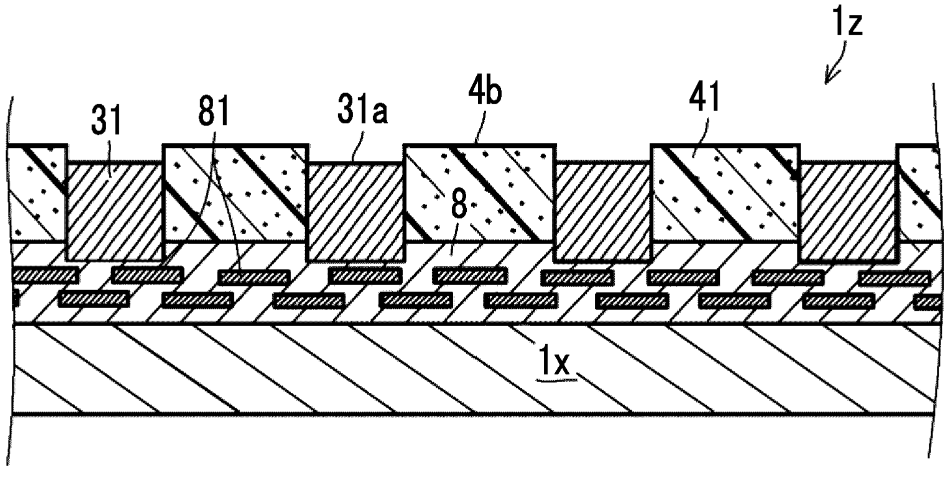

FIG. 4A

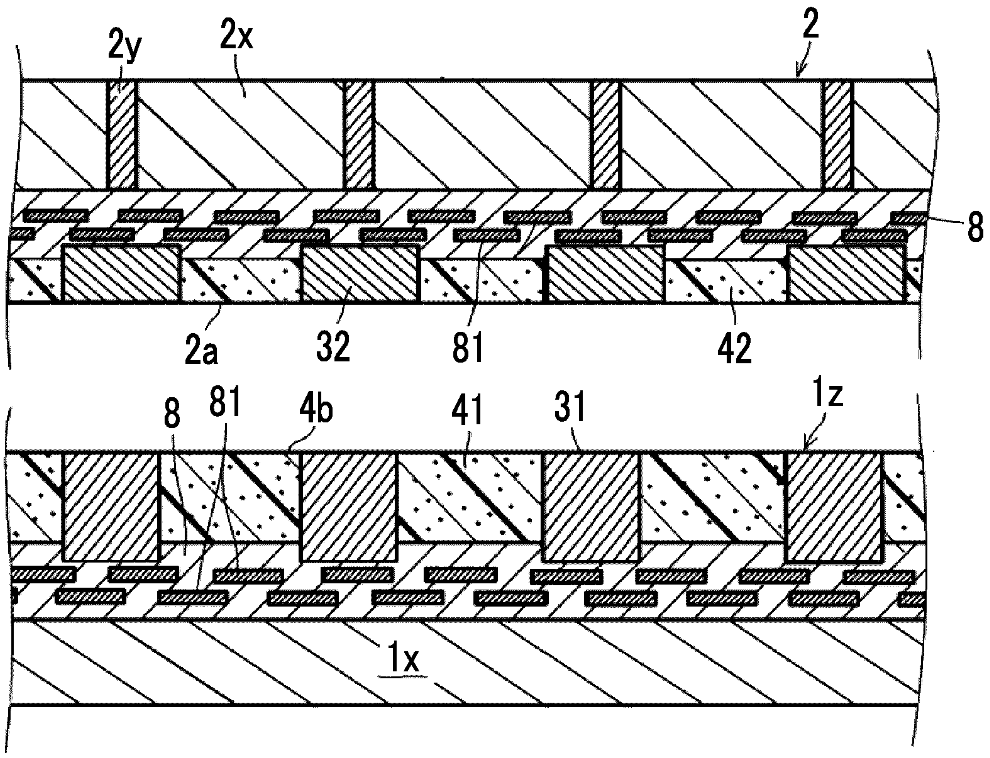


FIG. 4B

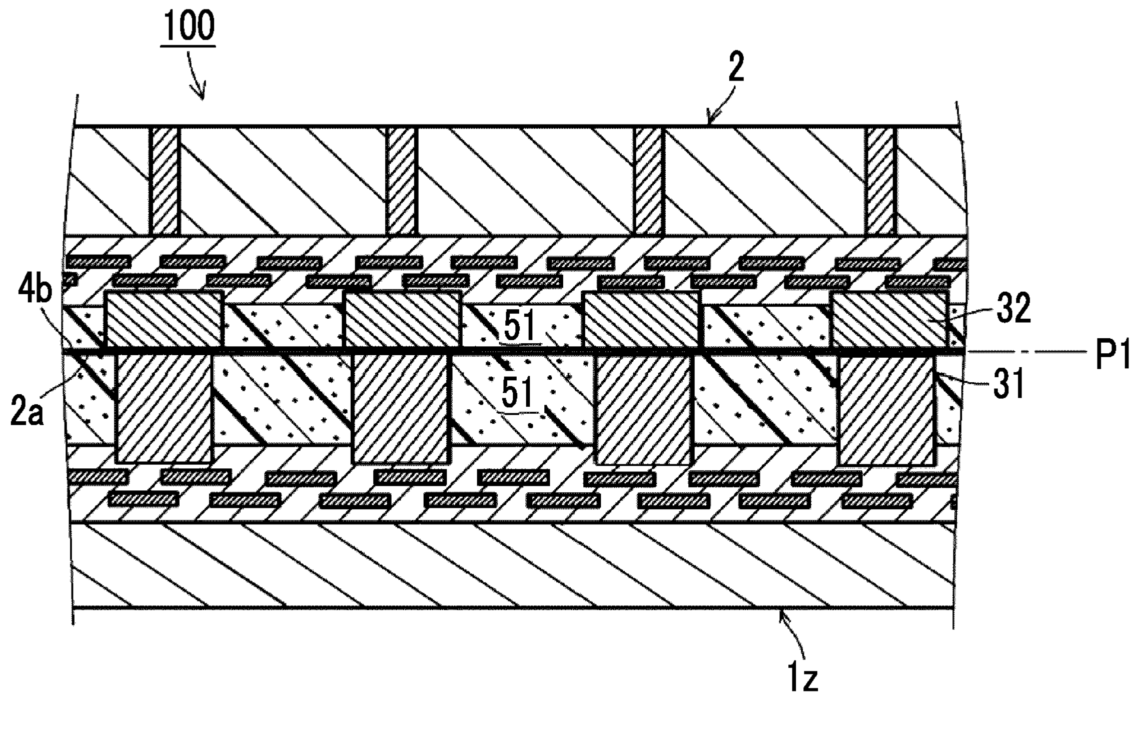

FIG. 5

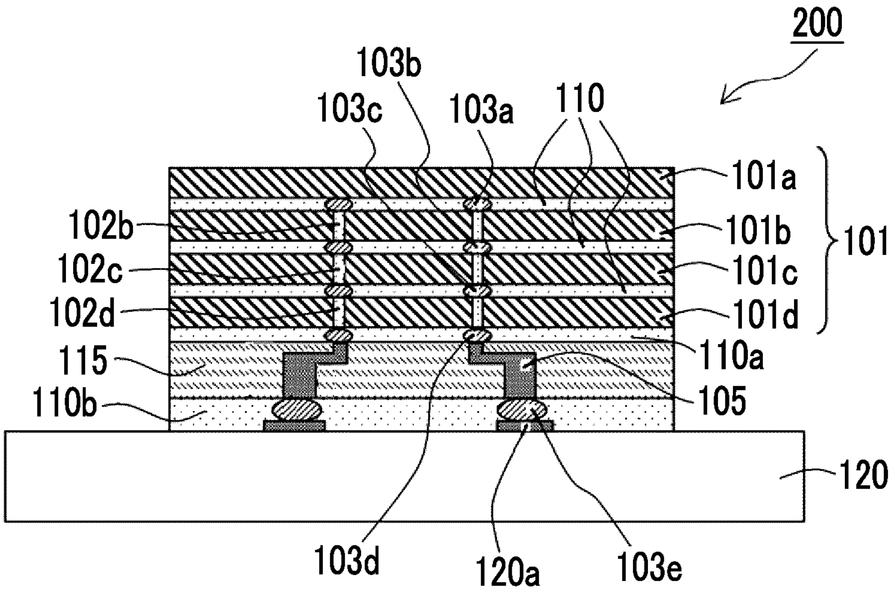


FIG. 6A

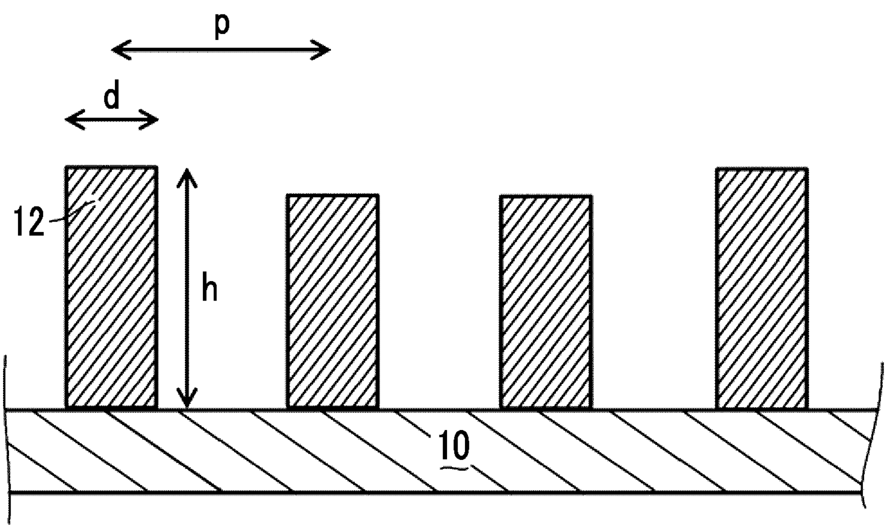


FIG. 6B

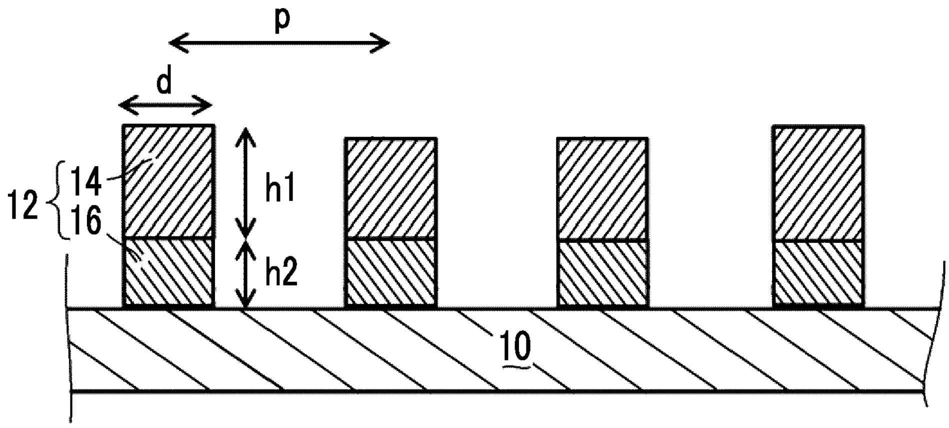

FIG. 7A

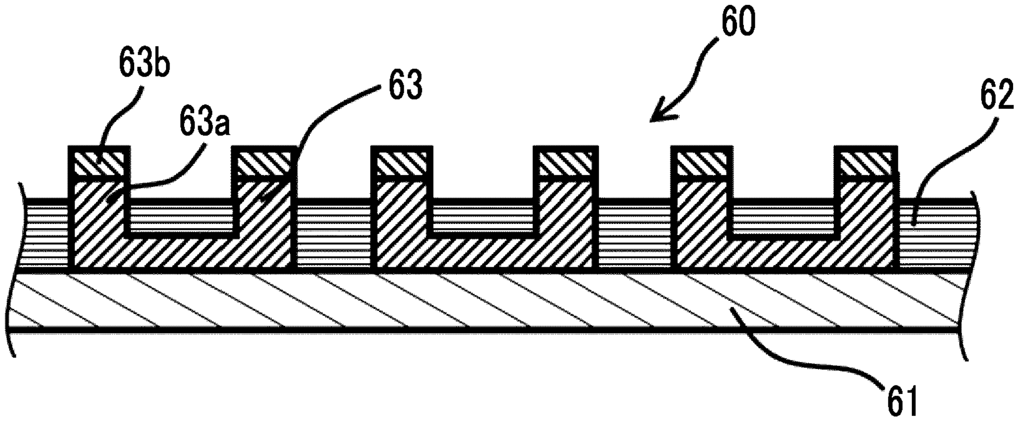


FIG. 7B

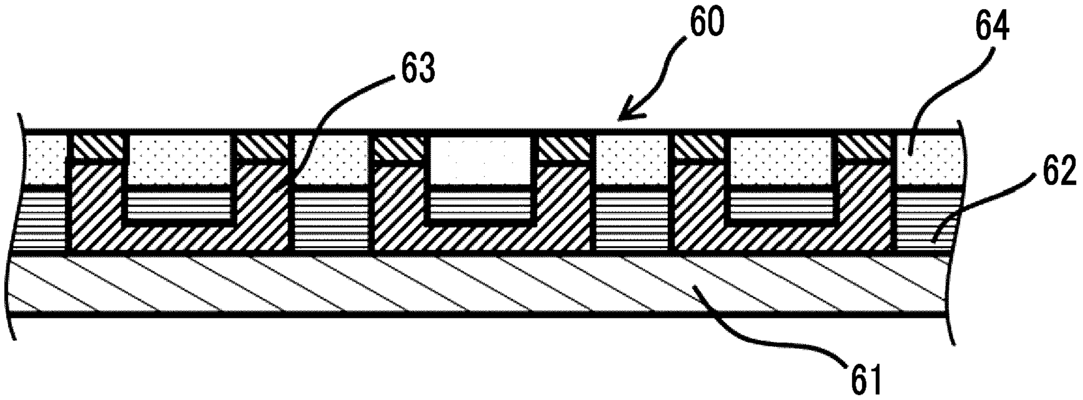


FIG. 7C

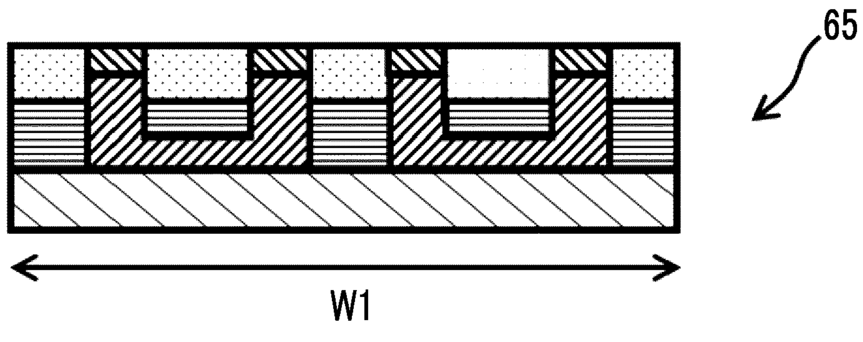

FIG. 8A

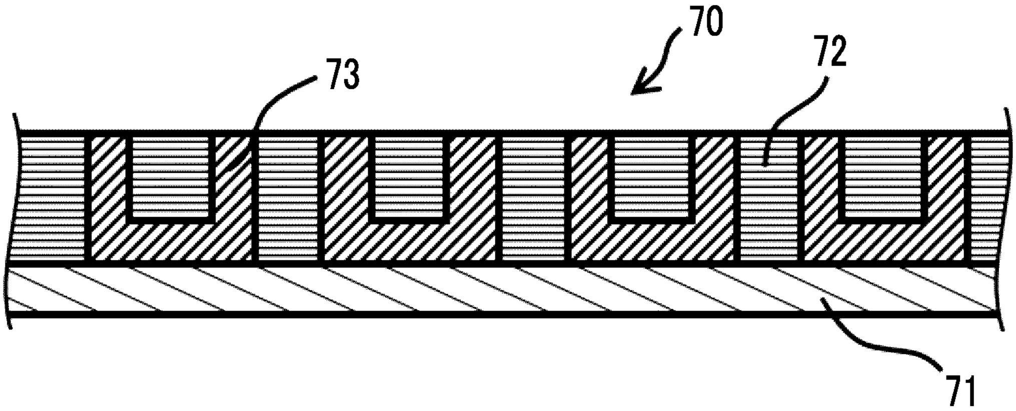


FIG. 8B

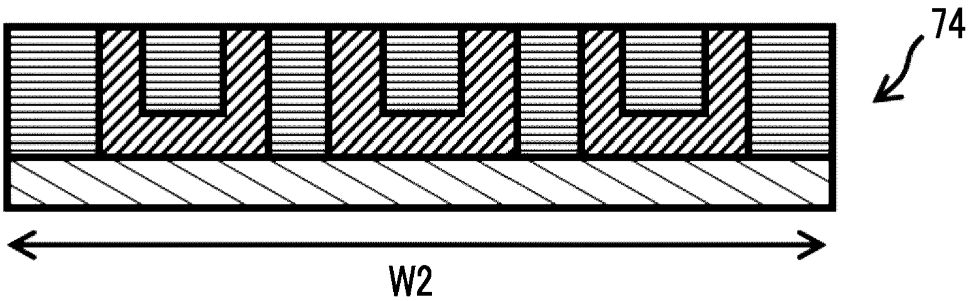


FIG. 8C

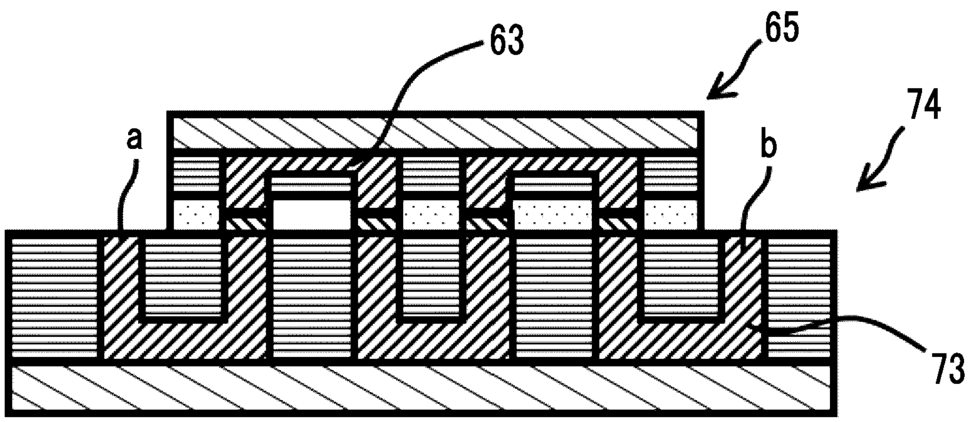

**INTERNATIONAL SEARCH REPORT**

International application No.
**PCT/JP2022/043600**

**A. CLASSIFICATION OF SUBJECT MATTER**

***H01L 25/07***(2006.01)i; ***C08G 73/10***(2006.01)i; ***C08L 79/08***(2006.01)i; ***H01L 25/065***(2023.01)i; ***H01L 25/18***(2023.01)i
FI: H01L25/08 B; H01L25/08 H; C08L79/08; C08G73/10; H01L25/08 C

According to International Patent Classification (IPC) or to both national classification and IPC

**B. FIELDS SEARCHED**

Minimum documentation searched (classification system followed by classification symbols)

H01L25/07; C08G73/10; C08L79/08; H01L25/065; H01L25/18

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2012/005079 A1 (TORAY INDUSTRIES) 12 January 2012 (2012-01-12) paragraphs [0015]-[0042], [0061]-[0063], [0066], [0067], [0077], [0091], [0095], [0097]-[0112], fig. 1 | 1, 3, 4, 6-9, 16, 18-27, 29, 30 |
| Y | | 10-13, 15, 17 |
| A | | 2, 5, 14, 28 |
| Y | WO 2018/173764 A1 (FUJIFILM CORP) 27 September 2018 (2018-09-27) paragraphs [0018]-[0033], fig. 1-6 | 10-13, 15 |
| Y | WO 2017/209176 A1 (FUJIFILM CORP) 07 December 2017 (2017-12-07) paragraphs [0018], [0161]-[0165] | 17 |
| A | WO 2011/004706 A1 (TORAY INDUSTRIES) 13 January 2011 (2011-01-13) entire text, all drawings | 1-30 |

☐ Further documents are listed in the continuation of Box C.  ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **06 February 2023** | **14 February 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2022/043600**

| Patent document cited in search report | Publication date (day/month/year) | Patent family member(s) | Publication date (day/month/year) |
|---|---|---|---|
| WO 2012/005079 A1 | 12 January 2012 | US 2013/0105998 A1<br>paragraphs [0017]-[0040], [0058]-[0060], [0063],[0064], [0074],[0088],[0092]-[0095], [0102]-[0129],図1<br>EP 2592126 A1<br>CN 102985505 A<br>KR 10-2013-0096644 A<br>TW 201202846 A | |
| WO 2018/173764 A1 | 27 September 2018 | US 2019/0363068 A1<br>paragraphs [0108]-[0144], fig. 1-6<br>KR 10-2019-0104620 A<br>TW 201836094 A | |
| WO 2017/209176 A1 | 07 December 2017 | KR 10-2018-0135070 A<br>CN 109313397 A<br>TW 201835226 A | |
| WO 2011/004706 A1 | 13 January 2011 | US 2012/0129988 A1<br>entire text, all drawings<br>EP 2452964 A1<br>SG 177608 A<br>CN 102471461 A<br>TW 201120174 A<br>KR 10-2012-0051634 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006023696 A
- JP 2006047592 A
- US 9159547 B
- WO 2017038598 A
- JP 2016027357 A
- WO 2021112189 A
- JP 48041708 B
- JP S48041708 B
- JP 51037193 A
- JP S51037193 A
- JP 2032293 B
- JP H02032293 B
- JP 2016765 B
- JP H02016765 B
- JP 58049860 B
- JP S58049860 B
- JP 56017654 B
- JP S56017654 B
- JP 62039417 B
- JP S62039417 B
- JP 62039418 B
- JP S62039418 B
- JP 63277653 A
- JP S63277653A B
- JP 63260909 A
- JP S63260909 A
- JP 1105238 A
- JP H01105238 A
- WO 2015199219 A
- JP 2014130173 A
- JP 6301489 B
- WO 2018221177 A
- WO 2018110179 A
- JP 2019043864 A
- JP 2019044030 A
- JP 2019167313 A
- JP 2015087611 A
- JP 10291969 A
- JP H10291969 A
- JP 4225898 B
- JP 2001233842 A
- JP 2000080068 A
- JP 2006342166 A
- JP 2000066385 A
- JP 2004534797 A
- JP 2017019766 A
- JP 6065596 B
- WO 2015152153 A
- WO 2017051680 A
- JP 2017198865 A
- WO 2017164127 A
- WO 2013167515 A
- JP 2012014052 A
- WO 2021020359 A
- JP 4600600 B
- JP 2007269779 A
- JP 2009191061 A
- WO 2015125469 A
- JP 2010527339 A
- JP 2011524436 A
- WO 2015004565 A
- JP 2016532675 A
- WO 2017033680 A
- JP 2013522445 A
- WO 2016034963 A
- JP 2017523465 A
- JP 2017167399 A
- JP 2017151342 A
- JP 6469669 B
- WO 2020066416 A
- WO 2020054226 A
- WO 2018038002 A
- JP 2018173573 A
- JP 2011128358 A
- JP 2014186186 A
- JP 2013072935 A
- JP 2012003225 A
- US 20130034812 A
- JP 2008250074 A
- JP 2010164965 A
- JP 2008063554 A
- JP 2015123351 A

### Non-patent literature cited in the description

- *Journal of Microelectronics and Electronic Packaging,* 2010, vol. 7, 214-219
- All of Most Advanced Semiconductor Package Technologies. Kogyo Chosakai Publishing Co., Ltd, 8-19, 110-114, 160-165

- All of Surface Treatment Technologies with Illustrations. Kogyo Chosakai Publishing Co., Ltd, 32-41, 56-59
- Handbook of Chemistry, Pure Chemistry. Chemical Society of Japan
- *MATERIAL STAGE,* 2019, vol. 19 (3
- *J. C. S. Perkin II,* 1979, 1653-1660
- *J. C. S. Perkin II,* 1979, 156-162
- *Journal of Photopolymer Science and Technology,* 1995, 202-232
- Polymer Dictionary. 2005, 683-684